# EUROPEAN PATENT SPECIFICATION

(11) **EP 4 276 535 B1**
(45) Date of publication and mention of the grant of the patent: **18.09.2024**
(21) Application number: 23168870.6
(22) Date of filing: 20.04.2023
(51) Int. Cl.: G03F 7/075, G03F 7/09

(54) **COMPOSITION FOR FORMING METAL OXIDE FILM, PATTERNING PROCESS, AND METHOD FOR FORMING METAL OXIDE FILM**
ZUSAMMENSETZUNG ZUR BILDUNG EINES METALLOXIDFILMS, STRUKTURIERUNGSVERFAHREN UND VERFAHREN ZUR BILDUNG EINES METALLOXIDFILMS
COMPOSITION POUR FORMER UN FILM D'OXYDE MÉTALLIQUE, PROCÉDÉ DE FORMATION DE MOTIFS ET PROCÉDÉ DE FORMATION D'UN FILM D'OXYDE MÉTALLIQUE

(30) Priority: 10.05.2022 JP 2022077797
(43) Date of publication of application: 15.11.2023
(73) Proprietor: Shin-Etsu Chemical Co., Ltd., Chiyoda-ku Tokyo 100-0005 (JP)
(72) Inventor: Kobayashi, Naoki, Niigata (JP); Kori, Daisuke, Niigata (JP); Satoh, Hironori, Niigata (JP); Yano, Toshiharu, Niigata (JP)
(74) Representative: Sonnenhauser, Thomas Martin

(56) References cited:
- US-A1- 2010 316 950
- US-A1- 2016 336 189
- US-A1- 2017 183 531
- US-A1- 2019 300 498
- US-B2- 9 201 305

## Description

### TECHNICAL FIELD

The present invention relates to a composition for forming a metal oxide film, a patterning process, and a method for forming a metal oxide film.

### BACKGROUND ART

As LSI advances toward high integration and high processing speed, miniaturization of pattern size is progressing rapidly. With this miniaturization, lithography techniques have achieved formation of the fine pattern by shortening a wavelength of a light source and appropriately selecting a resist composition corresponding to the wavelength. The main composition among the resist compositions is a positive-type photoresist composition to be used for a single layer. This single-layer positive-type photoresist composition has a skeleton having etching resistance against dry etching with chlorine-based or fluorine-based gas plasma in the resist resin, and has a switching mechanism so that an exposed portion is dissolved. Using this composition, a pattern is formed by dissolving the exposed portion, and while using the remained resist pattern as an etching mask, a substrate to be processed is processed by dry etching.

However, miniaturizing the pattern, that is reducing the pattern width, with keeping a film thickness of the used photoresist film causes a problem of deteriorating resolution performance of the photoresist film. In addition, when pattern development on the photoresist film is performed by using developer, aspect ratio is too high, and a problem of pattern collapse is consequently caused. Thus, the photoresist film has been thinned as the pattern has been miniaturized.

Meanwhile, used for processing a substrate to be processed is commonly a method of processing the substrate by dry etching while using a photoresist film having a formed pattern as an etching mask. However, realistically there is no dry etching method that can have complete dry etching selectivity between the photoresist film and the substrate to be processed. Thus, there is a problem in which, during the substrate processing, the photoresist film is damaged and collapsed, so that the resist pattern cannot be precisely transferred to the substrate to be processed. Accordingly, as the pattern has been miniaturized, the resist composition is required to have higher dry etching resistance. However, on the other hand, in order to improve resolution, a resin used for the photoresist composition is required to have a small light absorption for the exposure wavelength. Thus, as the wavelength of the exposure light has become shorter of i-line, KrF, and ArF, the resin has changed to a novolac resin, polyhydroxystyrene, and a resin having an aliphatic polycyclic skeleton. However, the etching rate under the dry etching condition during the substrate processing has become realistically high, and recent photoresist compositions having high resolution rather tend to have weak etching resistance.

Thus, the substrate to be processed is required to be processed by dry etching while using the photoresist film having smaller thickness and weaker etching resistance. It has been urgent to achieve a material and process for this processing.

One of methods to solve such a problem is a multilayer resist method. This method is of: interposing a resist middle layer film having etching selectivity differing from a photoresist film (that is, a resist upper layer film) between the resist upper layer film and a substrate to be processed; obtaining a pattern in the resist upper layer film; and then transferring the pattern to the resist middle layer film by dry etching while using the resist upper layer film pattern as a dry etching mask; and further transferring the pattern to the substrate to be processed by dry etching while using the resist middle layer film as a dry etching mask.

One of the multilayer resist methods is a three-layer resist method that can be performed by using a common resist composition used for the single-layer resist film. In this three-layer resist method, for example, an organic film of a novolac resin, etc. is formed on a substrate to be processed as a resist underlayer film, a silicon-containing resist middle layer film is formed thereon as a resist middle layer film, and a common organic photoresist film is formed thereon as a resist upper layer film. The organic resist upper layer film can have good etching selectivity to the silicon-containing resist middle layer film when dry etching with fluorine-based gas plasma is performed. Thus, the resist upper layer film pattern can be transferred to the silicon-containing resist middle layer film by dry etching with the fluorine-based gas plasma. According to this method, the pattern can be transferred to the silicon-containing resist middle layer film (resist middle layer film) even by using a resist composition having difficulty to form a pattern having a film thickness sufficient for directly processing a substrate to be processed or by using a resist composition having dry etching resistance insufficient for forming the substrate. Subsequently transferring the pattern by dry etching with oxygen-based or hydrogen-based gas plasma can yield an organic film (resist underlayer film) pattern of the novolac resin, etc. that has dry etching resistance sufficient for processing the substrate. Many resist underlayer films as described-above have been already known, for example described in Patent Document 1.

Meanwhile, integration of 3D-NAND memories has been rapidly increased in recent years, and increased is a necessity of a thick-film resist underlayer film material having: filling property that can fill a high aspect-ratio pattern substrate without a void; and excellent dry etching resistance that can transfer the fine structure pattern to a substrate to be processed with high precision. As the thick-film organic underlayer film material having excellent filling property, materials described in Patent Document 2 have been reported, for example. However, when focusing on application for the latest generation, there is a concern about the dry etching resistance in the materials, and conventional coating-type organic underlayer film materials are approaching the application limit.

For the problem of dry etching resistance of the coating-type organic resist underlayer film material, a method in which a metal oxide film is used for the resist underlayer film has attracted attention. However, singly using the metal oxide material has insufficient flowability, and it is difficult to fill a high aspect-ratio pattern substrate. Thus, preferable is a composition in which an organic material is added to improve the flowability. Such compositions in which an organic material is added into a metal oxide compound are reported in Patent Document 3 and Patent Document 4. Although the filling property is not mentioned, a metal oxide dicarboxylate used in Patent Document 3 and a hydrolysis-condensate of a metal alkoxide used in Patent Document 4 have large thermal contraction, and induce considerable deterioration in the filling ability. Thus, there is concern about insufficiency as the resist underlayer film material required to have a high filling property.

For this problem, a composition for forming a metal oxide film in which a metal oxide nanoparticle is added into a high-carbon polymer is proposed (Patent Document 5). Reported is using the metal oxide nanoparticle having smaller thermal contraction than a metal oxide compound improves the filling property compared with the metal oxide compound. The addition of the high-carbon polymer as a flowability accelerator of the metal oxide nanoparticle is also proposed, but the high-carbon polymer has insufficient thermal flowability. Thus, there is concern about insufficiency for filling a high aspect-ratio pattern substrate. In addition, the high-carbon polymer has a high carbon content and a rigid structure, and thereby there is concern about cracking when the composition forms a thick film.

Organic materials having excellent dry etching resistance and thermal flowability include a material having a fluorene skeleton having a cardo structure. There is a resist underlayer film material combining: a compound or polymer having a cardo structure as a thermal flowability accelerator; and a metal oxide nanoparticle. It is found that although the material has excellent dry etching resistance and filling property, the thermal flowability accelerator has a high carbon content and a rigid cardo structure, and cracking occur when the material forms a thick film. It has been also unveiled that the material has insufficient filling ability for the high aspect-ratio pattern substrate as a filling sacrificial film for the advanced 3D-NAND. In addition, there is inconvenience of insufficient storage stability, for example, the case where the composition concentration is increased up to a concentration that can form a thick film, aggregation of the nanoparticles occur to cause a defect.

Patent document 6 discloses a compound for forming an organic film having high filling and planarizing properties.

Patent document 7 discloses a composition for forming an underlayer film for lithography having excellent optical characteristics and etching resistance and containing a naphthalene formaldehyde polymer having a specific unit obtained by reacting naphthalene and/or alkylnaphthalene with formaldehyde, and an organic solvent. The composition can contain metallic particles.

Patent document 8 discloses spin-on compositions containing at least one metal oxide dicarboxylate and an organic solvent into which the metal oxide dicarboxylate is soluble or colloidally stable.

Patent document 9 discloses an organic film composition for forming an organic film having dry etching resistance as well as advanced filling/planarizing characteristics.

Patent document 10 discloses a compound capable of curing under the film forming conditions without forming byproducts, thereby forming an organic under layer film that has good dry etching durability in substrate processing.

### CITATION LIST

### PATENT LITERATURE

Patent Document 1: JP 2004-205685 A
Patent Document 2: JP 6550760 B
Patent Document 3: JP 6342998 B
Patent Document 4: JP 5756134 B
Patent Document 5: JP 7008075 B
Patent document 6: US2017183531A1
Patent document 7: US2010316950A1
Patent document 8: US9201305B2
Patent document 9: US2016336189A1
Patent document 10: US2019300498A1

### SUMMARY OF INVENTION

### TECHNICAL PROBLEM

The present invention has been made in view of the above circumstances. An object of the present invention is to provide: a composition for forming a metal oxide film that has excellent dry etching resistance compared with a conventional organic underlayer film material, and excellent filling property compared with a conventional metal hard mask, that can reduce cracking with forming a thick film, and that has excellent storage stability; a patterning process using this material; and a method of forming a metal oxide film (resist underlayer film).

### SOLUTION TO PROBLEM

To solve the above problem, the present invention provides a composition for forming a metal oxide film, comprising:
(A) a metal oxide nanoparticle;
(B) a flowability accelerator containing a resin having a structural unit represented by the following general formula (1);
(C) a dispersion stabilizer having two or more benzene rings or having one benzene ring and a structure represented by the following general formula (C-1), and the dispersion stabilizer being composed of an aromatic group-containing compound having a molecular weight represented by a molecular formula of 500 or less; and
(D) an organic solvent,

wherein the flowability accelerator (B) has a content of 9 mass% or more in an entirety of the composition, a ratio Mw/Mn of a weight-average molecular weight Mw and a number-average molecular weight Mn of the flowability accelerator (B) in terms of polystyrene by a gel permeation chromatography method is 2.50 ≤ Mw/Mn ≤ 9.00, and the flowability accelerator (B) contains no compound nor polymer having a cardo structure, 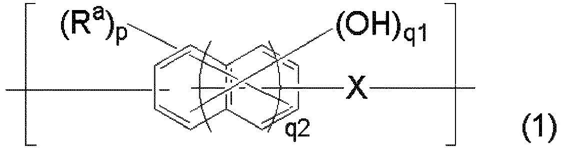
wherein R^{a} represents a saturated monovalent organic group having 1 to 30 carbon atoms or an unsaturated monovalent organic group having 2 to 30 carbon atoms; X represents a divalent organic group having 1 to 30 carbon atoms; "p" represents an integer of 0 to 5; "q₁" represents an integer of 1 to 6; "p + q₁" represents an integer of 1 or more and 6 or less; and "q₂" represents 0 or 1, 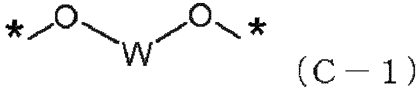
wherein "*" represents a bonding position; and W represents an organic group having 1 to 4 carbon atoms.

Such a composition for forming a metal oxide film can be used as the resist underlayer film material used for the multilayer resist method. The composition contains the flowability accelerator having excellent cracking resistance, and thereby can form a thick film exhibiting the excellent dry etching resistance derived from the metal oxide nanoparticle. In addition, a synergistic effect of the flowability accelerator and the dispersion stabilizer yields the excellent thermal flowability, and thereby the composition can provide a resist underlayer film material that can fill a high aspect-ratio pattern substrate without a void, the filling being not able to be achieved by the metal oxide nanoparticle alone. Furthermore, the composition for forming a metal oxide film can be provided which can keep the nanoparticles in a good dispersed state even in a chemical liquid containing the resin at high concentration composition of 9 mass% or more by containing a dispersion stabilizer having the specific structure, and thereby can exhibit an excellent storage stability.

The flowability accelerator (B) preferably contains the resin having a structural unit represented by the following general formula (2) in addition to the resin having the structural unit represented by the general formula (1); or the flowability accelerator (B) is preferably a resin having both of the structural unit represented by the general formula (1) and the structural unit represented by the following general formula (2), 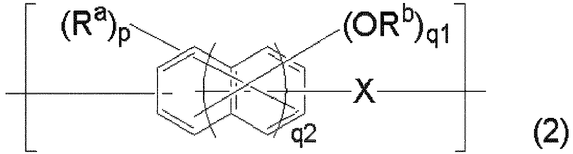 wherein R^{a} represents a saturated monovalent organic group having 1 to 30 carbon atoms or an unsaturated monovalent organic group having 2 to 30 carbon atoms; R^{b} represents a saturated hydrocarbon group having 1 to 30 carbon atoms or an unsaturated hydrocarbon group having 2 to 10 carbon atoms; X represents a divalent organic group having 1 to 30 carbon atoms; "p" represents an integer of 0 to 5; "q₁" represents an integer of 1 to 6; "p + q₁" represents an integer of 1 or more and 6 or less; and "q₂" represents 0 or 1.

When the flowability accelerator contains: the resin having the structural unit represented by the general formula (2); or the resin having both the structural unit represented by the general formula (1) and the structural unit represented by the general formula (2), the flowability is increased to be further effective for filling the high aspect-ratio pattern substrate. In addition, since having low compatibility with a polar solvent, the flowability accelerator is effective for reducing an amount of a remained solvent in the filling film.

It is preferable that, in the general formula (2), R^{b} represents any one of an alkyl group having 1 to 30 carbon atoms or a structure represented by the following general formula (3), and a content of the general formula (2) satisfies relationships of a + b = 1 and 0.2 ≤ b ≤ 0.8, where "a" represents a proportion of the general formula (1) and "b" represents a proportion of the general formula (2), 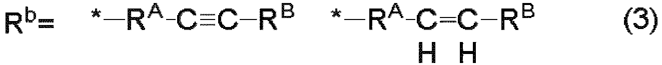 wherein "*" represents a bonding position to the oxygen atom; R^{A} represents a divalent organic group having 1 to 10 carbon atoms and optionally having a substituent; and R^{B} represents a hydrogen atom or a monovalent organic group having 1 to 10 carbon atoms and optionally having a substituent.

Since a composition for forming a metal oxide film containing such a flowability accelerator (B) can exhibit the flowability which is further improved, the composition is further effective for filling the high aspect-ratio pattern substrate. When the contents of the general formula (1) and the general formula (2) are within the above range, physical properties required for use for forming the metal oxide film, such as the filling property, the dry etching resistance, and the adhesiveness to a substrate, can be regulated within appropriate ranges. Regulating the contents of the general formula (1) and the general formula (2) according to the surface state of the metal oxide nanoparticle can improve the dispersion stability of the metal oxide nanoparticle in the composition.

The dispersion stabilizer (C) preferably has a weight reduction rate of less than 30% on a temperature change from 30°C to 190°C, and preferably has a weight reduction rate of 98% or more on a temperature change from 30°C to 350°C.

The features of the weight reduction rate of less than 30% on a temperature change from 30°C to 190°C and the weight reduction rate of 98% or more on a temperature change from 30°C to 350°C contribute to improvement of flowability of the composition during the coating. Since removed from the film after baking at 350°C, the dispersion stabilizer (C) can improve the filling/planarizing property without deterioration in dry etching resistance. In addition, the dispersion stabilizer (C) can also inhibit defect occurrence caused by drying, which can contribute to improvement of an yield of semiconductor manufacturing.

The dispersion stabilizer (C) preferably contains one or more compounds selected from the following general formulae (I) to (III), 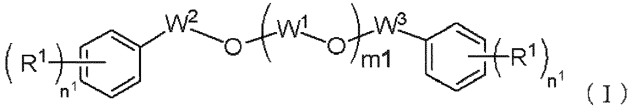
wherein R¹ each independently represents a hydrogen atom, a hydroxy group, or an organic group having 1 to 10 carbon atoms and optionally having a substituent; W¹ represents a phenylene group or a divalent group represented by the following general formula (I-1); each of W² and W³ represents a single bond or any one divalent group represented by the following general formula (1-2); "m¹" represent an integer of 1 to 10; and "n¹" represents an integer of 0 to 5, 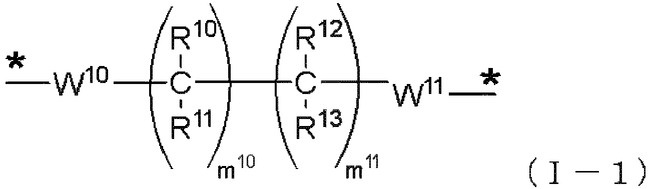
wherein "*" represents a bonding position; each of R¹⁰, R¹¹, R¹², and R¹³ represents a hydrogen atom, a hydroxy group, or an organic group having 1 to 10 carbon atoms; W¹⁰ and W¹¹ each independently represent a single bond or a carbonyl group; each of "m¹⁰" and "m¹¹" represents an integer of 0 to 10; and m¹⁰ + m¹¹ > 1, 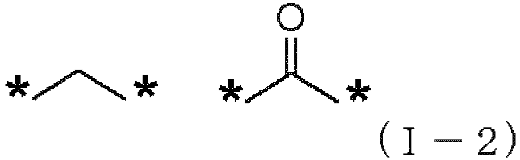
wherein "*" represents a bonding position, 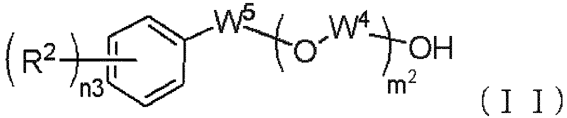
wherein R² each independently represents a hydrogen atom or an organic group having 1 to 10 carbon atoms and optionally having a substituent; W⁴ represents any one divalent group represented by the following general formula (II-1); W⁵ represents a single bond or a divalent group represented by the following general formula (II-2); "m²" represents an integer of 2 to 10; and "n³" represents an integer of 0 to 5, 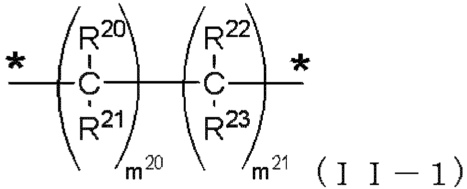
wherein "*" represents a bonding position; each of R²⁰, R²¹, R²², and R²³ represents a hydrogen atom, a hydroxy group, or an organic group having 1 to 10 carbon atoms; each of "m²⁰" and "m²¹" represents an integer of 0 to 10; and m²⁰ + m²¹ ≥ 1, 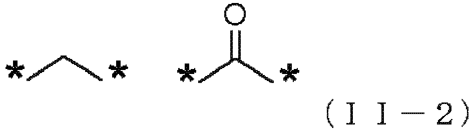
wherein "*" represents a bonding position, 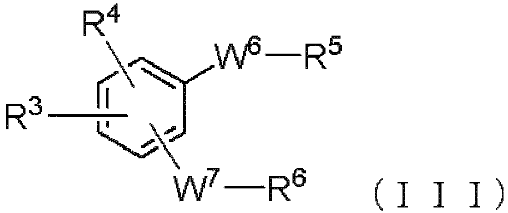
wherein each of R³ and R⁴ represents a hydrogen atom, a hydroxy group, or an organic group having 1 to 10 carbon atoms and optionally having a substituent, and R³ and R⁴ are optionally bonded to each other to form a cyclic structure; each of R⁵ and R⁶ represents an organic group having 1 to 10 carbon atoms, and R⁵ represents a group having any one of an aromatic ring or a divalent group represented by the following general formula (III-1); and each of W⁶ and W⁷ represents a single bond or any one divalent group represented by the following general formula (III-2), and at least one of W⁶ and W⁷ represents the divalent group represented by the following general formula (III-2), 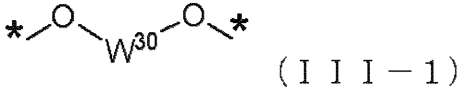
wherein "*" represents a bonding position; and W³⁰ represents an organic group having 1 to 4 carbon atoms, 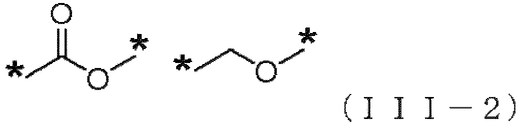
wherein "*" represents a bonding position.

Using the dispersion stabilizer having the aromatic ring being a hydrophobic moiety and the structure having an oxygen atom being a hydrophilic moiety, represented by the structure (C-1), can prepare the composition for forming a metal oxide film having excellent dispersibility/stability of the metal oxide nanoparticle even in a composition at a concentration of the resin for the flowability accelerator of 9 mass% or more.

The metal oxide nanoparticle (A) is preferably one or more kinds of an oxide nanoparticle of a metal selected from the group consisting of zirconium, hafnium, aluminum, tungsten, titanium, copper, tin, cerium, indium, zinc, yttrium, lanthanum, chromium, cobalt, platinum, iron, antimony, and germanium.

Using such a metal oxide nanoparticle can prepare the composition for forming a metal oxide film having excellent dispersibility/stability of the metal oxide nanoparticle.

The metal oxide nanoparticle (A) is preferably one or more of metal oxide nanoparticles selected from the group consisting of a zirconium oxide nanoparticle, a hafnium oxide nanoparticle, a tungsten oxide nanoparticle, a titanium oxide nanoparticle, and a tin oxide nanoparticle.

Using such a metal oxide nanoparticle can form the metal oxide film having excellent etching resistance.

The metal oxide nanoparticle (A) preferably has an average primary particle diameter of 100 nm or less.

Using such a metal oxide nanoparticle can prepare the composition for forming a metal oxide film having excellent dispersibility and stability of the metal oxide nanoparticle.

A weight ratio between the metal oxide nanoparticle (A) and the flowability accelerator (B) is preferably 80/20 to 10/90.

According to the composition for forming a metal oxide film having the ratio between (A) and (B) within the above range, physical properties required for use for forming the metal oxide film, such as filling property, the dry etching resistance, and the adhesiveness to a substrate, can be regulated within appropriate ranges. In addition, the composition for forming a metal oxide film can be provided without impairing the dispersion stability of the metal oxide nanoparticle in the composition.

The composition for forming a metal oxide film preferably further comprises one or more of a crosslinker, a surfactant, and an acid generator.

The composition for forming a metal oxide film containing the above additive has further excellent coatability, dry etching resistance, and the filling property.

The present invention also provides a patterning process for forming a pattern on a substrate to be processed, comprising steps of:
(I-1) applying the above composition for forming a metal oxide film onto a substrate to be processed, and then heat-treating the composition to form a metal oxide film;
(I-2) forming a resist upper layer film on the metal oxide film by using a photoresist material;
(I-3) subjecting the resist upper layer film to pattern exposure, and then to development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern on the substrate to be processed.

The patterning process with the above two-layer resist process can form a fine pattern on a body to be processed (substrate to be processed).

The present invention also provides a patterning process for forming a pattern on a substrate to be processed, comprising steps of:
(II-1) applying the above composition for forming a metal oxide film on a substrate to be processed, and then heat-treating the composition to form a metal oxide film;
(II-2) forming a silicon-containing resist middle layer film on the metal oxide film by using a silicon-containing resist middle layer film material;
(II-3) forming a resist upper layer film on the silicon-containing resist middle layer film by using a photoresist material;
(II-4) subjecting the resist upper layer film to pattern exposure, and then to development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal oxide film by dry etching while using the silicon-containing resist middle layer film having the transferred pattern as a mask; and
(II-7) processing the substrate to be processed while using the metal oxide film having the formed pattern as a mask to form the pattern on the substrate to be processed.

The patterning process with the above three-layer resist process can form a fine pattern on a substrate to be processed with high precision.

The present invention also provides a patterning process for forming a pattern on a substrate to be processed, comprising steps of:
(III-1) applying the above composition for forming a metal oxide film on a substrate to be processed, and then heat-treating the composition to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure, and then to development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern on the substrate to be processed.

The patterning process with the above four-layer resist process can form a fine pattern on a substrate to be processed with high precision.

The present invention also provides a patterning process for forming a pattern on a substrate to be processed, comprising steps of:
(IV-1) forming a resist underlayer film on a substrate to be processed;
(IV-2) forming: a resist middle layer film; or a combination of an inorganic hard mask middle layer film and an organic thin film on the resist underlayer film, the inorganic hard mask middle layer film being selected from a silicon oxide film, a silicon nitride film, and a silicon oxynitride film;
(IV-3) forming a resist upper layer film on the resist middle layer film or on the combination of the inorganic hard mask middle layer film and the organic thin film by using a photoresist material;
(IV-4) subjecting the resist upper layer film to pattern exposure, and then to development with a developer to form a pattern in the resist upper layer film;
(IV-5) transferring the pattern to the resist middle layer film or to the organic thin film and the inorganic hard mask middle layer film by dry etching while using the resist upper layer film having the formed pattern as a mask;
(IV-6) transferring the pattern to the resist underlayer film by dry etching while using the resist middle layer film or the inorganic hard mask middle layer film having the transferred pattern as a mask;
(IV-7) applying the above composition for forming a metal oxide film onto the resist underlayer film having the formed pattern, heat-treating the composition to cover the metal oxide film and fill a gap of the resist underlayer film pattern with the metal oxide film;
(IV-8) etching back the metal oxide film covering the resist underlayer film having the formed pattern by a chemical stripper or dry etching, the metal oxide film so as to have an uncovered upper surface of the resist underlayer film having the formed pattern;
(IV-9) removing the resist middle layer film or the inorganic hard mask middle layer film remained on the upper surface of the resist underlayer film by dry etching;
(IV-10) removing the resist underlayer film having the uncovered surface and the formed pattern by dry etching to form a reversed pattern to the original pattern on the metal oxide film; and
(IV-11) processing the substrate to be processed while using the metal oxide film having the formed reversed pattern as a mask to form a tone-reversed pattern on the substrate to be processed.

The patterning process with the above reversing process can form a fine pattern on a substrate to be processed with further higher precision.

The present invention provides a patterning process using a composition for forming a metal oxide film as a sacrificial film, comprising steps of:
(V-1) applying the above composition for forming a metal oxide film onto a substrate to be processed having a structure or a step, then heat-treating the composition to fill a metal oxide film;
(V-2) removing the metal oxide film outside the structure or the step on the substrate to be processed by a CMP method to remove the metal oxide from a surface of the substrate to be processed;
(V-3) alternately stacking an insulative film and a conductive film on the substrate to be processed filled with the metal oxide film;
(V-4) forming an organic resist underlayer film on a stacked film of the insulative film and the conductive film formed on the substrate to be processed filled with the metal oxide film;
(V-5) forming a resist middle layer film, or an inorganic hard mask middle layer film, or a combination of the inorganic hard mask middle layer film and an organic thin film on the organic resist underlayer film, the inorganic hard mask middle layer film being selected from a silicon oxide film, a silicon nitride film, and a silicon oxynitride film;
(V-6) forming a resist upper layer film on the resist middle layer film, or on the inorganic hard mask middle layer film, or on the combination of the inorganic hard mask middle layer film and the organic thin film by using a photoresist material;
(V-7) subjecting the resist upper layer film to pattern exposure, and then to development with a developer to form a pattern in the resist upper layer film;
(V-8) transferring the pattern to the resist middle layer film, or to the inorganic hard mask middle layer film, or to the organic thin film and the inorganic hard mask middle layer film by dry etching while using the resist upper layer film having the formed pattern as a mask;
(V-9) transferring the pattern to the resist underlayer film by dry etching while using the resist middle layer film or the inorganic hard mask middle layer film having the transferred pattern as a mask;
(V-10) transferring the pattern to the stacked film of the insulative film and the conductive film by dry etching while using the resist underlayer film having the transferred pattern as a mask; and
(V-11) removing the metal oxide film filled on the substrate to be processed while using the stacked film of the insulative film and the conductive film having the transferred pattern as a mask.

The above patterning process can form a multi-stacked structure in 3D-NAND manufacturing, and can contribute to achieve further higher stacking.

The above insulative film can be formed from any appropriate (plurality of) insulative materials. The insulative material can contain, but not limited to, silicon oxide (for example, SiO2) as an example. The conductive film can be formed from any appropriate (plurality of) conductive materials. The conductive material can contain one or more metals such as polysilicon, tungsten, nickel, titanium, platinum, aluminum, gold, tungsten nitride, tantalum nitride, titanium nitride, and silicon nitride. The method for forming each of the conductive materials and the insulative materials is not described in detail herein, but these materials can be formed by a conventional technique.

A substrate having a structure or step having an aspect ratio of 5 or more is preferably used as the substrate to be processed.

In the present invention, the above substrate can be used as the substrate to be processed, for example.

The present invention also provides a method for forming a metal oxide film functioning as a planarizing film used in a semiconductor apparatus manufacturing process, the method comprising:
applying the above composition for forming a metal oxide film onto a substrate to be processed; and
heat-treating the substrate within a range of a temperature of 100°C or higher and 600°C or lower for 10 to 600 seconds to form a cured film.

The present invention also provides a method for forming a metal oxide film functioning as a planarizing film used in a semiconductor apparatus manufacturing process, the method comprising:
applying the above composition for forming a metal oxide film onto a substrate to be processed; and
heat-treating the substrate in an atmosphere with an oxygen concentration of 1 vol% or more and 21 vol% or less to form a cured film.

Such methods can accelerate the crosslinking reaction of the composition for forming a metal oxide film during the formation of the resist underlayer film, and can highly inhibit the mixing with the upper layer film. In addition, appropriately regulating the temperature, time, and oxygen concentration of the heat treatment within the above ranges can yield the filling/planarizing ability and curing characteristics of the metal oxide film suitable for its use.

The present invention also provides a method for forming a metal oxide film functioning as a planarizing film used in a semiconductor apparatus manufacturing process, the method comprising:
applying the above composition for forming a metal oxide film onto a substrate to be processed; and
heat-treating the substrate in an atmosphere with an oxygen concentration of less than 1 vol% to form a cured film.

Such a method can accelerate the crosslinking reaction of the composition for forming a metal oxide film during the formation of the metal oxide film without deterioration in the substrate to be processed even when the substrate to be processed contains a material unstable for heating under an oxygen atmosphere, and can highly inhibit the mixing with the upper layer film, which is useful.

### ADVANTAGEOUS EFFECTS OF INVENTION

As described above, the inventive composition for forming a metal oxide film, the inventive patterning process, and the inventive method for forming a metal oxide film are particularly suitably used for the multilayer resist process including filling/planarizing the substrate to be processed having a step or unevenness, and extremely useful in the fine patterning in the semiconductor apparatus manufacturing. Specifically, since containing the flowability accelerator having excellent cracking resistance, the inventive composition can form a thick film having excellent dry-etching resistance derived from the metal oxide nanoparticle. In addition, since containing the dispersion stabilizer that can further improve the thermal flowability of the resin for the flowability accelerator, the inventive composition can provide the composition for forming a metal oxide film that can be used as the resist underlayer film material which can achieve the filling of a high aspect-ratio pattern substrate, the filling being not able to be achieved by the metal oxide nanoparticle alone. Furthermore, the composition for forming a metal oxide film can be provided which can keep the nanoparticles in a good dispersed state even in a chemical liquid containing the resin at high concentration composition of 9 mass% or more by containing the dispersion stabilizer having the specific structure, and thereby can exhibit an excellent storage stability. In the fine patterning process using the multilayer resist method in the semiconductor apparatus manufacturing process, the inventive composition can fill even the substrate to be processed having a portion with difficulty in filling/planarization, such as a high aspect-ratio pattern substrate represented by the 3D-NAND memories increasing the higher stacking, without defects such as a void and peeling. The inventive composition can form a thick film having extremely excellent dry-etching resistance compared with a conventional coating-type organic resist underlayer film material, and therefore, can form a fine pattern on the body to be processed with further higher precision.

### BRIEF DESCRIPTION OF DRAWINGS

FIG. 1 is an explanatory view of an example of the inventive patterning process (three-layer resist process).
FIG. 2 is an explanatory view of an example of the inventive tone-reversed patterning process (reversing an SOC pattern in a three-layer resist process).
FIG. 3 is an explanatory view of an example of the inventive patterning process using a sacrificial film.
FIG. 4 is an explanatory view of a method for evaluating filling property.

### DESCRIPTION OF EMBODIMENTS

As noted above, in the fine patterning process using the multilayer resist method in the semiconductor apparatus manufacturing process, there has been demands for a thick resist underlayer film material that can fill/planarize even the substrate to be processed having a portion with difficulty in filling/planarization, such as a dense portion of a high aspect-ratio fine pattern structure represented by the 3D-NAND memories increasing the higher integration, without defects such as a void and peeling; that has excellent dry-etching resistance compared with a conventional coating-type organic resist underlayer film material; and that can transfer a resist pattern on the substrate to be processed with higher precision.

The present inventors have made earnestly studies the above object, and consequently investigated various resist underlayer film materials and patterning processes to achieve both of the high filling/planarizing and excellent dry-etching resistance with the underlayer film formation in the multilayer resist method using the resist underlayer film. As a result, the present inventors have found that extremely effective is a patterning process using a composition for forming a metal oxide film comprising: a metal oxide nanoparticle having excellent dry-etching resistance; a flowability accelerator containing a resin having a specific structure having excellent cracking resistance; and a dispersion stabilizer exhibiting an effect of improving resin flowability and storage stability. This finding has led to completion of the present invention.

Specifically, the present invention is a composition for forming a metal oxide film, including:
(A) a metal oxide nanoparticle;
(B) a flowability accelerator containing a resin having a structural unit represented by the following general formula (1);
(C) a dispersion stabilizer having two or more benzene rings or having one benzene ring and a structure represented by the following general formula (C-1), and the dispersion stabilizer being composed of an aromatic group-containing compound having a molecular weight represented by a molecular formula of 500 or less; and
(D) an organic solvent,

wherein the flowability accelerator (B) has a content of 9 mass% or more in an entirety of the composition, a ratio Mw/Mn of a weight-average molecular weight Mw and a number-average molecular weight Mn of the flowability accelerator (B) in terms of polystyrene by a gel permeation chromatography method is 2.50 ≤ Mw/Mn ≤ 9.00, and the flowability accelerator (B) contains no compound nor polymer having a cardo structure, 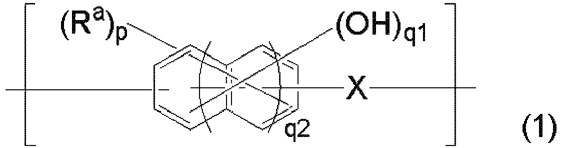
wherein R^{a} represents a saturated monovalent organic group having 1 to 30 carbon atoms or an unsaturated monovalent organic group having 2 to 30 carbon atoms; X represents a divalent organic group having 1 to 30 carbon atoms; "p" represents an integer of 0 to 5; "q₁" represents an integer of 1 to 6; "p + q₁" represents an integer of 1 or more and 6 or less; and "q₂" represents 0 or 1, 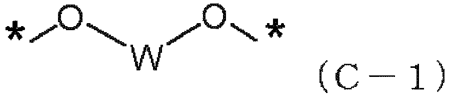
wherein "*" represents a bonding position; and W represents an organic group having 1 to 4 carbon atoms.

Hereinafter, the present invention will be described in detail, but the present invention is not limited thereto. The invention is limited by the scope of the claims.

### <Composition for Forming Metal Oxide Film>

The inventive composition for forming a metal oxide film includes: (A) a metal oxide nanoparticle; (B) a flowability accelerator represented by the specific general formula; (C) a dispersion stabilizer having two or more benzene rings or having one benzene ring and a structure represented by the following general formula (C-1), and the dispersion stabilizer being composed of an aromatic group-containing compound having a molecular weight represented by a molecular formula of 500 or less; and (D) an organic solvent, the components (A) to (D) described later, wherein the flowability accelerator (B) has a content of 9 mass% or more in an entirety of the composition, a ratio Mw/Mn of a weight-average molecular weight Mw and a number-average molecular weight Mn of the flowability accelerator (B) in terms of polystyrene by a gel permeation chromatography method is 2.50 ≤ Mw/Mn ≤ 9.00, and the flowability accelerator (B) contains no compound nor polymer having a cardo structure. The inventive composition may contain additives, such as a surfactant and a crosslinker, as necessary. Hereinafter, the components contained in the inventive composition will be described.

### <(A) Metal Oxide Nanoparticle>

The metal oxide nanoparticle (A) contained in the inventive composition for forming a metal oxide film is preferably one or more kinds of an oxide nanoparticle of a metal selected from the group consisting of zirconium, hafnium, aluminum, tungsten, titanium, copper, tin, cerium, indium, zinc, yttrium, lanthanum, chromium, cobalt, platinum, iron, antimony, and germanium. Among these, a zirconium oxide nanoparticle, a hafnium oxide nanoparticle, a tungsten oxide nanoparticle, a titanium oxide nanoparticle, and a tin oxide nanoparticle are preferable from the viewpoint of dispersibility and dry etching resistance.

By selecting the above metal oxide, a metal oxide film excellent in dispersibility and dry etching resistance can be formed.

The metal oxide nanoparticle (A) preferably has an average primary particle diameter of 100 nm or less, more preferably has an average primary particle diameter of 50 nm or less, further preferably has an average primary particle diameter of 30 nm or less, and particularly preferably 15 nm or less. The average primary particle diameter of the metal oxide nanoparticle before dispersed in the organic solvent can be determined by a method of directly measuring a size of the primary particle on an electron microscopic image. Specifically, a minor axis diameter and a major axis diameter of each primary particle are measured, and an average thereof is specified as a particle diameter of that particle. Then, on 100 or more particles, a volume (mass) of each particle is determined with approximating a cuboid having the determined particle diameter, and determined as a volume-average particle diameter to specify this diameter as the average particle diameter. By using any electron microscope of a transmission microscope (TEM), a scanning electron microscope (SEM), or a scanning transmission electron microscope (STEM), the same result can be obtained.

Within such a particle diameter range, the good dispersibility can be exhibited in the composition for forming a metal oxide film, and a metal oxide film having excellent filling/planarizing property of a dense portion of fine pattern structures can be formed.

As the metal oxide nanoparticle (A) contained in the inventive composition for forming a metal oxide film, a commercially available metal oxide nanoparticle can be used.

Examples of the titania nanoparticle include: TTO series (TTO-51(A), TTO-51(C), etc.), and TTO-S and V series (TTO-S-1, TTO-S-2, TTO-V-3, etc.), manufactured by ISHIHARA SANGYO KAISHA, LTD.; MT series (MT-01, MT-05, MT-100SA, MT-500SA, NS405, etc.), manufactured by TAYCA CORPORATION; and STR-100A-LP, manufactured by SAKAI CHEMICAL INDUSTRY CO., LTD.

Examples of the zirconia nanoparticle include: PCS (manufactured by Nihondenko Co., Ltd.); JS-01, JS-03, and JS-04 (manufactured by Nihondenko Co., Ltd.); UEP, UEP-50, and UEP-100 (manufactured by DAIICHI KIGENSO KAGAKU KOGYO CO., LTD.); PCPB-2-50-PGA and PCPA-2-502-PGA (manufactured by Pixelligent Technologies); ZrO₂ nanoparticles 915505 (manufactured by Sigma-Aldrich); SZR-M, SZR-K, and SZR-En10 (manufactured by SAKAI CHEMICAL INDUSTRY CO., LTD.); and Dispersion of Zirconia Nanoparticles ZIRCOSTAR ZP-153 and HR-101 (manufactured by NIPPON SHOKUBAI CO., LTD.).

As the metal oxide nanoparticle (A) contained in the inventive composition for forming a metal oxide film, one kind of nanoparticle may be used singly, or the combination of two or more kinds thereof may be used. These nanoparticles can be selected with any combination according to a required performance. A content of the component (A) can be 11 to 400 parts by mass relative to 100 parts by mass of the flowability accelerator in the composition.

### <(B) Flowability Accelerator >

The inventive composition for forming a metal oxide film includes the flowability accelerator (B) containing the resin having the structural unit represented by the following general formula (1) at 9 mass% or more of the entirety of the composition, and containing no compound nor polymer having a cardo structure, 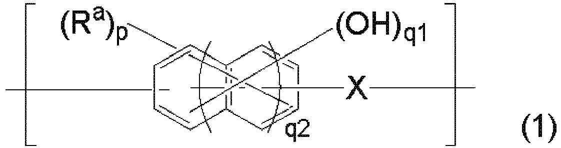 wherein R^{a} represents a saturated monovalent organic group having 1 to 30 carbon atoms or an unsaturated monovalent organic group having 2 to 30 carbon atoms; X represents a divalent organic group having 1 to 30 carbon atoms; "p" represents an integer of 0 to 5; "q₁" represents an integer of 1 to 6; "p + q₁" represents an integer of 1 or more and 6 or less; and "q₂" represents 0 or 1.

When the content of the flowability accelerator (B) is 9 mass% or more, a thick metal oxide film can be formed. Thus, it is considered that the resist underlayer film has excellent filling property and can be formed without defects such as a void and peeling even on a substrate to be processed having a high aspect ratio and a portion which is particularly difficult to be filled. With considering the increase in an aspect ratio of a pattern requiring filling as further higher stacking of the 3D-NAND, the content of the flowability accelerator (B) is more preferably 15 mass% or more, and further preferably 20 mass% or more.

The flowability accelerator (B) containing no compound nor polymer having a cardo structure can form a thick metal oxide film having excellent cracking resistance. A fluorene ring having a cardo structure, which has a rigid structure and a large steric hindrance, can form a film having excellent heat resistance. However, such a high carbon material is likely to cause cracking due to thermal contraction during the baking, and is unsuitable for thick film formation.

The inventive composition preferably contains no resin having a high carbon content, not only the cardo structure. A carbon content rate of the flowability accelerator (B) measured by elemental analysis is preferably 90 mass% or less, and further preferably 85 mass% or less. The carbon content rate is measured as follows: forming a coating film on a substrate by using a composition dissolving only the flowability accelerator in a solvent component without the nanoparticle component; baking the produced film at 350°C for approximately 60 seconds; and then measuring the carbon content rate.

In the general formula (1), examples of the saturated monovalent organic group having 1 to 30 carbon atoms or the unsaturated monovalent organic group having 2 to 30 carbon atoms represented by R^{a} include: monovalent saturated hydrocarbon groups, such as a methyl group, an ethyl group, an n-propyl group, an i-propyl group, an n-butyl group, an i-butyl group, a sec-butyl group, a tert-butyl group, an n-pentyl group, an iso-pentyl group, a sec-pentyl group, and a tert-pentyl group; monovalent unsaturated chain hydrocarbon groups, such as an ethenyl group, a propenyl group, a butenyl group, a pentenyl group, an etynyl group, and a propynyl group; monocyclic saturated cyclic hydrocarbon groups, such as a cyclobutyl group, a cyclopentyl group, a cyclohexyl group, a cycloheptyl group, and a cyclooctyl group; monovalent monocyclic unsaturated cyclic hydrocarbon groups, such as a cyclobutenyl group, a cyclopentenyl group, and a cyclohexenyl group; monovalent polycyclic hydrocarbon groups, such as a norbornyl group and an adamantyl group; and monovalent aromatic hydrocarbon groups, such as a phenyl group, a methylphenyl group, a naphthyl group, a methylnaphthyl group, an anthryl group, and a methylanthryl group.

Examples of the organic group represented by the R^{a} include: alkoxy groups, such as a methoxy group, an ethoxy group, an n-propoxy group, an i-propoxy group, an n-butoxy group, an i-butoxy group, a sec-butoxy group, a t-butoxy group, an n-pentyloxy group, and an n-hexyloxy group; and alkoxycarbonyl groups, such as a methoxycarbonyl group, an ethoxycarbonyl group, an n-propoxycarbonyl group, an i-propoxycarbonyl group, an n-butoxycarbonyl group, an i-butoxycarbonyl group, a sec-butoxycarbonyl group, a t-butoxycarbonyl group, an n-pentyloxycarbonyl group, and an n-hexyloxycarbonyl group.

A part or all of hydrogen atoms in the saturated hydrocarbon group, the unsaturated chain hydrocarbon group, the monocyclic saturated cyclic hydrocarbon group, the monocyclic unsaturated cyclic hydrocarbon group, the polycyclic hydrocarbon group, the aromatic hydrocarbon group, the alkoxy group, the alkoxycarbonyl group, etc. are optionally substituted. Examples of the substituent include halogen atoms such as a fluorine atom, a chlorine atom, a bromine atom, and an iodine atom; a hydroxy group; a cyano group; a carboxy group; a nitro group; an amino group; an alkoxy group; an alkoxycarbonyl group; an acyl group; an alkoxycarbonyloxy group; an aryl group; aliphatic heterocyclic groups such as a lactone group; and aromatic heterocyclic groups such as a furyl group and a pyridyl group.

Preferable examples of the organic group represented by the R^{a} include a methyl group from the viewpoint of availability of the raw material.

In the general formula (1), examples of the divalent organic group having 1 to 30 carbon atoms represented by X include: alkanediyl groups, such as a methylene group, an ethanediyl group, a propanediyl group, a butanediyl group, a pentanediyl group, a hexanediyl group, an octanediyl group, and a decanediyl group; monocyclic cycloalkanediyl groups, such as a cyclopropanediyl group, a cyclobutanediyl group, a cyclopentanediyl group, a cylohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups, such as a bicyclo[2.2.1]heptanediyl group, a bicyclo[2.2.2]octanediyl group, a tricyclo[5.2.1.0^{2,6}]decanediyl group (dicyclopentylene group), a tricyclo[3.3.1.1^{3,7}]decanediyl group, a tetracyclo[6.2.1.1^{3,6}.0^{2,7}]dodecanediyl group, and an adamantanediyl group; and arenediyl groups, such as a phenylene group and a naphthylene group.

Examples of the alkanediyloxy group represented by X include a group combining the above alkanediyl group and an oxygen atom. Examples of the cycloalkanediyloxy group represented by X include a group combining the above cycloalkanediyl group and an oxygen atom.

A part or all of hydrogen atoms in the alkanediyl group, the cycloalkanediyl group, the alkanediyloxy group, the cycloalkanediyloxy group, and the arenediyl group are optionally substituted. Examples of the substituent include groups same as the substituent examples that may be contained in the organic group represented by R^{a}.

Examples of the organic group represented by the above X include groups represented by the following formulae, 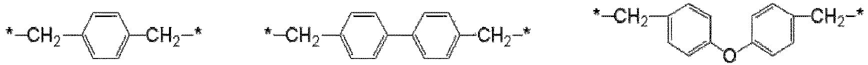 wherein "*" represents a bond.

Preferable examples of the above X include a methylene group from the viewpoint of availability of the raw material.

Specific examples of the resin having the structural unit (B) represented by the general formula (1) include the following resins.

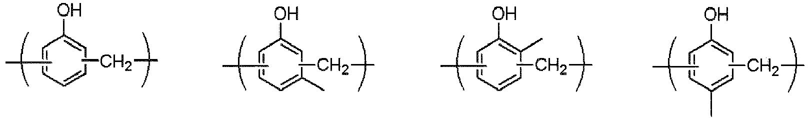

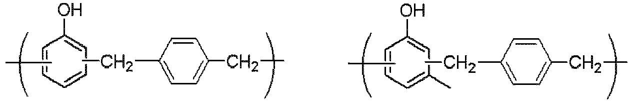

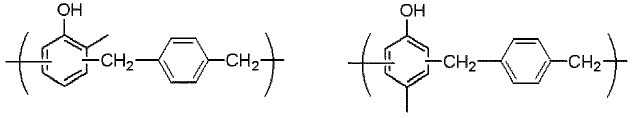

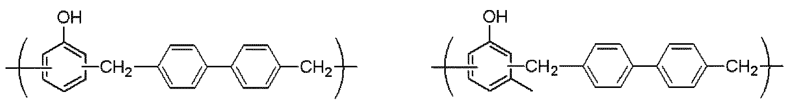

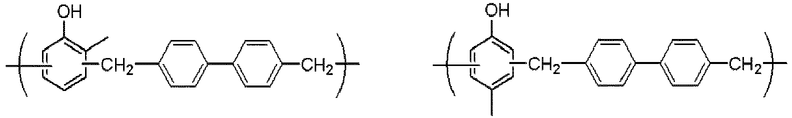

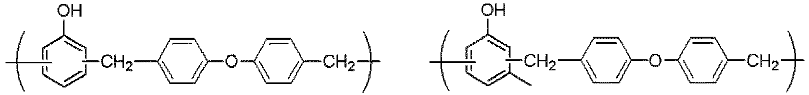

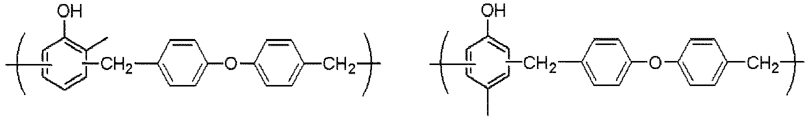

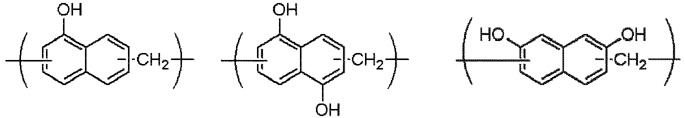

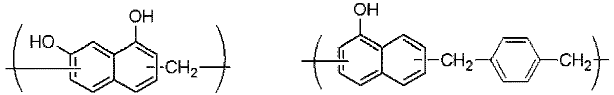

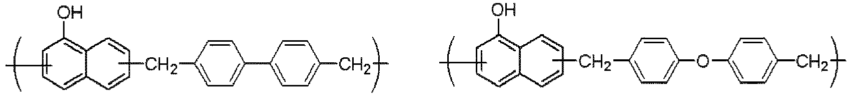

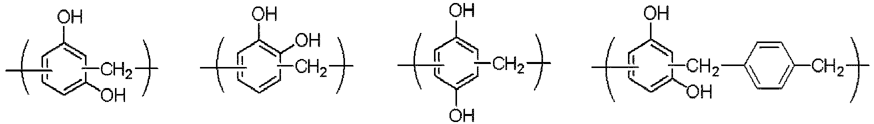

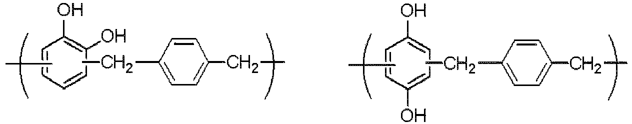

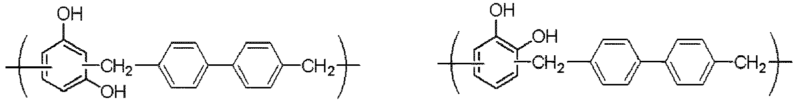

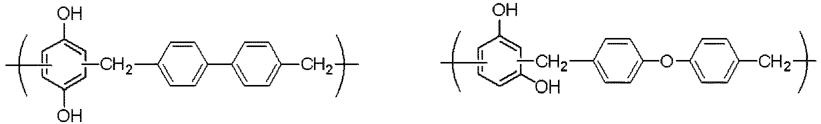

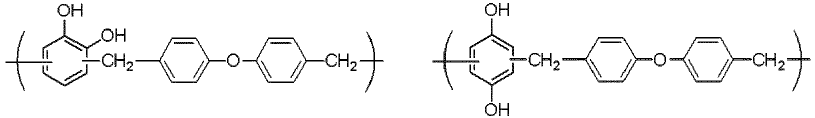

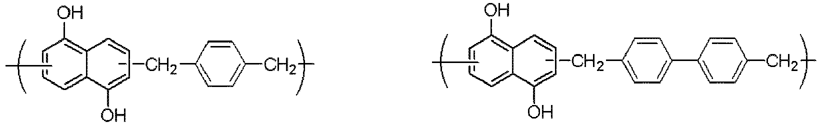

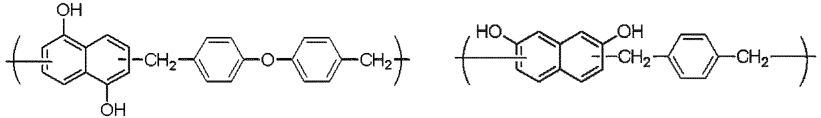

The flowability accelerator (B) has a ratio Mw/Mn of a weight-average molecular weight Mw and a number-average molecular weight Mn in terms of polystyrene by a gel permeation chromatography method of 2.50 ≤ Mw/Mn ≤ 9.00, preferably 3.00 ≤ Mw/Mn ≤ 8.00.

Such a dispersion degree yields further better thermal flowability of the resin contained in the flowability accelerator. Thus, the blended composition can favorably fill a fine structure formed on a substrate, and in addition, can form a resist underlayer film which makes the substrate be entirely planarized.

The flowability accelerator (B) preferably has a weight-average molecular weight Mw in terms of polystyrene by a gel permeation chromatography method of 1,500 ≤ Mw ≤ 20,000, more preferably 3,000 ≤ Mw ≤ 15,000, particularly preferably 4,000 ≤ Mw ≤ 12,000.

Such a range of the molecular weight yields further better thermal flowability of the resin contained in the flowability accelerator. Thus, the blended composition can favorably fill a fine structure formed on a substrate, and in addition, can form a resist underlayer film which makes the substrate entirely planarized. Furthermore, the composition can form a metal oxide film having excellent uniformity of film thickness and reduced sublimate.

The flowability accelerator (B) may contain the resin having a structural unit represented by the following general formula (2) in addition to the resin having the structural unit represented by the general formula (1), 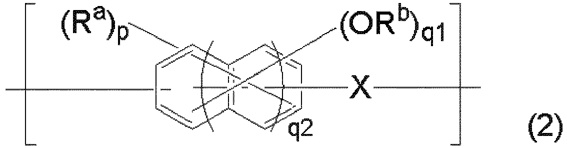 wherein R^{a} represents a saturated monovalent organic group having 1 to 30 carbon atoms or an unsaturated monovalent organic group having 2 to 30 carbon atoms; R^{b} represents a saturated hydrocarbon group having 1 to 30 carbon atoms or an unsaturated hydrocarbon group having 2 to 10 carbon atoms; X represents a divalent organic group having 1 to 30 carbon atoms; "p" represents an integer of 0 to 5; "q₁" represents an integer of 1 to 6; "p + q₁" represents an integer of 1 or more and 6 or less; and "q₂" represents 0 or 1.

In the general formula (2), examples of the saturated monovalent organic group having 1 to 30 carbon atoms or the unsaturated monovalent organic group having 2 to 10, represented by R^{b}, include same groups as of R^{a}.

The flowability accelerator containing the resin having the structural unit represented by the general formula (2) has increased flowability and is effective for filling a higher aspect-ratio pattern substrate. In addition, since having low compatibility with a polar solvent, the flowability accelerator is effective for reducing an amount of a remained solvent in the filling film.

Preferable aspects of the general formula (2) include a resin having a structural unit in which R^{b} represents any one of an alkyl group having 1 to 30 carbon atoms or a structure represented by the following general formula (3), 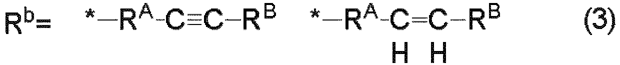 wherein "*" represents a bonding position to the oxygen atom; R^{A} represents a divalent organic group having 1 to 10 carbon atoms and optionally having a substituent; and R^{B} represents a hydrogen atom or a monovalent organic group having 1 to 10 carbon atoms and optionally having a substituent.

In the general formula (3), examples of the divalent organic group having 1 to 10 carbon atoms represented by R^{A} include: alkanediyl groups, such as a methylene group, an ethanediyl group, a propanediyl group, a butanediyl group, a pentanediyl group, a hexanediyl group, an octanediyl group, and a decanediyl group; and arenediyl groups, such as a benzenediyl group, a methylbenzenediyl group, and a naphthalenediyl group.

In the general formula (3), examples of the monovalent organic group having 1 to 10 carbon atoms represented by R^{B} include: alkyl groups, such as a methyl group, an ethyl group, an n-propyl group, an i-propyl group, an n-butyl group, an i-butyl group, a sec-butyl group, a t-butyl group, an n-pentyl group, an n-hexyl group, an n-octyl group, and an n-decyl group; and aryl groups, such as a phenyl group, a tolyl group, a xylyl group, a mesityl group, and a naphthyl group.

A part or all of hydrogen atoms in the alkanediyl group, the arenediyl group, the alkyl group, and the aryl group are optionally substituted. Examples of the substituent include groups same as the substituent examples that may be contained in the organic group represented by R^{a}.

Specifically preferable examples thereof include the following structures. When having such structures, the flowability accelerator can provide a composition for forming a metal oxide film that can form a filling film having excellent filling property for a high aspect-ratio pattern. The structures, which also yield good heat resistance and film formability, can inhibit production of sublimate during the heating curing, inhibit apparatus contamination due to the sublimate, and inhibit generation of a coating defect.

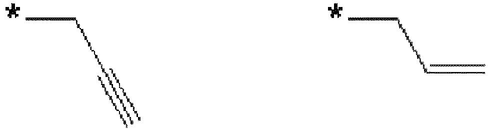

In the formulae, "*" represents a bonding position to the oxygen atom.

The flowability accelerator having such a crosslinking group can further improve the flowability, and can form a cured film having excellent film formability and reduced outgas.

Specific examples of the polymer having the structural unit represented by the general formula (2) include the following polymers.

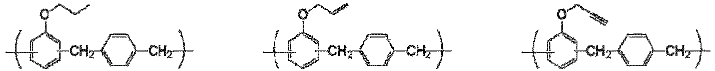

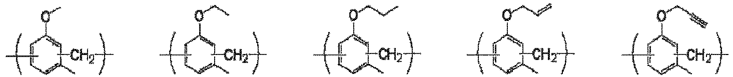

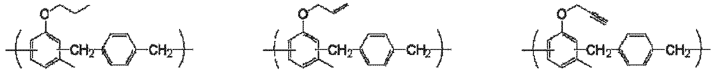

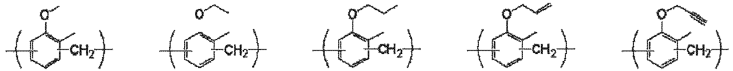

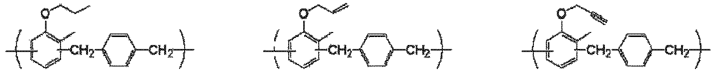

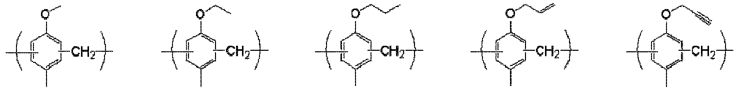

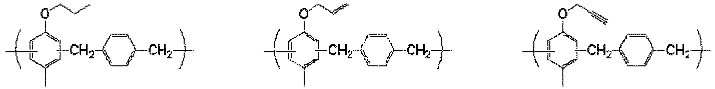

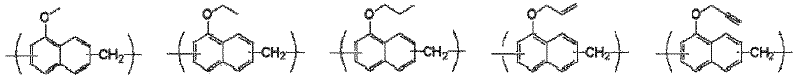

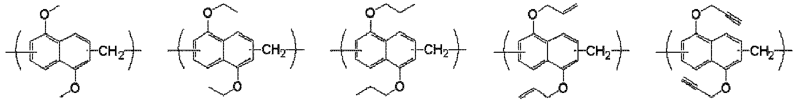

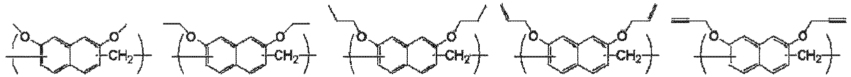

A content of the polymer having the structural unit represented by the general formula (2) preferably satisfies relationships of a + b = 1 and 0.2 ≤ b ≤ 0.8, more preferably 0.3 ≤ b ≤ 0.7 where "a" represents a proportion of the resin having the structural unit represented by the general formula (1) and "b" represents a proportion of the resin having the structural unit represented by the general formula (2).

By regulating the proportion of the resin represented by the general formula (2) within such a range, flowability and the adhesiveness to a substrate can be highly exhibited, and a resist underlayer film material having improved filling/planarizing property can be provided. For improving the film formability and adhesiveness of the film to a substrate, the proportion "a" of the resin having a hydroxy group is increased, that is a > b. For improving the curability, the heat resistance, and the planarizing property, a < b. These can be regulated to any proportions according to the required performance. By regulating the contents of the general formula (1) and the general formula (2) according to the surface state of the metal oxide nanoparticle, the dispersion stability of the metal oxide nanoparticle in the composition can be improved.

As noted above, the similar composition can be prepared by not only mixing the two resins at a desired ratio but also regulating proportions of substituents in one resin. Specifically, such a resin is a resin having both of the structural unit represented by the general formula (1) and the structural unit represented by the general formula (2). In this case, a resin represented by the following general formula (4) is preferably used for regulating a proportion of the structure constituting R^{c}, which can prepare the composition. Specifically, a relationship of a + b = 1 is satisfied where "a" represents a proportion of hydrogen atoms in the structure constituting R^{c}, and "b" represents a proportion of the alkyl group having the structure having 1 to 30 carbon atoms or the structure represented by the general formula (3). In this case, the proportion preferably satisfies a relationship of 0.2 ≤ b ≤ 0.8, and further preferable example of the proportion include a relationship of 0.3 ≤ b ≤ 0.7.

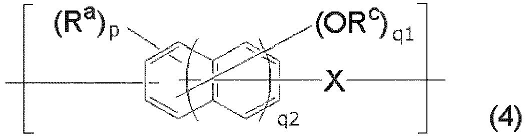

In the formula, R^{a}, "p", "q1", "q2", and X represent the same as above. R^{c} represents any one of a hydrogen atom, an alkyl group having 1 to 30 carbon atoms, or the structure represented by the general formula (3). The structure constituting R^{c} satisfies a relationship of a + b = 1 where "a" represents a proportion of the hydrogen atom, and "b" represents a proportion of the alkyl group having 1 to 30 carbon atoms or the structure represented by the general formula (3).

The inventive composition for forming a metal oxide film has a weight ratio between the metal oxide nanoparticle (A) and the flowability accelerator (B) of preferably 80/20 to 10/90, more preferably 70/30 to 20/80, further preferably 70/30 to 30/70.

By regulating the ratio between the metal oxide nanoparticle (A) and the flowability accelerator (B) within the above range, the dry etching resistance and the filling/planarizing property can be highly exhibited. When the ratio is within a range of 80/20 to 10/90, thick film formation is easily achieved without deterioration in the heat resistance and the dry etching resistance. For improving the dry etching resistance, the proportion of the metal oxide nanoparticle (A) is increased. For improving the filling/planarizing property, the proportion of the flowability accelerator (B) is increased. These can be regulated to any proportions according to the required performance. The content of the component (B) in the composition can be 25 to 900 parts by mass relative to 100 parts by mass of the metal oxide nanoparticle.

### <(C) Dispersion Stabilizer>

The dispersion stabilizer (C) used in the present invention is an aromatic group-containing compound having a molecular weight represented by the molecular formula of 500 or less, preferably having an oxygen atom, and having an aromatic ring.

The dispersion stabilizer (C) having a molecular weight within the above range exhibits sufficient thermal flowability during the baking, and thereby exhibits high filling property and reduces the residue in the metal oxide film after the baking. The molecular weight on the molecular formula representing the dispersion stabilizer is preferably 180 to 500, preferably 200 to 450, and particularly preferably 240 to 400.

When the dispersion stabilizer has a molecular weight of 180 or more, such a dispersion stabilizer is not easily reduced by evaporation, etc. with the heat treatment, and has excellent thermal flowability and sufficient filling/planarizing property. If the molecular weight is more than 500, evaporation, etc. of the dispersion stabilizer by the heat treatment is inhibited. Thus, the crosslinking reaction between the metal oxide nanoparticle and the flowability accelerator in the composition for forming a metal oxide film and the evaporation of the dispersion stabilizer simultaneously occur to deteriorate the film formability and in-plane uniformity. The residue of the dispersion stabilizer in the film may also deteriorate the etching resistance.

As the aromatic ring, a benzene ring is essential. Examples of other aromatic rings include: aromatic carbon rings, such as a naphthalene ring; and aromatic heterorings, such as a furan ring, a pyrrole ring, a thiophene ring, a phosphole ring, a pyrazole ring, an oxazole ring, an isoxazole ring, a thiazole ring, a pyridine ring, a pyrazine ring, a pyrimidine ring, a pyridazine ring, and a triazine ring.

For the inventive composition for forming a metal oxide film, the thermal flowability accelerator having the aromatic skeleton is used. The dispersion stabilizer is preferably the aromatic group-containing compound because the dispersion stabilizer has excellent compatibility with the resin for the thermal flowability accelerator, and a film formation defect such as a pinhole hardly occurs during the film formation. Among the aromatic rings, aromatic carbon rings are preferable, and a benzene ring is more preferable.

Example of the dispersion stabilizer (C) include a compound having two or more benzene rings or having one benzene ring and a structure represented by the following general formula (C-1), 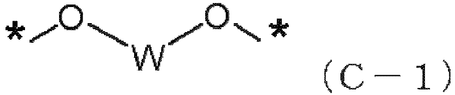 wherein "*" represents a bonding position; and W represents an organic group having 1 to 4 carbon atoms.

Specific examples of W include a methylene group, an ethylene group, a propylene group, a butylene group, a trimethylene group, and a tetramethylene group. Among these, an ethylene group is preferable.

The dispersion stabilizer (C) preferably has a weight reduction rate of less than 30% on a temperature change from 30°C to 190°C, and has a weight reduction rate of 98% or more on a temperature change from 30°C to 350°C.

Of the dispersion stabilizer having the weight reduction rate of less than 30% on a temperature change from 30°C to 190°C and having the weight reduction rate of 98% or more on a temperature change from 30°C to 350°C, the evaporation during the heat treatment is inhibited and its low viscosity is sufficiently maintained. Such a dispersion stabilizer is preferable because of excellent thermal flowability and reduced residue of the dispersion stabilizer in the metal oxide film after baking. The weight reduction rate herein is based on a value determined by thermogravimetry (TG) measurement with a differential thermal balance.

An upper limit of the temperature range in which the weight reduction rate of the dispersion stabilizer is less than 30% is further preferably 210°C, and further preferably 230°C. By regulating the temperature range in which the weight reduction rate of the dispersion stabilizer is less than 30% within the above temperature range, the filling/planarizing property can be further improved.

The temperature at which the weight reduction rate of the dispersion stabilizer is 98% or more is further preferably 330°C, and particularly preferably 310°C. By regulating the temperature at which the weight reduction rate of the dispersion stabilizer is 98% or more within the above temperature range, the residue of the dispersion stabilizer in the metal oxide film after baking can be further reduced.

By blending the dispersion stabilizer as described-above, the thermal flowability between the beginning of the heat treatment and the curing with the crosslinking reaction of the composition for forming a metal oxide film can be improved. Thus, the composition exhibits excellent filling/planarizing property. Meanwhile, the dispersion stabilizer is reduced by evaporation, etc. with the heat treatment, and thereby does not impair the etching resistance and optical characteristics.

Further preferable aspects of the dispersion stabilizer include one or more compounds selected from the following general formulae (I) to (III), 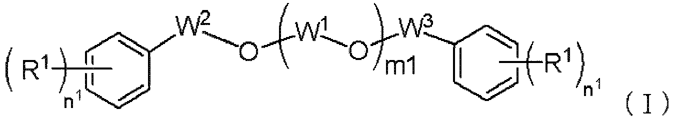
wherein R¹ each independently represents a hydrogen atom, a hydroxy group, or an organic group having 1 to 10 carbon atoms and optionally having a substituent; W¹ represents a phenylene group or a divalent group represented by the following general formula (I-1); each of W² and W³ represents a single bond or any one divalent group represented by the following general formula (1-2); "m¹" represents an integer of 1 to 10; and "n¹" represents an integer of 0 to 5, 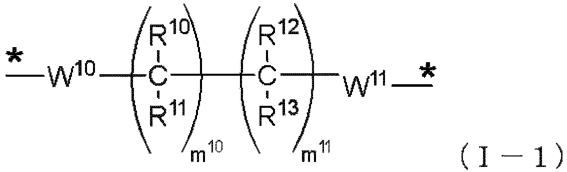
wherein "*" represents a bonding position; each of R¹⁰, R¹¹, R¹², and R¹³ represents a hydrogen atom, a hydroxy group, or an organic group having 1 to 10 carbon atoms; W¹⁰ and W¹¹ each independently represent a single bond or a carbonyl group; each of "m¹⁰" and "m¹¹" represents an integer of 0 to 10; and m¹⁰ ₊ m¹¹ ≥ 1, 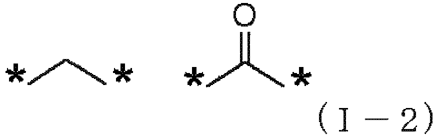
wherein "*" represents a bonding position.

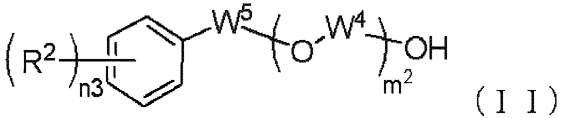

In the formula, R² each independently represents a hydrogen atom or an organic group having 1 to 10 carbon atoms and optionally having a substituent; W⁴ represents any one divalent group represented by the following general formula (II-1); W⁵ represents a single bond or a divalent group represented by the following general formula (II-2); "m²" represents an integer of 2 to 10; and "n³" represents an integer of 0 to 5.

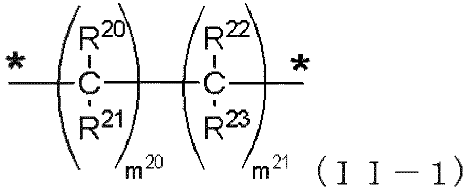

In the formula, "*" represents a bonding position; each of R²⁰, R²¹, R²², and R²³ represents a hydrogen atom, a hydroxy group, or an organic group having 1 to 10 carbon atoms; each of "m²⁰" and "m²¹" represents an integer of 0 to 10; and m²⁰ + m²¹ ≥ 1.

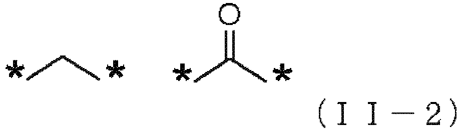

In the formula, "*" represents a bonding position.

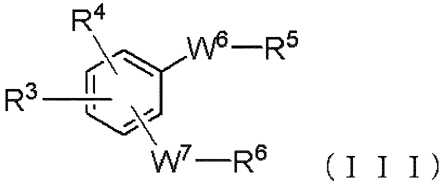

In the formula, each of R³ and R⁴ represents a hydrogen atom, a hydroxy group, or an organic group having 1 to 10 carbon atoms and optionally having a substituent, and R³ and R⁴ are optionally bonded to each other to form a cyclic structure; each of R⁵ and R⁶ represents an organic group having 1 to 10 carbon atoms, and R⁵ represents a group having any one of an aromatic ring or a divalent group represented by the following general formula (III-1); and each of W⁶ and W⁷ represents a single bond or any one divalent group represented by the following general formula (III-2), and at least one of W⁶ and W⁷ represents the divalent group represented by the following general formula (III-2) .

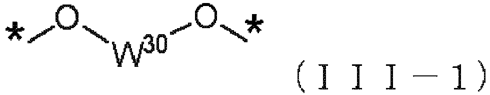

In the formula, "*" represents a bonding position; and W³⁰ represents an organic group having 1 to 4 carbon atoms.

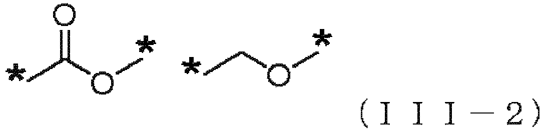

In the formula, "*" represents a bonding position.

In the general formula (I), R¹ each independently represents a hydrogen atom, a hydroxy group, or an organic group having 1 to 10 carbon atoms and optionally having a substituent.

Here, "organic group" in the present invention means a group having at least one carbon, and the group may further have hydrogen, and optionally have nitrogen, oxygen, sulfur, silicon, a halogen atom, etc.

There may be single kind of R¹ or a plurality kinds of R¹. More specific examples of R¹ include a hydrogen atom, a hydroxy group, a methyl group, an ethyl group, a vinyl group, a 2,2,2-trifluoroethyl group, a propyl group, an isopropyl group, an allyl group, a butyl group, a s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, a s-butoxy group, a t-butoxy group, a norbornyl group, an adamantyl group, a phenyl group, a tolyl group, a xylyl group, a naphthyl group, a benzyl group, a 2-furanyl group, and a 2-tetrahydrofuranyl group. Among these, a hydrogen atom is more preferable.

W¹ represents a phenylene group or a divalent group represented by the general formula (I-1). Each of W² and W³ represents a single bond or any one divalent group represented by the general formula (I-2). "m¹" represents an integer of 1 to 10, and "n¹" each independently represents an integer of 0 to 5.

Each of R¹⁰, R¹¹, R¹², and R¹³ represents a hydrogen atom, a hydroxy group, or an organic group having 1 to 10 carbon atoms. More specific examples thereof include a hydrogen atom, a hydroxy group, a methyl group, an ethyl group, a vinyl group, a 2,2,2-trifluoroethyl group, a propyl group, an isopropyl group, an allyl group, a butyl group, a s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, a s-butoxy group, a t-butoxy group, a norbornyl group, an adamantyl group, a phenyl group, a tolyl group, a xylyl group, a naphthyl group, a benzyl group, a 2-furanyl group, and a 2-tetrahydrofuranyl group. Among these, a hydrogen atom and a methyl group are more preferable, and a hydrogen atom is more preferable.

W¹⁰ and W¹¹ each independently represent a single bond or a carbonyl group. Each of "m¹⁰" and "m¹¹" represents an integer of 0 to 10, and m¹⁰ + m¹¹ > 1.

There may be a single kind of R² or a plurality of types of R². More specific examples of R² include a hydrogen atom, a methyl group, an ethyl group, a vinyl group, a 2,2,2-trifluoroethyl group, a propyl group, an isopropyl group, an allyl group, a butyl group, a s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, a s-butoxy group, a t-butoxy group, a norbornyl group, an adamantyl group, a phenyl group, a tolyl group, a xylyl group, a naphthyl group, a benzyl group, a 2-furanyl group, and a 2-tetrahydrofuranyl group. Among these, a hydrogen atom is more preferable.

W⁴ represents a divalent group represented by the general formula (II-1). W⁵ represents a single bond or any one divalent group represented by the general formula (II-2). "m²" represents an integer of 2 to 10, and "n³" represents an integer of 0 to 5.

More specific examples of each of R²⁰, R²¹, R²², and R²³ include a hydrogen atom, a hydroxy group, a methyl group, an ethyl group, a vinyl group, a 2,2,2-trifluoroethyl group, a propyl group, an isopropyl group, an allyl group, a butyl group, a s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, a s-butoxy group, a t-butoxy group, a norbornyl group, an adamantyl group, a phenyl group, a tolyl group, a xylyl group, a naphthyl group, a benzyl group, a 2-furanyl group, and a 2-tetrahydrofuranyl group. Among these, a hydrogen atom and a methyl group are more preferable, and a hydrogen atom is more preferable.

Each of "m²⁰" and "m²¹" represents an integer of 0 to 10, and m²⁰ + m²¹ ≥ 1.

Each of R³ and R⁴ represents a hydrogen atom, a hydroxy group, or an organic group having 1 to 10 carbon atoms and optionally having a substituent. More specific examples thereof include a hydrogen atom, a hydroxy group, a methyl group, an ethyl group, a vinyl group, a 2,2,2-trifluoroethyl group, a propyl group, an isopropyl group, an allyl group, a butyl group, a s-butyl group, a t-butyl group, an isobutyl group, a pentyl group, a cyclopentyl group, a hexyl group, a cyclohexyl group, a cyclohexenyl group, a decyl group, a methoxy group, an ethoxy group, a propoxy group, an isopropoxy group, a butoxy group, a s-butoxy group, a t-butyl group, a butoxy group, a norbornyl group, an adamantyl group, a phenyl group, a tolyl group, a xylyl group, a naphthyl group, a benzyl group, a 2-furanyl group, and a 2-tetrahydrofuranyl group. Among these, a hydrogen atom is more preferable.

R⁶ represents an organic group having 1 to 10 carbon atoms. R⁵ represents an organic group having 1 to 10 carbon atoms, the group having any one of an aromatic ring or the divalent group represented by the general formula (III-1). Examples of the organic group having 1 to 10 carbon atoms include the groups exemplified as R³ and R⁴.

Each of W⁶ and W⁷ represents a single bond or any one divalent group represented by the general formula (III-2). At least one of W⁶ and W⁷ represents any one divalent group represented by the general formula (III-2) .

W³⁰ represents an organic group having 1 to 4 carbon atoms. More specific examples thereof include a methylene group, an ethylene group, a propylene group, a butylene group, a trimethylene group, and a tetramethylene group. Among these, an ethylene group is more preferable.

More specific examples of the compound represented by the general formula (I) include the following compounds, but the compound is not limited thereto.

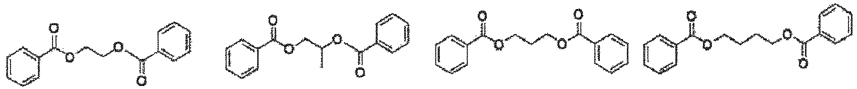

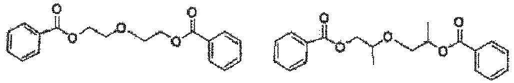

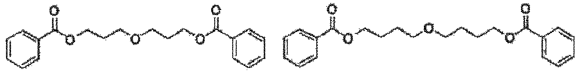

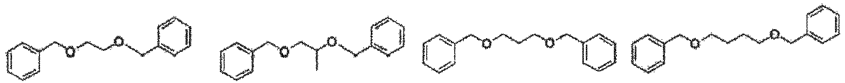

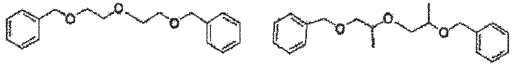

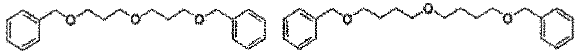

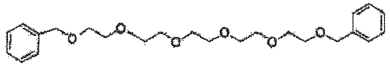

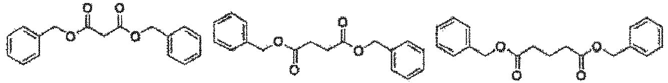

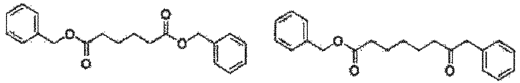

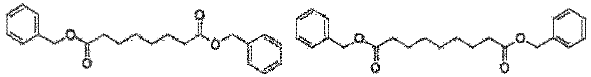

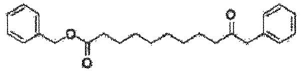

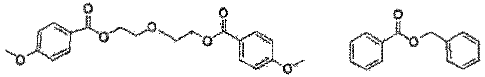

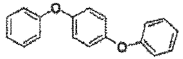

More specific examples of the compound represented by the general formula (II) include the following compounds, but the compound is not limited thereto.

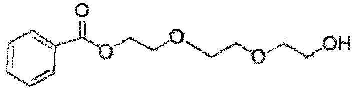

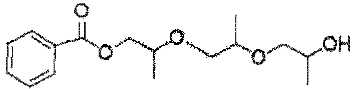

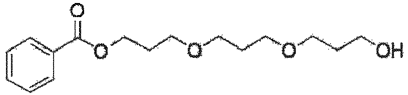

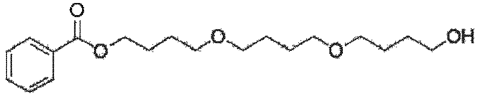

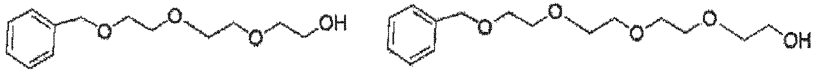

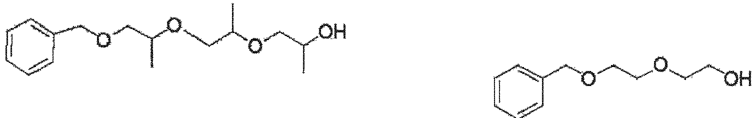

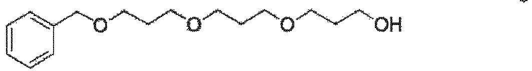

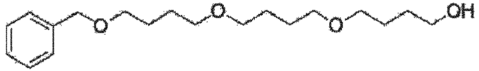

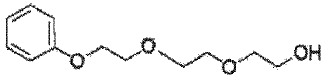

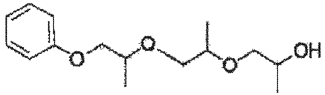

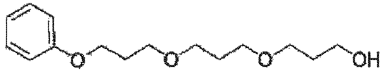

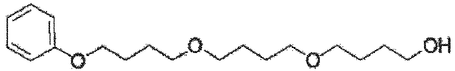

More specific examples of the compound represented by the general formula (III) include the following compounds, but the compound is not limited thereto.

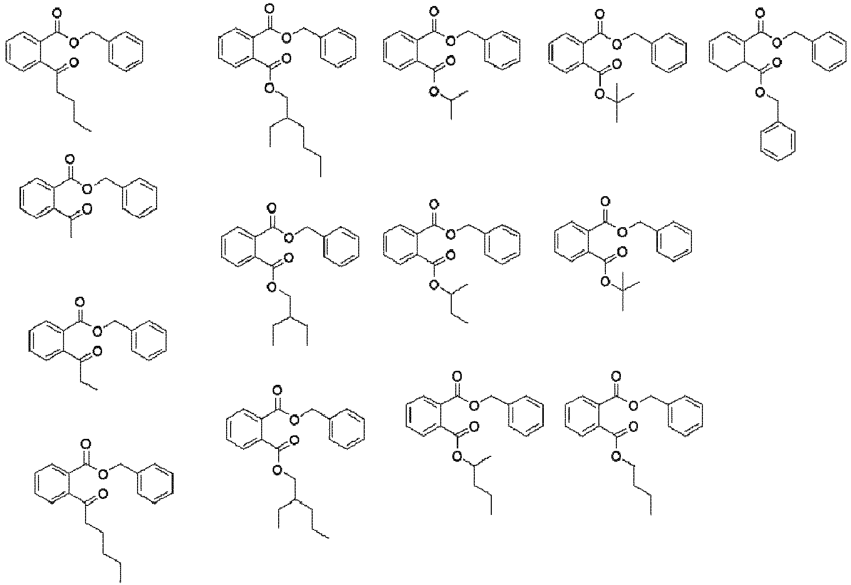

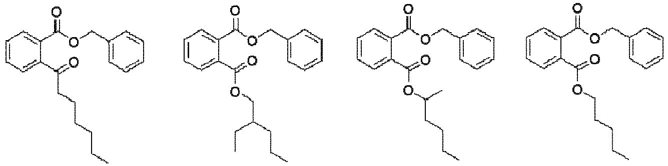

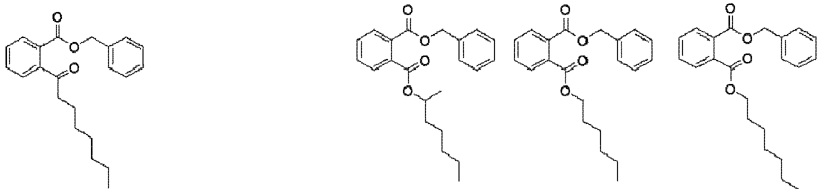

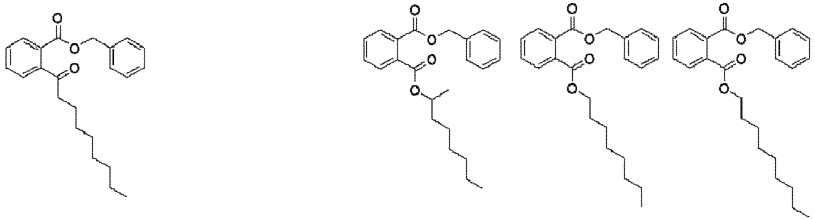

With collectively considering the improvement of the dispersion stability of the metal oxide nanoparticle in the composition for forming a metal oxide film, the film formability, the filling/planarizing property for a substrate, etc., the dispersion stabilizer (C) used in the inventive composition for forming a metal oxide film is preferably aromatic group-containing compounds having a benzyl group or a benzoyl group, and particularly preferably aromatic group-containing compounds as follows.
(i) (Poly)ethylene glycol dibenzoate
(ii) (Poly)ethylene glycol dibenzyl ether
(iii) (Poly)propylene glycol dibenzyl ether
(iv) (Poly)butylene glycol dibenzyl ether
(v) Dibenzyl linear aliphatic dicarboxylate
(vi) (Poly)ethylene glycol monobenzyl ether
(vii) (Poly)phenyl ether

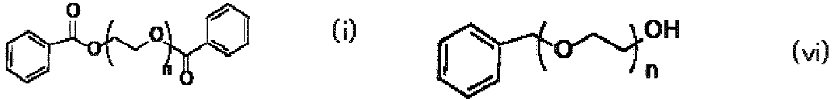

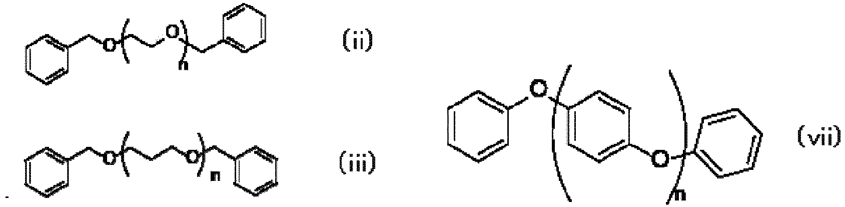

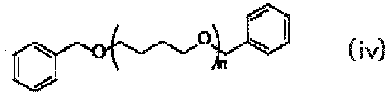

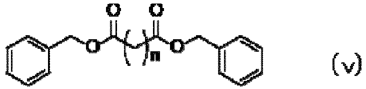

In the formulae (i) to (vii), "n" represents an integer so that the molecular weight is within a range of 500 or less, and is applied only in these formulae.

The dispersion stabilizer (C) used in the inventive composition for forming a metal oxide film has a structure having both of a hydrophobic moiety composed of the aromatic ring and a hydrophilic moiety composed of a structure having O, such as the structure (C-1). Thus, the metal oxide nanoparticle has excellent dispersion stability even when the inventive composition contains the resin for the flowability accelerator at a high concentration required for thick film formation. Therefore, the present invention can provide the composition for forming a metal oxide film having good storage stability.

A blending amount of the dispersion stabilizer (C) is preferably 0.1 to 50 parts by mass, more preferably 0.5 to 30 parts by mass, and further preferably 1 to 10 parts by mass, relative to 100 parts by mass of the metal oxide nanoparticle. A blending amount of the dispersion stabilizer of 0.1 mass% or more sufficiently yields the effects of improving the flowability of the composition for forming a metal oxide film and stabilizing the dispersibility of the metal oxide nanoparticle. When the content of the dispersion stabilizer relative to the metal nanoparticle is sufficiently high, the effects of stabilizing the dispersibility of the nanoparticle and improving the thermal flowability of the metal oxide film are sufficiently improved. On the other hand, when the content of the dispersion stabilizer is not excessively high, there is no risk of undesired effect on the film formability of the obtained coating film and the dry etching resistance.

For the inventive dispersion stabilizer, single kind of the aromatic group-containing compound can be used, the combination of two or more kinds thereof can be used.

### <(D) Organic Solvent>

The organic solvent (D) usable for the inventive composition for forming a metal oxide film is not particularly limited as long as the solvent can disperse the metal oxide nanoparticle (A), and dissolves the flowability accelerator (B), the dispersion stabilizer (C), and if contained, a crosslinker, a surfactant, an acid generator, and other additives, described later. Specifically, solvents having a boiling point of lower than 180°C, such as solvents described in paragraphs [0091] to [0092] of JP 2007-199653 A, can be used. Among these, propylene glycol monomethyl ether acetate, propylene glycol monomethyl ether, 2-heptanone, cyclopentanone, cyclohexanone, and a mixture of two or more kinds thereof are preferably used. A blending amount of the organic solvent is preferably 50 to 1,000 parts, more preferably 70 to 900 parts, and further preferably 100 to 850 parts, relative to 100 parts of the flowability accelerator (B).

Such a composition for forming a metal oxide film can favorably disperse the metal oxide nanoparticle (A), and can be applied by spin-coating. Thus, the metal oxide film having both of the dry etching resistance and high filling/planarizing property can be formed.

### <Other Components>

### [Crosslinker]

In the inventive composition for forming a metal oxide film, a crosslinker can be added to improve the curability and to further inhibit intermixing with the upper layer film. The crosslinker is not particularly limited, and known various types of crosslinkers can be widely used. Examples of the crosslinker include a polynuclear phenol methylol-based or alkoxymethyl-based crosslinker (polynuclear phenol-based crosslinker), a melamine-based crosslinker, a glycoluril-based crosslinker, a benzoguanamine-based crosslinker, a urea-based crosslinker, a β-hydroxyalkylamide-based crosslinker, an isocyanurate-based crosslinker, an aziridine-based crosslinker, an oxazoline-based crosslinker, or an epoxy-based crosslinker. When the crosslinker is added, the amount thereof is preferably 1 to 100 parts, and more preferably 5 to 50 parts, relative to the flowability accelerator (B).

Specific examples of the melamine-based crosslinker include hexamethoxymethylated melamine, hexabutoxymethylated melamine, alkoxy- and/or hydroxy-substituted derivatives thereof, and partially self-condensed products thereof.

Specific examples of the glycoluril-based crosslinker include tetramethoxymethylated glycoluril, tetrabutoxymethylated glycoluril, alkoxy- and/or hydroxy-substituted derivatives thereof, and partially self-condensed products thereof.

Specific examples of the benzoguanamine-based crosslinker include tetramethoxymethylated benzoguanamine, tetrabutoxymethylated benzoguanamine, alkoxy- and/or hydroxy-substituted derivatives thereof, and partially self-condensed products thereof.

Specific examples of the urea-based crosslinker include dimethoxymethylated dimethoxyethylene urea, alkoxy- and/or hydroxy-substituted derivatives thereof, and partially self-condensed products thereof.

Specific examples of the β-hydroxyalkylamide-based crosslinker include N,N,N',N'-tetra(2-hydroxyethyl)adipic amide.

Specific examples of the isocyanurate-based crosslinker include triglycidylisocyanurate and triallylisocyanurate.

Specific examples of the aziridine-based crosslinker include 4,4'-bis(ethyleneiminocarbonylamino)diphenylmethane and 2,2-bishydroxymethylbutanol-tris[3-(1-azirlidinyl)propionate].

Specific examples of the oxazoline-based crosslinker include 2,2'-isopropylidinebis(4-benzyl-2-oxazoline), 2,2'-isoprolylidenebis(4-phenyl-2-oxazoline), 2,2'-methylenebis-4,5-diphenyl-2-oxazoline, 2,2'-metylenebis-4-phenyl-2-oxazoline, 2,2'-methylenebis-4-tert-butyl-2-oxazoline, 2,2'-bis(2-oxazoline), 1,3-phenylenebis(2-oxazoline), 1,4-phenylenebis(2-oxazoline), and a 2-isopropenyloxazoline copolymer.

Specific examples of the epoxy-based crosslinker include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinker include compounds represented by the following general formula (XL-1), 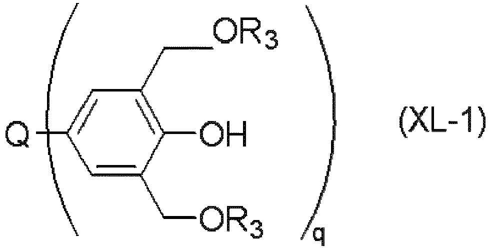 wherein Q represents a single bond or a q-valent hydrocarbon group having 1 to 20 carbon atoms; R³ represents a hydrogen atom or an alkyl group having 1 to 20 carbon atoms; and "q" represents an integer of 1 to 5.

Q represents a single bond or a q-valent hydrocarbon group having 1 to 20 carbon atoms. "q" represents an integer of 1 to 5, and more preferably 2 or 3. Specific examples of Q include groups obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or icosane. R³ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an icosanyl group. R³ is preferably a hydrogen atom or a methyl group.

Specific examples of the compound represented by the general formula (XL-1) include the following compounds. Among these, hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene are preferable from the viewpoint of improvements of the curability and the uniformity of the film thickness. R³ represents the same as above.

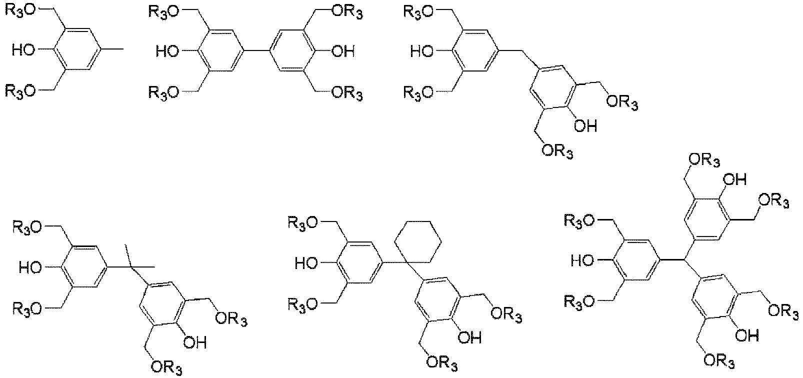

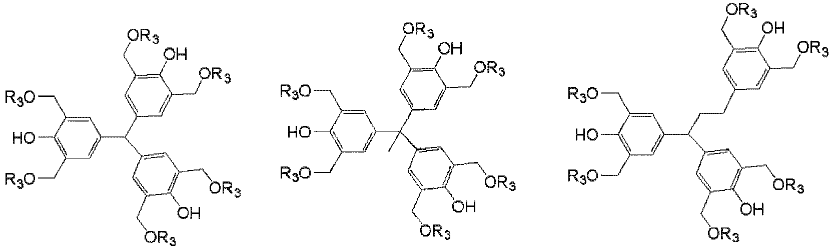

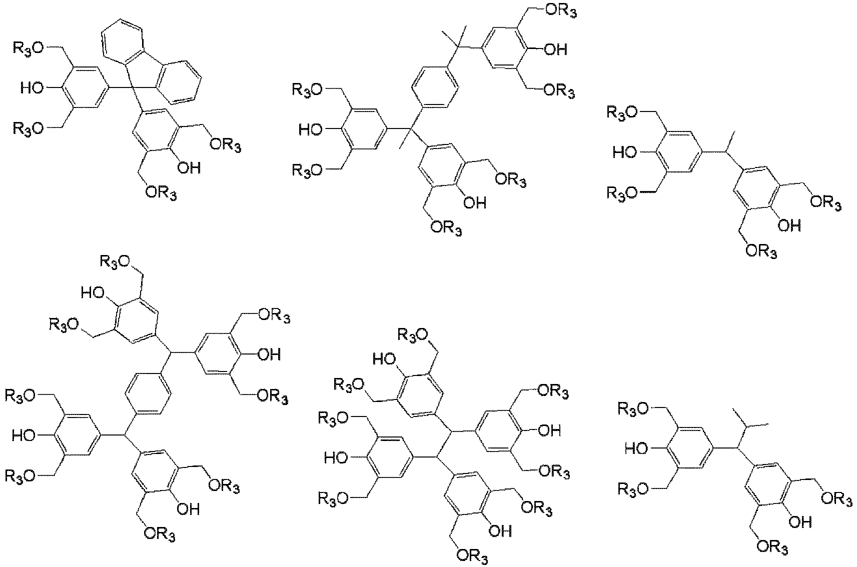

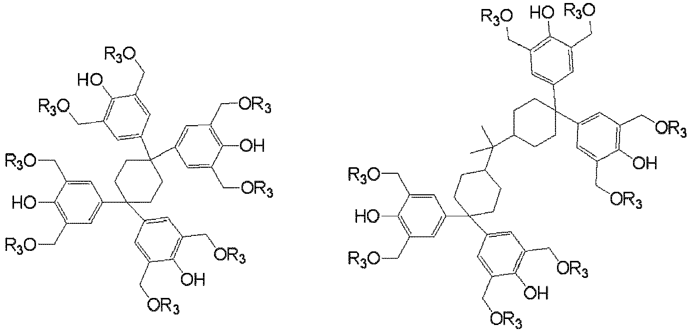

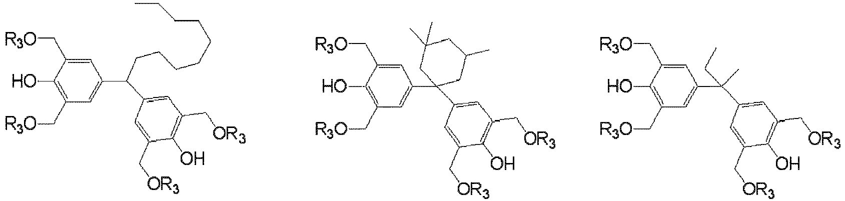

### [Surfactant]

In the inventive composition for forming a metal oxide film, a surfactant can be added to improve coatability by spin-coating. For the surfactant, surfactants described in paragraphs [0142] to [0147] of JP 2009-269953 A can be used, for example. When the surfactant is added, the addition amount is preferably 0.01 to 10 parts, and more preferably 0.05 to 5 parts, relative to 100 parts by mass of the flowability accelerator (B).

### [Acid Generator]

In the inventive composition for forming a metal oxide film, an acid generator can be added to further accelerate the curing reaction. The acid generator includes a material to generate an acid by pyrolysis and a material to generate an acid by light irradiation, and any of them can be added. Specifically, materials described in paragraphs [0061] to [0085] of JP 2007-199653 A can be added, but the acid generator is not limited thereto.

Single kind of the acid generator can be used, or the combination of two or more kinds thereof may be used. When the acid generator is added, the addition amount is preferably 0.05 to 50 parts, and more preferably 0.1 to 10 parts, relative to 100 parts by mass of flowability accelerator (B).

### [Plasticizer]

In the inventive composition for forming a metal oxide film, a plasticizer can be added to further improve the planarizing/filling property. The plasticizer is not particularly limited, and known various types of plasticizers can be widely used. Examples of the plasticizer includes: low molecular-weight compounds such as phthalate esters, adipate esters, phosphate esters, trimellitate esters, and citrate esters; and polymers such as polyether polymers, polyester polymers, and polyacetal polymers described in JP 2013-253227 A. When the plasticizer is used, the addition amount is preferably 1 to 100 parts, and more preferably 5 to 30 parts, relative to 100 parts by mass of the flowability accelerator (B).

In the inventive composition for forming a metal oxide film, preferably used as additives for imparting the filling/planarizing property similar to the plasticizer are: liquid additives having a polyethylene glycol structure or a polypropylene glycol structure; or a pyrolytic polymer having a weight reduction rate of 40 mass% or more on a temperature change from 30°C to 250°C, and having a weight-average molecular weight of 300 to 200,000, for example. This pyrolytic polymer preferably has a repeating unit having an acetal structure represented by the following general formula (DP1) or (DP1a).

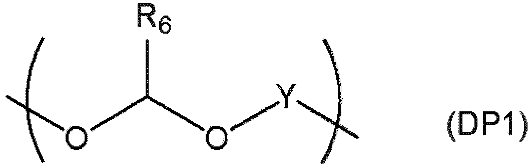

In the formula, R⁶ represents a hydrogen atom or a saturated or unsaturated monovalent organic group having 1 to 30 carbon atoms and optionally having a substituent. Y represents a saturated or unsaturated divalent organic group having 2 to 30 carbon atoms.

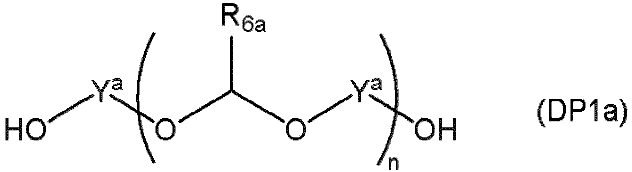

In the formula, R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average number of the repeating units, and is 3 to 500.

### [Dispersant]

In the inventive composition for forming a metal oxide film, a common dispersant can be added in addition to the dispersion stabilizer (C). A type of the used dispersant is not particularly limited, and known dispersants can be used. Examples thereof include: low molecular-weight dispersants, such as an alkylamine, an alkanethiol, an alkanediol and a phosphate ester; polymer dispersants having each functional group; and silane coupling agents. Examples of the polymer dispersant include styrene-based resins (such as a styrene-(meth)acrylic acid copolymer and a styrenemaleic anhydride copolymer), acrylic resins (such as (meth)acrylic acid resins such as a methyl (meth)acrylate-(meth)acrylic acid copolymer and a poly(meth)acrylic acid), water-soluble urethane resins, water-soluble acrylic urethane resins, water-soluble epoxy resins, water-soluble polyester resins, cellulose derivatives (such as: nitrocellulose; cellulose ethers such as alkylcelluloses such as ethylcellulose; alkyl-hydroxyalkylcelluloses such as ethylhydroxyethylcellulose; hydroxyalkylcelluloses such as hydroxyethylcellulose and hydroxypropylcellulose; and carboxyalkylcelluloses such as carboxymethylcellulose), polyvinyl alcohol, polyalkylene glycols (such as liquid polyethylene glycol and polypropylene glycol), natural polymers (such as saccharides such as gelatin, casein, dextrin, and gum arabic), polyethylenesulfonic acid or a salt thereof, polystyrenesulfonic acid or a salt thereof, a formalin condensed product of naphthalenesulfonic acid, and nitrogen atom-containing polymer compounds [for example, polymer compounds having an amino group, such as polyalkylene imines (such as polyethylene imine), polyvinylpyrrolidone, polyallylamine, and polyether polyamines (such as polyoxyethylene polyamine). A blending amount of the dispersant is preferably 0.1 to 50 parts by mass, more preferably 0.5 to 30 parts by mass, and further preferably 1 to 10 parts by mass, relative to 100 parts by mass of the metal oxide nanoparticle.

By adding the dispersant in addition to the dispersion stabilizer (C), the aggregation preventing property of the metal nanoparticle can be further improved.

Single kind of the inventive composition for forming a metal oxide film can be used, or the combination of two or more kinds thereof can be used. The composition for forming a metal oxide film can be used for the metal oxide film material or the planarizing material for semiconductor apparatus manufacturing.

As noted above, since containing the flowability accelerator (B) having excellent cracking resistance, the inventive composition for forming a metal oxide film can form a thick film having excellent dry-etching resistance derived from the metal oxide nanoparticle (A). In addition, since containing the dispersion stabilizer (C) that can further improve the thermal flowability of the resin for the flowability accelerator, the inventive composition can provide a resist underlayer film material that can achieve the filling of a high aspect-ratio pattern substrate without a void, the filling being not able to be achieved by the metal oxide nanoparticle alone. Furthermore, the composition for forming a metal oxide film can be provided which can keep the good dispersion state of the nanoparticles even in a chemical liquid containing the resin at high concentration composition of 9 mass% or more by containing the dispersion stabilizer having the specific structure, and thereby the composition can exhibit an excellent storage stability.

### (Patterning Process)

The present invention also provides, as a patterning process with the two-layer resist process using such a composition for forming a metal oxide film, a patterning process for forming a pattern on a substrate to be processed, including steps of:
(I-1) applying the composition for forming a metal oxide film according to claim 1 onto a substrate to be processed, and then heat-treating the composition to form a metal oxide film;
(I-2) forming a resist upper layer film on the metal oxide film by using a photoresist material;
(I-3) subjecting the resist upper layer film to pattern exposure, and then to development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern on the substrate to be processed.

Since the resist upper layer film in the above two-layer resist process exhibits the etching resistance against a chlorine-based gas, the dry etching of the metal oxide film while using the resist upper layer film as a mask in the above two-layer resist process is preferably performed by using an etching gas mainly composed of the chlorine-based gas.

The present invention also provides, as a patterning process with the three-layer resist process using such a composition for forming a metal oxide film, a patterning process for forming a pattern on a substrate to be processed, including steps of:
(II-1) applying the composition for forming a metal oxide film according to claim 1 onto a substrate to be processed, and then heat-treating the composition to form a metal oxide film;
(II-2) forming a silicon-containing resist middle layer film on the metal oxide film by using a silicon-containing resist middle layer film material;
(II-3) forming a resist upper layer film on the silicon-containing resist middle layer film by using a photoresist material;
(II-4) subjecting the resist upper layer film to pattern exposure, and then to development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal oxide film by dry etching while using the silicon-containing resist middle layer film having the transferred pattern as a mask; and
(II-7) processing the substrate to be processed while using the metal oxide film having the formed pattern as a mask to form the pattern on the substrate to be processed.

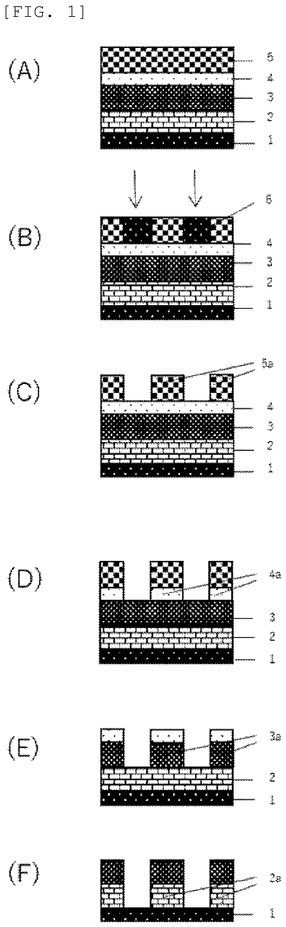

An example of the three-layer resist process will be specifically shown as follows by using FIG. 1. In a case of the three-layer resist process, as illustrated in FIG. 1(A), by using the inventive material for forming a metal oxide film, a metal oxide film (metal-containing resist underlayer film) 3 is formed on a layer 2 to be processed stacked on a substrate 1 to be processed, then a silicon atom-containing resist middle layer film 4 is formed, and a resist upper layer film 5 is formed thereon.

Then, as illustrated in FIG. 1(B), a target portion (exposure portion) 6 in the resist upper layer film 5 is exposed, and PEB and development are performed to form a resist upper layer film pattern 5a (FIG. 1(C)). While using this obtained resist upper layer film pattern 5a as a mask, the silicon atom-containing resist middle layer film 4 is processed by dry etching using a CF-based gas to form a silicon atom-containing resist middle layer film pattern 4a (FIG. 1(D)). After the resist upper layer film pattern 5a is removed, while using this obtained silicon atom-containing resist middle layer film pattern 4a is used as a mask, the metal oxide film 3 is etched by chlorine-based gas plasma to form a metal oxide film pattern (metal-containing resist underlayer film pattern) 3a (FIG. 1(E)). After the silicon atom-containing resist middle layer film pattern 4a is removed, while using the metal oxide film pattern 3a is used as a mask, the layer 2 to be processed is processed by etching to form a pattern 2a to be formed on the layer to be processed (FIG. 1(F)).

Since the silicon-containing resist middle layer film of the above three-layer resist process has etching resistance against an chlorine-based gas, the dry etching of the metal oxide film while using the silicon-containing resist middle layer film as a mask is preferably performed by using an etching gas mainly composed of the chlorine-based gas in the above three-layer resist process.

For the silicon-containing resist middle layer film in the above three-layer resist process, a polysiloxane-based middle layer film is also preferably used. By imparting an anti-reflective effect to the silicon-containing resist middle layer film, reflection can be inhibited. In particular, by using a material for 193-nm exposure containing a large amount of aromatic groups and having high etching selectivity to the substrate as the organic film, the k-value is increased, and reflection on the substrate is increased. However, the silicon-containing resist middle layer film having the absorption so as to have an appropriate k-value can inhibit the reflection, resulting in the substrate reflection of 0.5% or less. Preferably used for the silicon-containing resist middle layer film having the anti-reflective effect is anthracene for 248-nm or 157-nm exposure, and, for 193-nm exposure, a polysiloxane which have a light absorption group having a phenyl group or silicon-silicon bond at the pendant structure and is crosslinkable with an acid or heat. The polysiloxane has a light absorption group having a phenyl group or silicon-silicon bond at the pendant structure.

In addition, the present invention provides, as a patterning process with the four-layer resist process using such a composition for forming a metal oxide film, a patterning process including steps of: forming a metal oxide film on a substrate to be processed using the above composition for forming a metal oxide film; forming a silicon-containing resist middle layer film on the resist underlayer film using a silicon-containing resist middle layer film material; forming an organic anti-reflective film (BARC) or an adhesive film on the silicon-containing resist middle layer film; forming a resist upper layer film on the BARC using a photoresist material; subjecting the resist upper layer film to pattern exposure, and then to development with a developer to form a pattern in the resist upper layer film; transferring the pattern to the BARC or the adhesive film, and the silicon-containing resist middle layer film by dry etching while using the resist upper layer film having the formed pattern as a mask; transferring the pattern to the metal oxide film by dry etching while using the silicon-containing resist middle layer film having the transferred pattern as a mask; and processing the substrate to be processed while using the metal oxide film having the formed pattern as a mask to form the pattern on the substrate to be processed.

An inorganic hard mask may be formed instead of the silicon-containing resist middle layer film. In this case, a semiconductor apparatus circuit pattern can be formed on a substrate by at least: forming a metal oxide film on a body to be processed using the inventive composition for forming a metal oxide film; forming an inorganic hard mask selected from a silicon oxide film, a silicon nitride film, and a silicon oxynitride film on the metal oxide film; forming a resist upper layer film on the inorganic hard mask using a photoresist composition; forming a circuit pattern in the resist upper layer film; etching the inorganic hard mask while using the resist upper layer film having the formed pattern as a mask; etching the metal oxide film while using the inorganic hard mask having the formed pattern as a mask; and further etching the body to be processed while using the metal oxide film having the formed pattern as a mask to form a pattern on the body to be processed.

The present invention also provides a patterning process for forming a pattern on a substrate to be processed, comprising steps of:
(III-1) applying the composition for forming a metal oxide film according to claim 1 onto a substrate to be processed, and then heat-treating the composition to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure, and then to development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern on the substrate to be processed.

In this case, the inorganic hard mask is preferably formed by a CVD method or an ALD method.

By forming the inorganic hard mask by a CVD method or an ALD method, a fine pattern on a body to be processed can be formed with higher precision.

As noted above, when the inorganic hard mask is formed on the metal oxide film, a silicon oxide film, a silicon nitride film, and a silicon oxynitride film (SiON film) can be formed by a CVD method, an ALD method, etc. The method for forming the silicon nitride film are described in, for example, JP 2002-334869 A, WO 2004/066377, etc. A film thickness of the inorganic hard mask is preferably 5 to 200 nm, and more preferably 10 to 100 nm. As the inorganic hard mask, the SiON film, which is highly effective as the anti-reflective film, is most preferably used. Since the substrate temperature during the SiON film formation reaches 300 to 500°C, the metal oxide film is required to withstand the temperature of 300 to 500°C. The composition for forming a metal oxide film used in the present invention has high heat resistance and can resist the high temperature of 300°C to 500°C, and thereby the inorganic hard mask formed by the CVD method or the ALD method and the metal oxide film formed by spin-coating method can be combined.

Although the photoresist film may be formed as the resist upper layer film on the inorganic hard mask, as noted above, an organic anti-reflective film (BARC) or an adhesive film may be formed on the inorganic hard mask by spin-coating, and the photoresist film may be formed thereon. In particular, when the SiON film is used as the inorganic hard mask, the reflection can be inhibited by the two anti-reflective films of the SiON film and the BARC even with the immersion exposure having high NA of more than 1.0. Another merit of forming the BARC is an effect of reducing bottom footing of the photoresist pattern just on the SiON film.

The resist upper layer film in the above multilayer resist process may be any of positive-type or negative-type, and a material same as commonly used photoresist compositions can be used. After the photoresist composition is applied by spin-coating, the prebaking is performed. The prebaking is preferably performed within a range at 60 to 180°C for 10 to 300 seconds. Thereafter, the exposure, then post exposure bake (PEB), and development are performed in accordance with a common method to obtain the resist pattern. A thickness of the resist upper layer film is not particularly limited, and preferably 30 to 500 nm, particularly preferably 50 to 400 nm.

Examples of the exposure light include high-energy ray having a wavelength of 300 nm or less, and specifically, excimer laser with 248 nm, 193 nm, or 157 nm, soft X-ray with 3 to 20 nm, electron beam, and X-ray.

When the circuit pattern is formed in the resist upper layer film by using the above method, a fine pattern can be formed on the body to be processed with higher precision.

The pattern in the resist upper layer film is preferably formed by photolithography with a wavelength of 5 nm or more and 300 nm or less, direct writing with electron beam, nanoimprinting, or a combination thereof.

The development in the patterning process is preferably alkali development or development with an organic solvent. Specifically, in the patterning process, it is preferable that the exposure and development are performed to form the circuit pattern in the resist upper layer film, and the development is alkali development or development with an organic solvent.

Using the alkali development or the development with an organic solvent can form a fine pattern on the body to be processed with higher precision.

Then, etching is performed while using the obtained resist pattern as a mask. The etching of the silicon-containing resist middle layer film or the inorganic hard mask in the three-layer resist process is performed by using a fluorocarbon-based gas while using the upper layer resist pattern as a mask. This etching forms the silicon-containing resist middle layer film pattern or the inorganic hard mask pattern.

Subsequently, while using the obtained silicon-containing resist middle layer film pattern or the inorganic hard mask pattern as a mask, the metal oxide film is processed by etching. The etching process of the metal oxide film is preferably performed by using a chlorine-based gas.

The subsequent etching of the body to be processed can be performed in accordance with a common method. For example, when the body to be processed is a SiO₂-based, SiN-based, or silica-based low dielectric-constant insulative film, the etching is performed by using a gas mainly composed of a fluorocarbon-based gas. When the substrate is etched with the fluorocarbon-based gas, the silicon-containing resist middle layer film pattern in the three-layer resist process is simultaneously removed with the substrate processing.

The metal oxide film obtained with the inventive composition for forming a metal oxide film has a feature of excellent etching resistance during the etching of the body to be processed.

The body to be processed (substrate to be processed) is not particularly limited, and a substrate such as Si, α-Si, p-Si, SiO₂, SiN, SiON, W, TiN, and Al; and a substrate in which a layer to be processed is formed on the above substrate are used. As the layer to be processed, various low-k films such as Si, SiO₂, SiON, SiN, p-Si, α-Si, W, W-Si, Al, Cu, and Al-Si, and stopper films thereof are used. The layer to be processed can be formed to have a thickness of typically 50 to 10,000 nm, particularly 100 to 5,000 nm. When the layer to be processed is formed, the substrate and the layer to be processed having different materials are used.

The body to be processed is preferably a semiconductor apparatus substrate or a substrate having a film formed on the semiconductor apparatus substrate, the film being any of a metal film, a metal carbide film, a metal oxide film, a metal nitride film, a metal oxycarbide film, and a metal oxynitride film. More specifically, used are: a substrate such as Si, α-Si, p-Si, SiO₂, SiN, SiON, W, TiN, and Al; and a substrate on which the above metal film, etc. are formed as a layer to be processed, but the body to be processed is not particularly limited.

As the layer to be processed, various low-k films such as Si, SiO₂, SiON, SiN, p-Si, α-Si, W, W-Si, Al, Cu, and Al-Si, and stopper films thereof are used. The layer to be processed can be formed to have a thickness of typically 50 to 10,000 nm, particularly 100 to 5,000 nm. When the layer to be processed is formed, the substrate and the layer to be processed each having materials different from each other are used.

Should be noted that a metal constituting the body to be processed is preferably silicon, titanium, tungsten, hafnium, zirconium, chromium, germanium, copper, silver, gold, aluminum, indium, gallium, arsenic, palladium, iron, tantalum, iridium, cobalt, manganese, molybdenum, ruthenium, or an alloy thereof.

These materials can be used as the metal. As noted above, pattern formation using the inventive composition for forming an organic film can transfer and form a pattern of the upper layer photoresist to the body to be processed with high precision.

In the inventive patterning process, a substrate to be processed having a structure or step with an aspect ratio of 5 or more is preferably used. As noted above, the inventive composition for forming a metal oxide film has excellent filling/planarizing property, and thereby the substrate to be processed can be filled to form a plane cured film without a void even in the presence of a structure or step (unevenness) with an aspect ratio 5 or more on the substrate to be processed. The aspect ratio of the structure or step on the substrate to be processed is preferably 5 or more, and more preferably 10 or more. When in the method for processing the substrate to be processed having a structure or step with the aspect ratio, a film of the inventive composition for forming a metal oxide film is formed to perform fill/planarize, the film thickness of the resist middle layer film and the resist upper layer film formed thereafter can be uniformed. Thus, taking the exposure depth margin (DOF) in the photolithography is easily achieved, which is extremely preferable.

The present invention also provides, as a tone-reversed patterning process using such a composition for forming a metal oxide film, patterning process for forming a pattern on a substrate to be processed, including steps of:
(IV-1) forming a resist underlayer film on a substrate to be processed;
(IV-2) forming: a resist middle layer film; or a combination of an inorganic hard mask middle layer film and an organic thin film on the resist underlayer film, the inorganic hard mask middle layer film being selected from a silicon oxide film, a silicon nitride film, and a silicon oxynitride film;
(IV-3) forming a resist upper layer film on the resist middle layer film or on the combination of the inorganic hard mask middle layer film and the organic thin film by using a photoresist material;
(IV-4) subjecting the resist upper layer film to pattern exposure, and then to development with a developer to form a pattern in the resist upper layer film;
(IV-5) transferring the pattern to the resist middle layer film or to the organic thin film and the inorganic hard mask middle layer film by dry etching while using the resist upper layer film having the formed pattern as a mask;
(IV-6) transferring the pattern to the resist underlayer film by dry etching while using the resist middle layer film or the inorganic hard mask middle layer film having the transferred pattern as a mask;
(IV-7) applying the composition for forming a metal oxide film according to claim 1 onto the resist underlayer film having the formed pattern, heat-treating the composition to cover the metal oxide film and fill a gap of the resist underlayer film pattern with the metal oxide film;
(IV-8) etching back the metal oxide film covering the resist underlayer film having the formed pattern by a chemical stripper or dry etching, the metal oxide film so as to have an uncovered upper surface of the resist underlayer film having the formed pattern;
(IV-9) removing the resist middle layer film or the inorganic hard mask middle layer film remained on the upper surface of the resist underlayer film by dry etching;
(IV-10) removing the resist underlayer film having the uncovered surface and the formed pattern by dry etching to form a reversed pattern to the original pattern on the metal oxide film; and
(IV-11) processing the substrate to be processed while using the metal oxide film having the formed reversed pattern as a mask to form a tone-reversed pattern on the substrate to be processed.

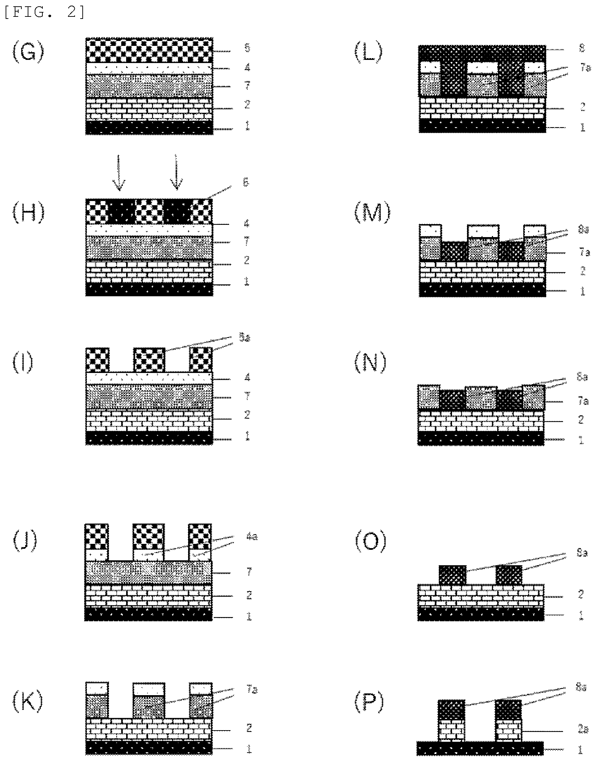

An example of forming the tone-reversed pattern is specifically described as follows by using FIG. 2. As illustrated in FIG. 2(G), a resist underlayer film 7 composed of an coating-type organic underlayer film material is formed on a layer 2 to be processed stacked on a substrate 1 to be processed, then a silicon atom-containing resist middle layer film 4 is formed, and then a resist upper layer film 5 is formed thereon.

Then, as illustrated in FIG. 2(H), a target portion (exposure portion) 6 in the resist upper layer film 5 is exposed, and PEB and development are performed to form a resist upper layer film pattern 5 (FIG. 2(I)). While using this obtained resist upper layer film pattern 5a as a mask, the silicon atom-containing resist middle layer film 4 is processed by etching using a CF-based gas to form a silicon atom-containing resist middle layer film pattern 4a (FIG. 2(J)). After the resist upper layer film pattern 5a is removed, while using this obtained silicon atom-containing resist middle layer film pattern 4a is used as a mask, the resist underlayer film 7 composed of the coating-type organic underlayer film material is subjected to etching with oxygen plasma to form a resist underlayer film pattern 7a composed of the coating-type organic underlayer film material (FIG. 2(K)).

The inventive composition for forming a metal oxide film is applied onto the resist underlayer film pattern 7a composed of the coating-type organic underlayer film material, the composition is heat-treated to cover the pattern with the metal oxide film 8, and to fill a gap of the resist underlayer film pattern 7a composed of the coating-type organic underlayer film material with the metal oxide film (FIG. 2(L)). Then, the metal oxide film 8 covering the resist underlayer film pattern 7a composed of the coating-type organic underlayer film material is etch backed by a chemical stripper or dry etching to uncover the upper surface of the resist underlayer film pattern 7a composed of the coating-type organic underlayer film material and to remain the metal oxide film pattern 8a having the reversed pattern to the resist underlayer film in the gap of the resist underlayer film pattern 7a composed of the coating-type organic underlayer film material (FIG. 2(M)). Furthermore, the silicon atom-containing resist middle layer film pattern 4a remained on the upper surface of the resist underlayer film pattern 7a composed of the coating-type organic underlayer film material is removed by dry etching (FIG. 2(N)). Then, the resist underlayer film pattern 7a composed of the coating-type organic underlayer film material is removed by dry etching to form a reversed pattern to the original pattern on the metal oxide film (the metal oxide film pattern 8a having a reversed pattern to the resist underlayer film pattern is formed) (FIG. 2(O)). Thereafter, while using the metal oxide film pattern 8a having the reversed pattern to the resist underlayer film pattern as a mask, the substrate to be processed is processed to form a tone-reversed pattern 2a on the substrate to be processed (FIG. 2(P)).

When the organic resist underlayer film is formed on the substrate to be processed as above, the organic resist underlayer film can be formed by a method using a coating-type organic underlayer film material, a CVD method, etc. Examples of the coating-type organic underlayer film material include resins and compositions described in JP 2012-1687 A, JP 2012-77295 A, JP 2004-264710 A, JP 2005-043471 A, JP 2005-250434 A, JP 2007-293294 A, JP 2008-65303 A, JP 2004-205685 A, JP 2007-171895 A, JP 2009-14816 A, JP 2007-199653 A, JP 2008-274250 A, JP 2010-122656 A, JP 2012-214720 A, JP 2014-29435 A, WO 2012/077640, WO 2010/147155, WO 2012/176767, JP 2005-128509 A, JP 2006-259249 A, JP 2006-259482 A, JP 2006-293298 A, JP 2007-316282 A, JP 2012-145897 A, JP 2017-119671 A, JP 2019-44022 A, etc. Examples of the organic resist underlayer film formed by a CVD method include an amorphous carbon film.

In the tone-reversed patterning process, the metal oxide film is preferably removed by dry etching with a chlorine-based gas to uncover the upper surface of the resist underlayer film pattern after covering the obtained resist underlayer film pattern with the composition for forming a metal oxide film. Thereafter, the resist middle layer film or hard mask middle layer film remained on the resist underlayer film is removed by dry etching with a fluorocarbon-based gas, and the resist underlayer film pattern having the uncovered surface is removed by dry etching with an oxygen-based gas to form the metal oxide film pattern.

In the tone-reversed patterning process, a substrate to be processed having a structure or step with an aspect ratio of 5 or more is preferably used. As noted above, the inventive composition for forming a metal oxide film has excellent filling/planarizing property, and thereby the filling can be performed to form a plane cured film without a void even in the presence of a structure or step (unevenness) with an aspect ratio 5 or more. The aspect ratio of the structure or step on the substrate to be processed is preferably 5 or more, and more preferably 10 or more. In the method for reversing the resist underlayer film pattern having the pattern with the above height, filling/planarizing performed by forming a film of the inventive composition for forming a metal oxide film can reverse and transfer the pattern with high precision, which is extremely preferable. Since the inventive composition has more excellent dry-etching resistance with a fluorocarbon-based gas than the resist underlayer film using a conventional coating-type organic underlayer film material, reversing the resist underlayer film pattern with the above composition for forming a metal oxide film has advantage that the desired resist pattern can be formed on a film to be processed with high precision.

In the above inventive two-layer resist patterning process, three-layer resist patterning process, four-layer resist patterning process, and tone-reversed patterning process, a pattern with an aspect ratio of 5 or more is preferably formed on the substrate to be processed. As noted above, the inventive composition for forming a metal oxide film can form a thick metal oxide film having excellent dry-etching resistance, and thereby the high aspect-ratio pattern can be transferred on the substrate to be processed with high precision. The aspect ratio of the pattern formed on the substrate to be processed while using the metal oxide film as a mask is preferably 5 or more, and more preferably 10 or more. For transferring the high aspect-ratio pattern with high precision, the hard mask is required to take expanded thick-film margin and excellent dry-etching resistance. The inventive composition for forming a metal oxide film uses the flowability accelerator having excellent cracking resistance to enable to form a thick metal oxide film with 1 um or more.

The present invention also provides a patterning process using the above composition for forming a metal oxide film as a sacrificial film, including steps of:
(V-1) applying the composition for forming a metal oxide film according to claim 1 onto a substrate to be processed having a structure or a step, then heat-treating the composition to fill a metal oxide film;
(V-2) removing the metal oxide film outside the structure or the step on the substrate to be processed by a CMP method to remove the metal oxide from a surface of the substrate to be processed;
(V-3) alternately stacking an insulative film and a conductive film on the substrate to be processed filled with the metal oxide film;
(V-4) forming an organic resist underlayer film on a stacked film of the insulative film and the conductive film formed on the substrate to be processed filled with the metal oxide film;
(V-5) forming a resist middle layer film, or an inorganic hard mask middle layer film, or a combination of the inorganic hard mask middle layer film and an organic thin film on the organic resist underlayer film, the inorganic hard mask middle layer film being selected from a silicon oxide film, a silicon nitride film, and a silicon oxynitride film;
(V-6) forming a resist upper layer film on the resist middle layer film, or on the inorganic hard mask middle layer film, or on the combination of the inorganic hard mask middle layer film and the organic thin film by using a photoresist material;
(V-7) subjecting the resist upper layer film to pattern exposure, and then development with a developer to form a pattern in the resist upper layer film;
(V-8) transferring the pattern to the resist middle layer film, or to the inorganic hard mask middle layer film, or to the organic thin film and the inorganic hard mask middle layer film by dry etching while using the resist upper layer film having the formed pattern as a mask;
(V-9) transferring the pattern to the resist underlayer film by dry etching while using the resist middle layer film or the inorganic hard mask middle layer film having the transferred pattern as a mask;
(V-10) transferring the pattern to the stacked film of the insulative film and the conductive film by dry etching while using the resist underlayer film having the transferred pattern as a mask; and
(V-11) removing the metal oxide film filled on the substrate to be processed while using the stacked film of the insulative film and the conductive film having the transferred pattern as a mask.

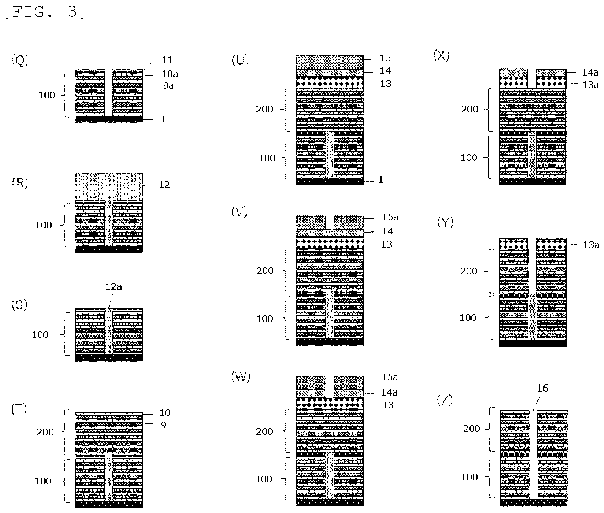

An example of the patterning process using the above composition for forming a metal oxide film as a sacrificial film is specifically described as follows by using FIG. 3. As illustrated in FIG. 3(Q), insulative film patterns 10a and conductive film patterns 9a are alternately stacked. Onto a step formed in the alternately stacked layer (underlayer) 100 of the insulative film patterns 10a and the conductive film patterns 9a, which contains an upper-lower connecting insulative film 11, the inventive composition for forming a metal oxide film is applied and then heat-treated to cover the stacked layer with the metal oxide film 12 (FIG. 3(R)). Thereafter, the metal oxide film 12 outside the step is removed by a CMP method so that the metal oxide layer 12 is removed from the surface of the substrate to be processed so as to perform planarization (FIG. 3(S)). After the CMP planarization in which the metal oxide film 12a outside the step is removed, an alternately stacked film (upper layer) 200 of the insulative film 10 and the conductive film 9 is formed (FIG. 3(T)), and an organic resist underlayer film 13 is formed on the alternately stacked layer. On the organic resist underlayer film 13, a silicon atom-containing resist middle layer film 14 (a polysiloxane-based resist middle layer film; an inorganic hard mask middle layer film selected from a silicon oxide film, a silicon nitride film, and a silicon oxynitride film; or a combination of the inorganic hard mask and an organic thin film) is formed, and a resist upper layer film 15 is formed on the resist middle layer film 14 (FIG. 3(U)).

Subsequently, the resist upper layer film 15 is exposed, and PEB and development are performed to form a resist upper layer film pattern 15a (FIG. 3(V)). While using this obtained resist upper layer film pattern 15a as a mask, the silicon atom-containing resist middle layer film 14 is processed by etching with a CF-based gas to form a silicon atom-containing resist middle layer film pattern 14a (FIG. 3(W)). After the resist upper layer film pattern 15a is removed, while using this obtained silicon atom-containing resist middle layer film 14a as a mask, the organic resist underlayer film 13 is etched with oxygen plasma to form an organic resist underlayer film pattern 13a (FIG. 3(X)). While using the resist underlayer film 13a as a mask, the alternately stacked film (upper layer) 200 of the insulative films 10 and the conductive films 9 is processed by dry etching with a CF-based gas to form a high aspect-ratio pattern (FIG. 3(Y)). Thereafter, the metal oxide film 12a obtained after the CMP planarization and filled in the step of the layer 100 to be processed is removed by dry etching using a chlorine-based gas to form a penetrated pattern 16 through the layer film 200 and through the alternately stacked film (underlayer) 100 of the insulative film patterns 10a and the conductive film patterns 9a (a through pattern 16 through the layer 100 and the layer 200 is formed) (FIG. 3(Z)).

The alternately stacked layer 100 of the insulative film patterns 10a and the conductive film patterns 9a and the alternately stacked film 200 of the insulative films 10 and the conductive films 9 are stacked on the substrate by using a stacking precursor suitable for a CVD method or an atomic layer deposition (ALD). The insulative film pattern 10a and the insulative film 10 can be formed from any appropriate (plurality of) insulative materials. Examples of the insulative material include, but not limited to, silicon oxide (for example, SiO₂). The conductive film pattern 9a and the conductive film 9 can be formed from any appropriate (plurality of) conductive materials. Examples thereof include one or more metals such as polysilicon, tungsten, nickel, titanium, platinum, aluminum, gold, tungsten nitride, tantalum nitride, titanium nitride, and silicon nitride.

As noted above, when the organic resist underlayer film 13 is formed on the alternately stacked layer 200 of the insulative film patterns 10a and the conductive film patterns 9a, the organic resist underlayer film can be formed by a method using a coating-type organic underlayer film material, a CVD method, etc. Examples of the coating-type organic underlayer film material include resins and compositions described in JP 2012-1687 A, JP 2012-77295 A, JP 2004-264710 A, JP 2005-043471 A, JP 2005-250434 A, JP 2007-293294 A, JP 2008-65303 A, JP 2004-205685 A, JP 2007-171895 A, JP 2009-14816 A, JP 2007-199653 A, JP 2008-274250 A, JP 2010-122656 A, JP 2012-214720 A, JP 2014-29435 A, WO 2012/077640, WO 2010/147155, WO 2012/176767, JP 2005-128509 A, JP 2006-259249 A, JP 2006-259482 A, JP 2006-293298 A, JP 2007-316282 A, JP 2012-145897 A, JP 2017-119671 A, JP 2019-44022 A, etc. The organic resist underlayer film may contain a metal atom of zirconium, hafnium, aluminum, tungsten, titanium, copper, tin, cerium, indium, zinc, yttrium, lanthanum, chromium, cobalt, platinum, iron, antimony, and germanium, and a combination thereof. The inventive composition for forming a metal oxide film may also be used therefor.

Examples of the organic resist underlayer film formed by a CVD method include: an amorphous carbon film; or a doped carbon film containing a metal atom of zirconium, hafnium, aluminum, tungsten, titanium, copper, tin, cerium, indium, zinc, yttrium, lanthanum, chromium, cobalt, platinum, iron, antimony, and germanium, and a combination thereof.

The step formed on the alternately stacked layer 100 of the insulative films 10a and the conductive films 9a preferably has a formed pattern with an aspect ratio of 5 or more. As noted above, the inventive composition for forming a metal oxide film has excellent filling/planarizing property, and thereby the filling can be performed to form a plane cured film without a void even in the presence of a structure or step (evenness) with an aspect ratio of 5 or more on the substrate to be processed. The aspect ratio of the structure or step on the body to be processed is preferably 5 or more, more preferably 10 or more, further preferably 20 or more, and particularly preferably 50 or more. In the method for filling the substrate to be processed having the structure or step with the above aspect ratio, filling/planarizing performed by forming a film with the inventive composition for forming a metal oxide film can uniformize the film thicknesses of the alternate layer of the insulative films and the conductive films and the film thickness of the photoresist formed on the alternate layer, which are formed thereafter. Thus, taking the exposure depth margin (DOF) in the photolithography is easily achieved, which is extremely preferable in the multi-stacking manufacturing process of 3D-NAND. In addition, since the inventive composition for forming a metal oxide film also has excellent heat resistance, the process of forming the alternate layer of the insulative films and the conductive films on the substrate to be processed filled with the metal oxide film causes no void nor peeling in the filling film, and can form a high aspect-ratio pattern with high precision.

A thickness of the organic resist underlayer film 13 is decided with considering a thickness of the alternately stacked film 200 of the insulative films 10 and the conductive films 9 of the film to be etched. The organic resist underlayer film 13 can be formed to have a thickness of, for example, 10,000 to 100,000 Å.

The resist upper layer film in the above multilayer resist process may be any of positive-type or negative-type, and a material same as commonly used photoresist compositions can be used. After the photoresist composition is applied by spin-coating, the prebaking is performed. The prebaking is preferably performed within a range at 60 to 180°C for 10 to 300 seconds. Thereafter, the exposure, then post exposure bake (PEB), and development are performed in accordance with a common method to obtain the resist pattern. A thickness of the resist upper layer film is not particularly limited, and preferably 30 to 1,000 nm, particularly preferably 50 to 500 nm.

Examples of the exposure light include high-energy ray having a wavelength of 300 nm or less, and specifically, excimer laser with 248 nm, 193 nm, or 157 nm, soft X-ray with 3 to 20 nm, electron beam, and X-ray.

When the circuit pattern is formed in the resist upper layer film by using the above method, a fine pattern can be formed on the body to be processed with higher precision.

The resist upper layer film is preferably formed by photolithography with a wavelength of 5 nm or more and 300 nm or less, direct writing with electron beam, nanoimprinting, or a combination thereof.

The development in the patterning process is preferably performed with alkali development or development with an organic solvent. Specifically, it is preferable that in the patterning process, the exposure and development are performed to form the circuit pattern in the resist upper layer film, and the development is performed with alkali development or development with an organic solvent.

Using the alkali development or the development with an organic solvent as a development method can form a fine pattern on the body to be processed with higher precision.

### (Method for Forming Metal Oxide Film)

The present invention provides a method for forming a resist underlayer film of a multilayer resist film used for lithography or forming a filling film functioning as a planarizing film (organic planarizing film) for semiconductor manufacturing, the method using the above composition for forming a metal oxide film.

Specifically, the present invention provides a method for forming a metal oxide film functioning as a planarizing film used in a semiconductor apparatus manufacturing process, the method including: applying the above composition for forming a metal oxide film onto a substrate to be processed; and heat-treating the substrate within a range of a temperature of 100°C or higher and 600°C or lower for 10 to 600 seconds to form a cured film.

The present invention also provides a method for forming a metal oxide film functioning as a planarizing film used in a semiconductor apparatus manufacturing process, the method comprising: applying the above composition for forming a metal oxide film onto a substrate to be processed; and heat-treating the substrate in an atmosphere with an oxygen concentration of 1 vol% or more and 21 vol% or less to form a cured film.

The present invention also provides a method for forming a metal oxide film functioning as a planarizing film used in a semiconductor apparatus manufacturing process, the method comprising: applying the above composition for forming a metal oxide film on a substrate to be processed; and heat-treating the substrate in an atmosphere with an oxygen concentration of less than 1 vol% to form a cured film.

Such methods can accelerate the crosslinking reaction of the composition for forming a metal oxide film during the formation of the metal oxide film without deterioration in the substrate to be processed even when the substrate to be processed contains a material unstable for heating under an oxygen atmosphere, and can highly inhibit the mixing with the upper layer film, which is useful.

In the method for forming a metal oxide film using the inventive composition for forming a metal oxide film, the above composition for forming a metal oxide film is applied onto the substrate to be processed by spin-coating method, etc. Using the spin-coating method, etc. can yield good filling property. After the spin-coating, the solvent is evaporated, and baking (heat treatment) is performed to prevent mixing with the resist upper layer film or the resist middle layer film and to accelerate the crosslinking reaction. The baking is preferably performed within a range at 100°C or higher and 600°C or lower for 10 to 600 seconds, more preferably performed within a range at 200°C or higher and 500°C or lower for 10 to 300 seconds. With considering effects on device damage and wafer deformation, an upper limit of the heating temperature in the wafer process with the lithography is preferably 600°C or lower, and more preferably 500°C or lower.

In the method for forming a metal oxide film using the inventive composition for forming a metal oxide film, the inventive composition for forming a metal oxide film is applied onto the substrate to be processed by a spin-coating method etc., similar to the above, and the metal oxide film can also be formed by baking the composition for forming a metal oxide film in an atmosphere with an oxygen concentration of 0.1 vol% or more and 21 vol% or less to cure the composition.

Baking the inventive composition for forming a metal oxide film in such an oxygen atmosphere can yield a sufficiently cured film. Although the atmosphere during the baking may be the air, sealing an inert gas such as N₂, Ar, and He to reduce oxygen is preferable for preventing oxidation of the metal oxide film. To prevent the oxidation, the oxygen concentration is required to be controlled, and is preferably 1000 ppm or less, and more preferably 100 ppm or less (on a volumetric basis). Preventing the oxidation of the metal oxide film during the baking avoids increase in the absorption and deterioration in the etching resistance, which is preferable.

### EXAMPLES

Hereinafter, the present invention will be described more specifically with showing Synthesis Examples, Examples, and Comparative Examples, but the present invention is not limited by these examples. The invention is limited by the scope of the claims. With a molecular weight and a dispersion degree, a weight-average molecular weight (Mw) and number-average molecular weight (Mn) in terms of polystyrene were determined by gel permeation chromatography (GPC) using tetrahydrofuran as an eluent to determine the dispersion degree (Mw/Mn).

Resins (B-1) to (B-6) for resist underlayer films material were synthesized by using resin raw materials (b-1) to (b-6) shown below. (B-7) and (B-8) were synthesized by using the resin (B-4). A comparative resin (R-1) was synthesized by using the resin (B-3), and a comparative resin (R-3) was synthesized by using a raw material (G-1) of the comparative resin. A comparative resin (R-4) was synthesized by using a raw material (G-2) of the comparative resin with regulating the reaction rate using modifiers (c-1) and (c-2).

### Resin raw materials:

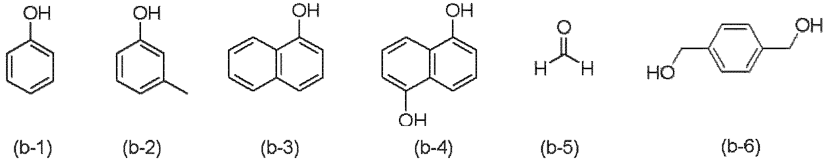

### Resins used for middle layers:

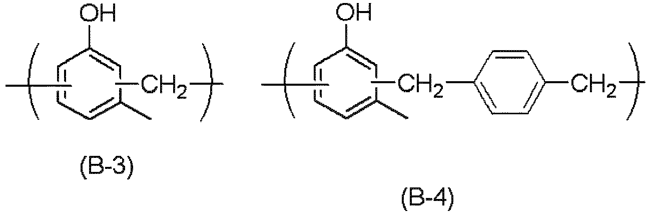

### Raw materials for comparative resin:

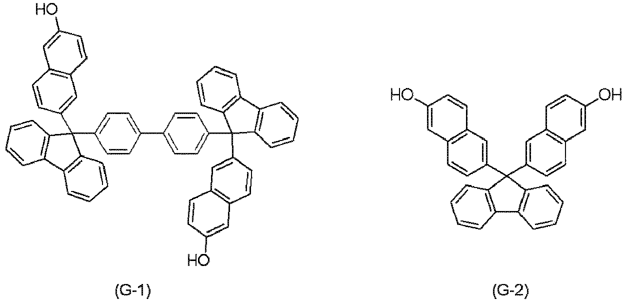

### Modifiers:

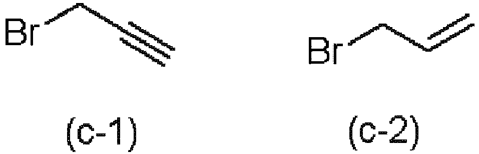

The resins (B-1) to (B-6) shown above were synthesized as follows.

### (Synthesis Example 1)

### Synthesis of Resin (B-1)

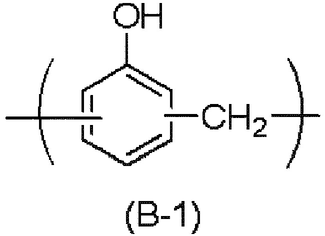

Under a nitrogen atmosphere, 188.2 g of the resin raw material (b-1), 113.6 g of the resin raw material (b-5), 9.0 g of oxalic acid, and 100 g of dioxane were added, and the reaction was performed at an internal temperature of 100°C for 24 hours. After the reaction was finished, the reaction mixture was cooled to a room temperature, 2,000 ml of MIBK was added to the mixture, and the mixture was washed six times with 500 ml of pure water. The organic layer was recovered, and moisture, the solvent, and remained monomers were removed under a reduced pressure of 2 mmHg at an internal temperature of 150°C to obtain a resin (B-1).

The weight-average molecular weight (Mw) and the dispersion degree (Mw/Mn) were determined by GPC to obtain the following results.
(B-1): Mw=6,500, Mw/Mn=2.87

### (Synthesis Example 2)

### Synthesis of Resin (B-2)

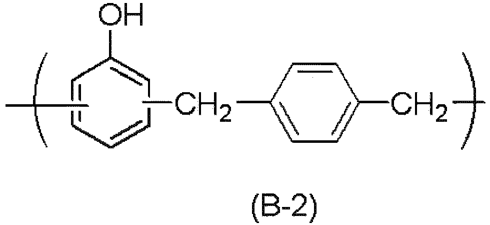

Under a nitrogen atmosphere, 94.1 g of the resin raw material (b-1), 89.8 g of the resin raw material (b-6), and 400 g of dichloromethane were added to prepare a uniform dispersion at an internal temperature of 30°C. Thereafter, 211 g of methanesulfonic acid was added over 2 hours, and a reaction was performed at an internal temperature of 30°C for 24 hours. After the reaction was finished, the reaction mixture was cooled to a room temperature, 2,000 ml of MIBK was added to the mixture, the mixture was washed six times with 500 ml of pure water, and the organic layer was decompressed to be dried. Into the residue, 300 g of THF was added to prepare a homogeneous solution, and then precipitation in 2,000 g of hexane was performed. The precipitated crystal was filtered to be separated, and washed twice with 500 g of hexane to be recovered. The recovered crystal was dried in vacuo at 70°C to obtain a resin (B-2) .

The weight-average molecular weight (Mw) and the dispersion degree (Mw/Mn) were determined by GPC to obtain the following results.
(B-2): Mw=6,300, Mw/Mn=3.11

### (Synthesis Example 3)

### Synthesis of Resin (B-3)

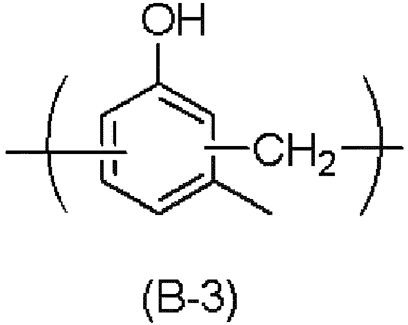

Under a nitrogen atmosphere, 216.3 g of the resin raw material (b-2), 113.6 g of the resin raw material (b-5), 10.8 g of oxalic acid, and 200 g of dioxane were added, and the reaction was performed at an internal temperature of 100°C for 24 hours. After the reaction was finished, the reaction mixture was cooled to a room temperature, 2,000 ml of MIBK was added to the mixture, and the mixture was washed six times with 500 ml of pure water. The organic layer was recovered, and moisture, the solvent, and remained monomers were removed under a reduced pressure of 2 mmHg at an internal temperature of 150°C to obtain a resin (B-3).

The weight-average molecular weight (Mw) and the dispersion degree (Mw/Mn) were determined by GPC to obtain the following results.
(B-3): Mw=7,000, Mw/Mn=3.50

### (Synthesis Example 4)

### Synthesis of Resin (B-4)

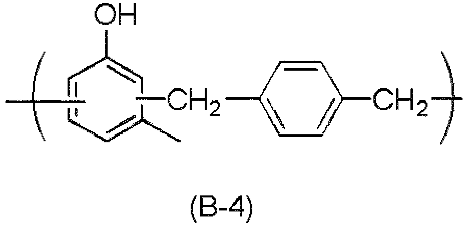

Under a nitrogen atmosphere, 108.2 g of the resin raw material (b-2), 89.8 g of the resin raw material (b-6), and 400 g of dichloromethane were added to prepare a uniform dispersion at an internal temperature of 30°C. Thereafter, 211 g of methanesulfonic acid was added over 2 hours, and a reaction was performed at an internal temperature of 30°C for 24 hours. After the reaction was finished, the reaction mixture was cooled to a room temperature, 2,000 ml of MIBK was added to the mixture, the mixture was washed six times with 500 ml of pure water, and the organic layer was decompressed to be dried. Into the residue, 300 g of THF was added to prepare a homogeneous solution, and then precipitation in 2,000 g of hexane was performed. The precipitated crystal was filtered to be separated, and washed twice with 500 g of hexane to be recovered. The recovered crystal was dried in vacuo at 70°C to obtain a resin (B-4) .

The weight-average molecular weight (Mw) and the dispersion degree (Mw/Mn) were determined by GPC to obtain the following results.
(B-4): Mw=6,900, Mw/Mn=3.34

### (Synthesis Example 5)

### Synthesis of Resin (B-5)

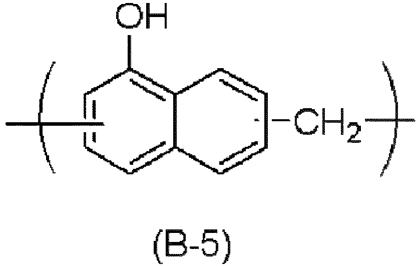

Under a nitrogen atmosphere, 144.2 g of the resin raw material (b-3), 56.8 g of the resin raw material (b-5), and 300 g of propylene glycol monomethyl ether (PGME) were added to be uniformized at an internal temperature of 100°C. Thereafter, a previously uniformized mixed liquid of 7.1 g of paratoluenesulfonic acid monohydrate and 7.1 g of PGME was slowly added dropwise, and a reaction was performed at an internal temperature of 100°C for 8 hours. After the reaction was finished, the reaction mixture was cooled to a room temperature, 2,000 ml of MIBK was added to the mixture, the mixture was washed six times with 500 ml of pure water, and the organic layer was decompressed to be dried. Into the residue, 300 g of THF was added to prepare a homogeneous solution, and then precipitation in 2,000 g of hexane is performed. The precipitated crystal was filtered to be separated, and washed twice with 500 g of hexane to be recovered. The recovered crystal was dried in vacuo at 70°C to obtain a resin (B-5) .

The weight-average molecular weight (Mw) and the dispersion degree (Mw/Mn) were determined by GPC to obtain the following results.
(B-5): Mw=2,900, Mw/Mn=2.76

### (Synthesis Example 6)

### Synthesis of Resin (B-6)

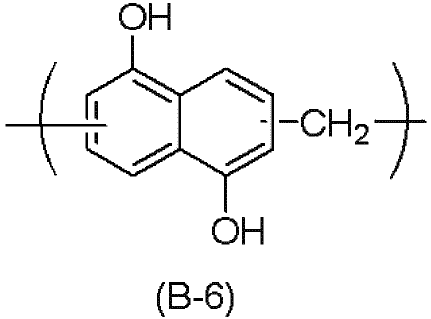

Under a nitrogen atmosphere, 160.2 g of the resin raw material (b-4), 56.8 g of the resin raw material (b-5), and 300 g of propylene glycol monomethyl ether (PGME) were added to be uniformized at an internal temperature of 100°C. Thereafter, a previously uniformized mixed liquid of 8.0 g of paratoluenesulfonic acid monohydrate and 8.0 g of PGME was slowly added dropwise, and a reaction is performed at an internal temperature of 80°C for 8 hours. After the reaction was finished, the reaction mixture was cooled to a room temperature, 2,000 ml of MIBK was added to the mixture, the mixture was washed six times with 500 ml of pure water, and the organic layer was decompressed to be dried. Into the residue, 300 g of THF was added to prepare a homogeneous solution, and then precipitation in 2,000 g of hexane is performed. The precipitated crystal was filtered to be separated, and washed twice with 500 g of hexane to be recovered. The recovered crystal was dried in vacuo at 70°C to obtain a resin (B-6) .

The weight-average molecular weight (Mw) and the dispersion degree (Mw/Mn) were determined by GPC to obtain the following results.
(B-6): Mw=3,300, Mw/Mn=2.54

### (Synthesis Example 7)

### Synthesis of Resin (B-7)

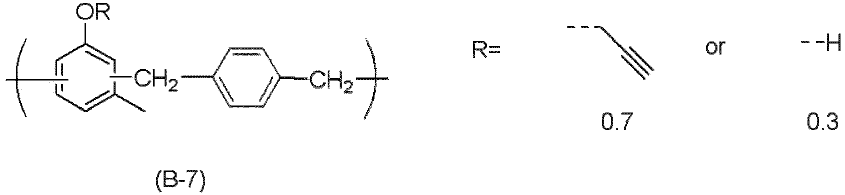

Under a nitrogen atmosphere, 20.0 g of the resin (B-4), 15.8 g of potassium carbonate, and 100 g of DMF were added to prepare a uniform dispersion at an internal temperature of 50°C. Into the dispersion, 7.9 g of the modifier (c-1) was slowly added, and a reaction was performed at an internal temperature of 50°C for 24 hours. Into the reaction liquid, 300 ml of methyl isobutyl ketone and 300 g of pure water were added to dissolve the precipitated salt, and then the separated aqueous layer was removed. The organic layer was washed six time with 100 g of a 3% aqueous nitric acid solution and 100 g of pure water, and then the organic layer was decompressed to be dried to obtain a resin (B-7).

The weight-average molecular weight (Mw) and the dispersion degree (Mw/Mn) were determined by GPC to obtain the following results.
(B-7): Mw=7,700, Mw/Mn=3.35

### (Synthesis Example 8)

### Synthesis of Resin (B-8)

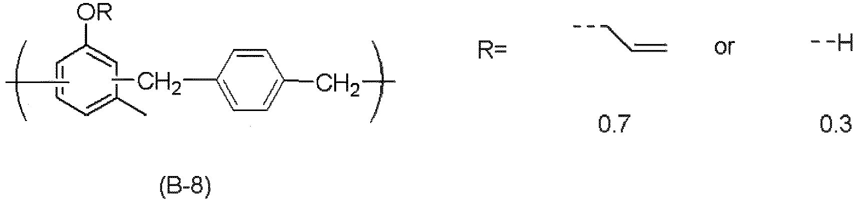

Under a nitrogen atmosphere, 20.0 g of the resin (B-4), 15.8 g of potassium carbonate, and 100 g of DMF were added to prepare a uniform dispersion at an internal temperature of 50°C. Into the dispersion, 8.1 g of the modifier (c-2) was slowly added, and a reaction was performed at an internal temperature of 50°C for 24 hours. Into the reaction liquid, 300 ml of methyl isobutyl ketone and 300 g of pure water were added to dissolve the precipitated salt, and then the separated aqueous layer was removed. The organic layer was washed six time with 100 g of a 3% aqueous nitric acid solution and 100 g of pure water, and then the organic layer was decompressed to be dried to obtain a resin (B-8).

The weight-average molecular weight (Mw) and the dispersion degree (Mw/Mn) were determined by GPC to obtain the following results.
(B-8): Mw=7,500, Mw/Mn=3.37

### (Synthesis Example 9)

### Synthesis of Resin (R-1)

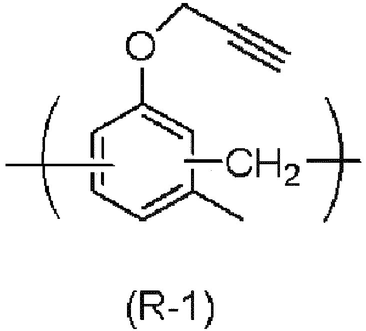

Under a nitrogen atmosphere, 20.0 g of the resin (B-3), 34.5 g of potassium carbonate, and 100 g of DMF were added to prepare a uniform dispersion at an internal temperature of 50°C. Into the dispersion, 23.8 g of the modifier (c-1) was slowly added, and a reaction was performed at an internal temperature of 50°C for 24 hours. Into the reaction liquid, 300 ml of methyl isobutyl ketone and 300 g of pure water were added to dissolve the precipitated salt, and then the separated aqueous layer was removed. The organic layer was washed six time with 100 g of a 3% aqueous nitric acid solution and 100 g of pure water, and then the organic layer was decompressed to be dried to obtain a resin (R-1).

The weight-average molecular weight (Mw) and the dispersion degree (Mw/Mn) were determined by GPC to obtain the following results.
(R-1): Mw=9,400, Mw/Mn=3.59

### (Synthesis Example 10)

### Synthesis of Resin (R-2)

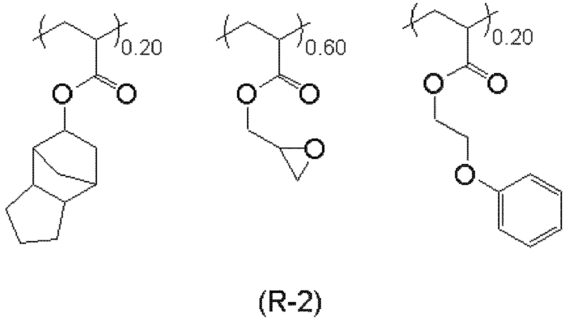

Under a nitrogen atmosphere, 23.3 of PGMEA was heated at 80°C with stirring. Into this heated PGMEA, a mixture of 25.8 g of glycidyl methacrylate, 12.0 g of 2-phenoxyethyl acrylate, 12.9 g of tricyclodecanyl acrylate, and 46.7 g of PGMEA; and a mixture of 4.45 g of dimethyl 2,2-azobis(2-methylpropionate) and 46.7 g of PGMEA were simultaneously and separately added over 2 hours. The mixture was further stirred with heating for 16 hours, cooled to 60°C, 200 g of heptane was added to the mixture, and the mixture was cooled to a room temperature to be left to stand for 2 hours. The upper layer was separated and removed, 100 g of PGMEA was added, and heptane was removed under a reduced pressure to obtain a PGMEA solution of a target polymer (R-2).

The weight-average molecular weight (Mw) and the dispersion degree (Mw/Mn) were determined by GPC to obtain the following results.
(R-2): Mw=7700, Mw/Mn=1.90

### (Synthesis Example 11)

### Synthesis of Resin (R-3)

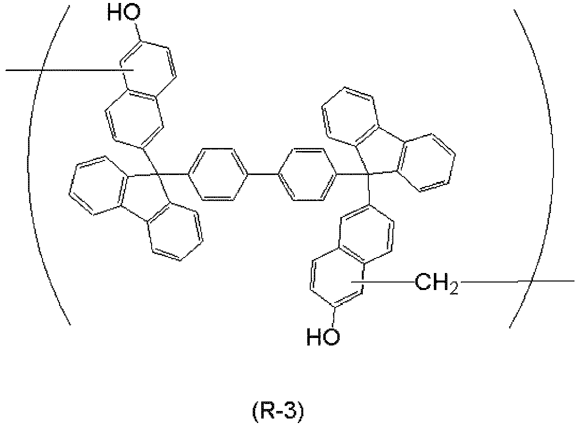

Into a 200-ml three-necked flask, 10.0 g of the compound (G-1) among the raw materials and 30 ml of 1-methoxy-2-propanol were weighed, and stirred under a nitrogen atmosphere in an oil bath at 75°C to be dissolved. Into the mixture, 0.25 g of paraformaldehyde was added, and 2.5 g of a 20 mass% solution of p-toluenesulfonic acid monohydrate in 1-methoxy-2-propanol was added dropwise. After the dropwise addition, the temperature of the oil bath was risen to 85°C and a reaction was performed for 4 hours. The mixture was allowed to be cooled to a room temperature, and diluted with 100 ml of methyl isobutyl ketone. The insoluble component was filtered off, the mixture was transferred into a separatory funnel, and washed eight times with 30 ml of ultrapure water with liquid separation. The organic layer was condensed under a reduced pressure to recover a polymer, and the polymer was decompressed to be dried to obtain a flowability accelerator polymer (R-3) .

The weight-average molecular weight (Mw) and the dispersion degree (Mw/Mn) were determined by GPC to obtain the following results.
(R-3): Mw=4920, Mw/Mn=1.75

### (Synthesis Example 12)

### Synthesis of Resin (R-4)

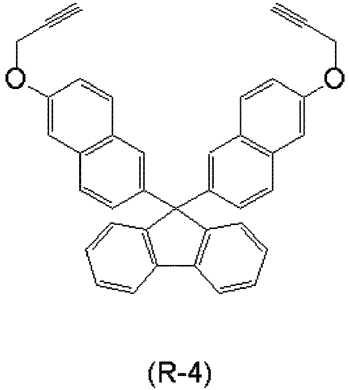

Under a nitrogen atmosphere, 42.8 g of the compound (G-2) among the raw materials, 15.7 g of potassium carbonate, and 150 g of DMF were added to prepare a uniform dispersion at an internal temperature of 50°C. Into the dispersion, 28.2 g of the modifier (c-1) was slowly added, and a reaction was performed at an internal temperature of 50°C for 24 hours. Into the reaction liquid, 300 ml of methyl isobutyl ketone and 300 g of pure water were added to dissolve the precipitated salt, and then the separated aqueous layer was removed. The organic layer was washed six time with 100 g of a 3% aqueous nitric acid solution and 100 g of pure water, and then the organic layer was decompressed to be dried to obtain a flowability accelerator compound (R-4) .

The weight-average molecular weight (Mw) and the dispersion degree (Mw/Mn) were determined by GPC to obtain the following results.
(R-4): Mw=560, Mw/Mn=1.01

### (Synthesis Example 13)

### Synthesis of Resin (R-5)

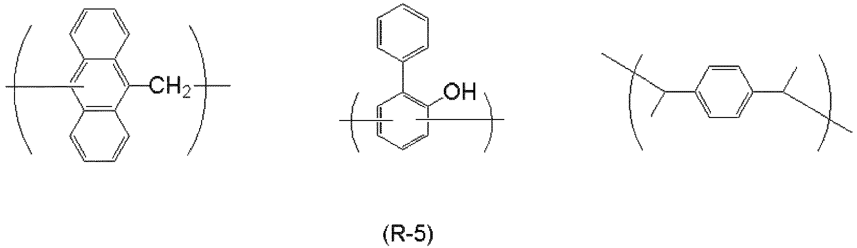

Into 25 g of cyclopentyl methyl ether and 90 g of diethylene glycol dimethyl ether, 90 g of 2-phenylphenol, 15.6 g of 9-anthracenemethanol, and 9.8 g of divinylbenzene were dissolved, and the solution was stirred at a room temperature for 5 minutes under a nitrogen atmosphere. Thereafter, 1.14 g of trifluoromethanesulfonic acid was added, the mixture was further stirred for 5 minutes, and subsequently stirred at 140°C for 3 hours. The reaction mixture was cooled, and diluted with 250 ml of cyclopentyl methyl ether. The mixture was transferred into a separatory funnel, washed with ultrapure water, and a polymer was precipitated with hexane. The precipitated polymer was filtered and recovered, and decompressed to be dried to obtain a target polymer (R-5).

The weight-average molecular weight (Mw) and the dispersion degree (Mw/Mn) were determined by GPC to obtain the following results.
(R-5): Mw=1960, Mw/Mn=1.45

### (Synthesis Example 14)

### Synthesis of Resin (R-6)

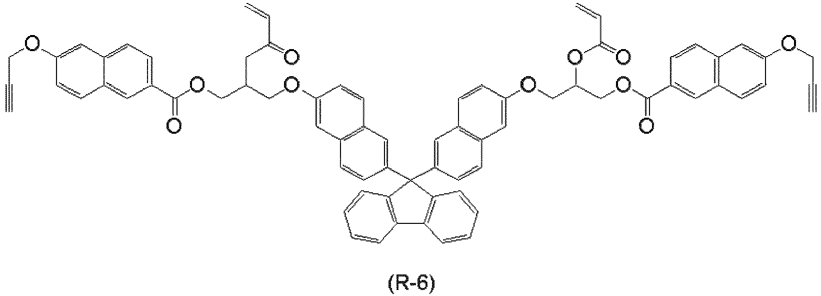

A mixture of 5.63 g of 9,9-bis(6-glycidyloxy-2-naphthyl)fluorene, 3.76 g of 6-hydroxy-2-naphthoic acid, 0.1 g of benzyltriethylammonium chloride, and 40 g of N-methylpyrrolidone was stirred at 120°C for 20 hours. After the mixture was allowed to be cooled, 2.76 g of potassium carbonate and 2.62 g of propargyl bromide were added, and the mixture was stirred at 60°C for 20 hours. The mixture was diluted by adding ethyl acetate, washed three times with water, and then condensed under a reduced pressure to synthesize a middle layer. Into the obtained middle layer, 40 g of N-methylpyrrolidone and 1.99 g of acryloyl chloride were added to be stirred, 2.33 g of triethylamine was added dropwise thereinto, and the mixture was stirred for 20 hours. The mixture was diluted by adding ethyl acetate, washed three times with water, condensed under a reduced pressure, and then the purified by silica-gel column chromatography to obtain 8.98 g of a compound (R-6).

The weight-average molecular weight (Mw) and the dispersion degree (Mw/Mn) were determined by GPC to obtain the following results.
(R-6): Mw=1613, Mw/Mn=1.10

Tables 1 to 3 show structure, weight-average molecular weight (Mw), and dispersion degree (Mw/Mn) of each of the obtained resins for the flowability accelerator.

**[Table 1]**

| Synthesis Example | Compound or polymer | Mw | Mw/Mn |
|---|---|---|---|
| 1 | 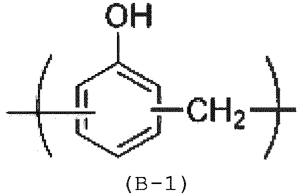 | 6500 | 2.87 |
| 2 | 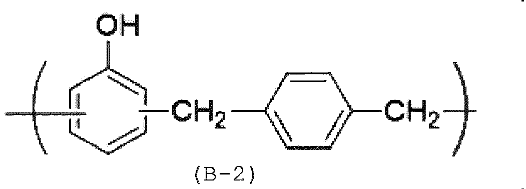 | 6300 | 3.11 |
| 3 | 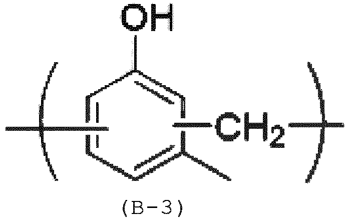 | 7000 | 3.50 |
| 4 | 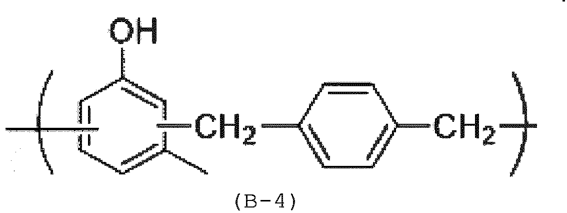 | 6900 | 3.34 |

**[Table 2]**

| Synthesis Example | Compound or polymer | Mw | Mw/Mn |
|---|---|---|---|
| 5 | 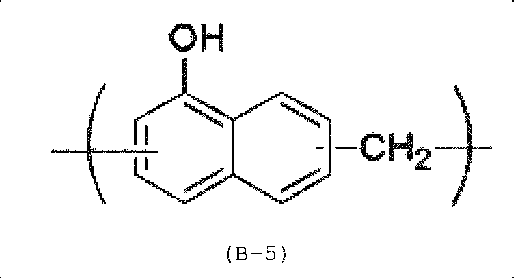 | 2900 | 2.76 |
| 6 | 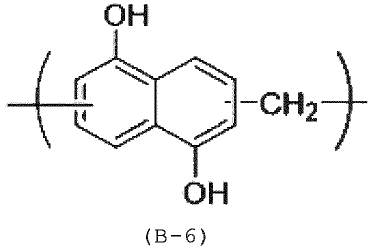 | 3300 | 2.54 |
| 7 | 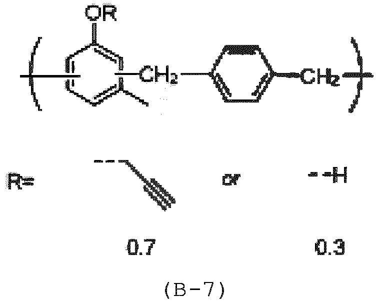 | 7700 | 3.35 |
| 8 | 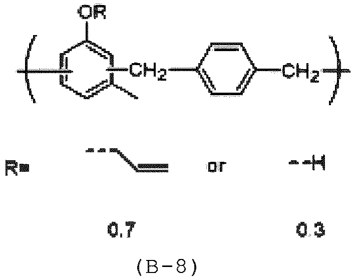 | 7500 | 3.37 |

**[Table 3]**

| Synthesis Example | Compound or polymer | Mw | Mw/Mn |
|---|---|---|---|
| 9 | 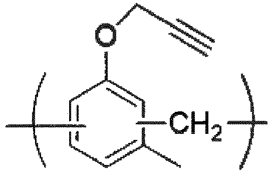 | 9400 | 3.59 |
| 10 | 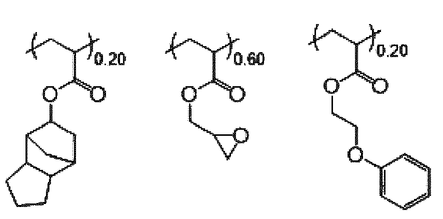 | 7700 | 1.90 |
| 11 | 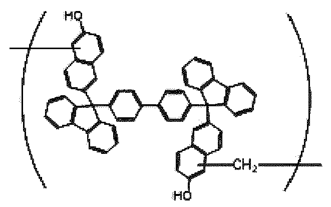 | 4920 | 1.75 |
| 12 | 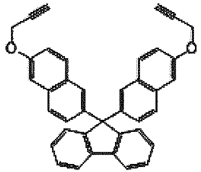 | 560 | 1.01 |
| 13 | 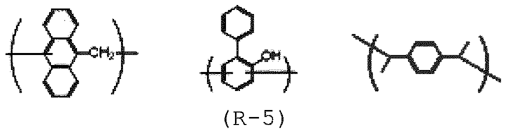 | 1960 | 1.45 |
| 14 | 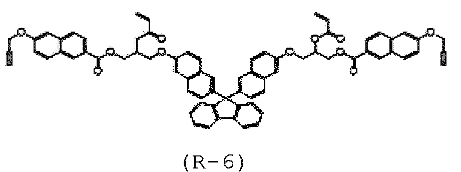 | 1613 | 1.10 |

### [(A) Metal Oxide Nanoparticle]

(A) a metal oxide nanoparticle (A-1) used for the composition for forming a metal oxide film was a ZrO₂ nanoparticle (5 nm core, 915505, Sigma-Aldrich Corp.).

### [(A) Comparative Metal Compound]

A comparative metal oxide compound (A-2) used for a comparative composition for forming a metal oxide film was synthesized by the following procedure with reference to Synthesis Example A-II in JP 5756134 B.

Into a mixture of 32.7 g of zirconium tetraisopropoxide, 50 g of isopropyl alcohol, and 50 g of acetylacetone, a mixture of 2.7 g of pure water and 50 g of isopropyl alcohol was added dropwise. After the dropwise addition, the mixture was stirred for 2 hours for hydrolytic condensation, and further heated to reflux for 2 hours. Into the mixture, 200 g of PGMEA was added, and the mixture was concentrated under a reduced pressure to obtain 250 g of a PGMEA solution of a zirconium-containing compound (A-2).

(A-2), which is a hydrolytically condensed product of the metal alkoxide and is a polymer having a polymetaloxane main skeleton, is structurally distinguished clearly from a metal oxide nanoparticle. Thus, this compound was used for Comparative Examples.

### [(C) Dispersion Stabilizer]

Compounds shown in Tables 4 and 5 are as follows.
C-1: A compound represented by the following formula (C-1) .
C-2: A compound represented by the following formula (C-2) .
C-3: A compound represented by the following formula (C-3) .
C-4: A compound represented by the following formula (C-4) .
C-5: A compound represented by the following formula (C-5) .
RC-1: A compound represented by the following formula (RC-1).
RC-2: A compound represented by the following formula (RC-2).
RC-3: A compound represented by the following formula (RC-3).

**[Table 4]**

| Compound or polymer | Mw (calculated value) | Weight reduction rate on temperature change from 30°C to 190°C | Weight reduction rate on temperature change from 30°C to 350°C |
|---|---|---|---|
| 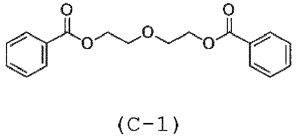 | 314 | 1 | 100 |
| 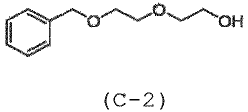 | 196 | 26 | 99 |
| 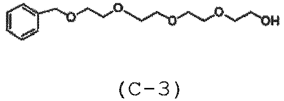 | 284 | 5 | 100 |
| 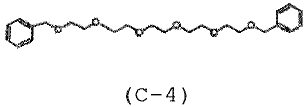 | 419 | 3 | 100 |
| 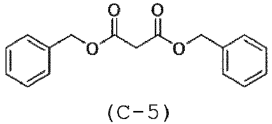 | 284 | 3 | 99 |

**[Table 5]**

| Compound or polymer | Mw (calculated value) | Weight reduction rate on temperature change from 30°C to 190°C | Weight reduction rate on temperature change from 30°C to 350°C |
|---|---|---|---|
| 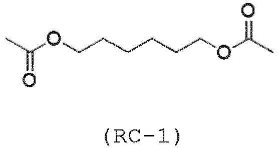 | 202 | 99 | 100 |
| 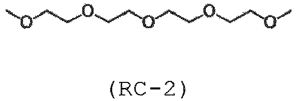 | 222 | 72 | 100 |
| 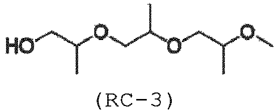 | 206 | 100 | 100 |

### [(E) Crosslinker]

A crosslinker (E) used for the composition for forming a metal oxide film is shown below.

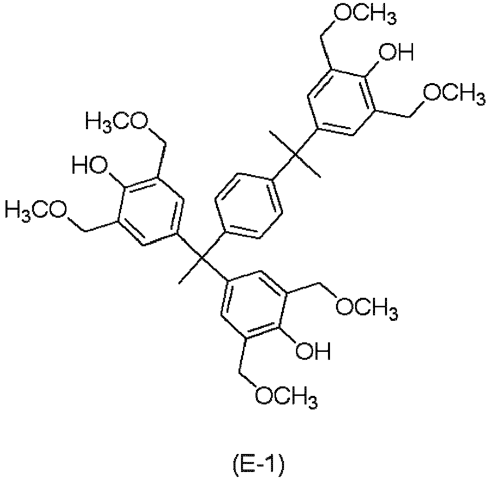

### [(F) Thermal acid generator]

A thermal acid generator (F) used for the composition for forming a metal oxide film is shown below.

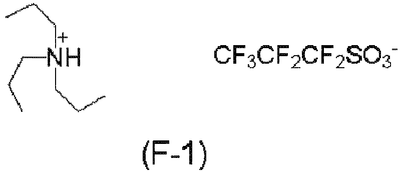

### [Composition for Forming Metal Oxide Film UDL-1]

The metal oxide nanoparticle (A-1) and the flowability accelerator (B-1) were dissolved in a propylene glycol monomethyl ether acetate (PGMEA) containing 0.5 mass% of a surfactant FC-4430 (manufactured by Sumitomo 3M Limited.) at a ratio in Table 6, and the mixture was filtered with a membrane filter with 0.02 um to prepare a composition for forming a metal oxide film (UDL-1).

### [Compositions for Forming Metal Oxide Film UDL-2 to 14 and Comparative UDL-1 to 14]

Each reagent liquid was prepared in the same procedure as of UDL-1 except that the kind and content of each component were those shown in Table 6 and Table 7. In Tables 6 and 7, "-" represents no use of the corresponding component. Used for the additive (G'-1) was pentaerythritol triacrylate.

**[Table 6]**

| Composition for forming metal oxide film | (A) Metal oxide nanoparticle | | (B) Compound/ polymer | | (C)Dispersion stabilizer | | (E) Crosslinker | (F) Thermal acid generator | (G) Additive | (D) Solvent | |
|---|---|---|---|---|---|---|---|---|---|---|---|
| | Struc ture | parts by mass | Struc ture | parts by mass | Struc ture | parts by mass | parts by mass | parts by mass | parts by mass | Struc ture | parts by mass |
| UDL-1 | A-1 | 30 | B-1 | 70 | C-1 | 3 | - | - | - | PGMEA | 360 |
| UDL-2 | A-1 | 30 | B-2 | 70 | C-2 | 3 | - | - | - | PGMEA | 360 |
| UDL-3 | A-1 | 30 | B-3 | 70 | C-3 | 3 | - | - | - | PGMEA | 360 |
| UDL-4 | A-1 | 30 | B-4 | 70 | C-4 | 3 | - | - | - | PGMEA | 360 |
| UDL-5 | A-1 | 30 | B-5 | 70 | C-5 | 3 | - | - | - | PGMEA | 360 |
| UDL-6 | A-1 | 30 | B-6 | 70 | C-1 | 3 | - | - | - | PGMEA | 360 |
| UDL-7 | A-1 | 30 | B-7 | 70 | C-2 | 3 | - | - | - | PGMEA | 360 |
| UDL-8 | A-1 | 30 | B-8 | 70 | C-3 | 3 | - | - | - | PGMEA | 360 |
| UDL-9 | A-1 | 30 | B-1 | 20 | C-4 | 3 | E-1 (14) | F-1 (2) | - | PGMEA | 360 |
| | | | R-1 | 50 | | | | | | | |
| UDL-10 | A-1 | 30 | B-1 | 50 | C-5 | 3 | - | - | | PGMEA | 360 |
| | | | R-1 | 20 | | | | | | | |
| UDL-11 | A-1 | 50 | B-1 | 50 | C-1 | 5 | - | - | - | PGMEA | 400 |
| UDL-12 | A-1 | 80 | B-1 | 20 | C-1 | 8 | - | - | - | PGMEA | 100 |
| UDL-13 | A-1 | 30 | B-1 | 70 | C-1 | 3 | - | - | - | PGMEA | 250 |
| UDL-14 | A-1 | 10 | B-1 | 90 | C-1 | 1 | - | - | - | PGMEA | 260 |

**[Table 7]**

| Composition for forming metal oxide film | (A) Metal oxide nanoparticle | | (B) Compound/ polymer | | (C) Dispersion stabilizer | | (E) Crosslinker | (F) Thermal acid generator | (G) Additive | (D) Solvent | |
|---|---|---|---|---|---|---|---|---|---|---|---|
| | Struc ture | parts by mass | Struc ture | parts by mass | Struc ture | parts by mass | parts by mass | parts by mass | parts by mass | Struc ture | parts by mass |
| Comparative UDL-1 | A-1 | 30 | R-1 | 70 | C-1 | 3 | - | - | - | PGMEA | 360 |
| Comparative UDL-2 | A-1 | 30 | R-2 | 70 | C-2 | 3 | - | - | - | PGMEA | 360 |
| Comparative UDL-3 | A-1 | 30 | R-3 | 70 | C-3 | 3 | - | - | - | PGMEA | 360 |
| Comparative UDL-4 | A-1 | 30 | R-4 | 70 | C-4 | 3 | - | - | - | PGMEA | 360 |
| Comparative UDL-5 | A-1 | 30 | R-5 | 70 | C-5 | 3 | - | - | - | PGMEA | 360 |
| Comparative UDL-6 | A-1 | 30 | R-6 | 70 | C-1 | 3 | - | - | - | PGMEA | 360 |
| Comparative UDL-7 | A-2 | 30 | B-1 | 70 | C-1 | 3 | - | - | - | PGMEA | 360 |
| Comparative UDL-8 | A-1 | 100 | - | - | - | - | - | - | - | PGMEA | 100 |
| Comparative UDL-9 | - | - | B-1 | 100 | - | - | - | - | - | PGMEA | 400 |
| Comparative UDL-10 | A-1 | 30 | - | - | - | - | - | - | G'-1 (70) | PGMEA | 180 |
| Comparative UDL-11 | A-1 | 80 | R-3 | 20 | C-1 | 8 | - | - | - | PGMEA | 100 |
| Comparative UDL-12 | A-1 | 50 | R-3 | 50 | C-2 | 5 | - | - | - | PGMEA | 400 |
| Comparative UDL-13 | A-1 | 30 | R-3 | 70 | C-3 | 3 | - | - | - | PGMEA | 250 |
| Comparative UDL-14 | A-1 | 10 | R-3 | 90 | C-1 | 1 | - | - | - | PGMEA | 250 |
| Comparative UDL-15 | A-1 | 30 | B-1 | 70 | - | - | - | - | - | PGMEA | 250 |
| Comparative UDL-16 | A-1 | 30 | B-1 | 70 | RC-1 | 3 | - | - | - | PGMEA | 250 |
| Comparative UDL-17 | A-1 | 30 | B-1 | 70 | RC-2 | 3 | - | - | - | PGMEA | 250 |
| Comparative UDL-18 | A-1 | 30 | B-1 | 70 | RC-3 | 3 | - | - | - | PGMEA | 250 |

### [Evaluation of Cracking Resistance (Examples 1-1 to 1-14 and Comparative Examples 1-1 to 1-18)]

Each of the compositions for forming a metal oxide film (UDL-1 to 14 and Comparative UDL-1 to 18) was applied onto a silicon substrate. In the atmosphere, the composition was baked at 350°C for 60 seconds to form a coating film, and the film thickness "a" was measured. A PGMEA solvent was dispensed thereon, left to stand for 30 seconds, then spin-drying was performed, and baking was performed at 100°C for 60 seconds to evaporate the PGMEA solvent. The film thickness "b" was measured. A difference in the film thickness before and after the PGMEA treatment was determined to evaluate solvent resistance. In addition, evaluated was presence/absence of cracking on each coating film before and after the PGMEA solvent dispensing. A case of absence of the cracking was evaluated as "Good", and a case of presence of the cracking was evaluated as "Poor".

Tables 8 and 9 show the results.

**[Table 8]**

| | Composition for forming metal oxide film | (A) Content | (B) Content | Film thickness "a" (A) | Film thickness "b" (A) | b/a × 100 | Coatability "a" | Coatability "b" |
|---|---|---|---|---|---|---|---|---|
| | | % | % | Å | Å | % | Cracking | Cracking |
| Example 1-1 | UDL-1 | 6% | 15% | 9987 | 9988 | 100% | Good | Good |
| Example 1-2 | UDL-2 | 6% | 15% | 9994 | 9994 | 100% | Good | Good |
| Example 1-3 | UDL-3 | 6% | 15% | 10040 | 10039 | 100% | Good | Good |
| Example 1-4 | UDL-4 | 6% | 15% | 9998 | 9998 | 100% | Good | Good |
| Example 1-5 | UDL-5 | 6% | 15% | 10002 | 10003 | 100% | Good | Good |
| Example 1-6 | UDL-6 | 6% | 15% | 10004 | 10005 | 100% | Good | Good |
| Example 1-7 | UDL-7 | 6% | 15% | 9989 | 9988 | 100% | Good | Good |
| Example 1-8 | UDL-8 | 6% | 15% | 10001 | 10000 | 100% | Good | Good |
| Example 1-9 | UDL-9 | 6% | 15% | 9431 | 9430 | 100% | Good | Good |
| Example 1-10 | UDL-10 | 6% | 15% | 9991 | 9990 | 100% | Good | Good |
| Example 1-11 | UDL-11 | 10% | 10% | 10031 | 10031 | 100% | Good | Good |
| Example 1-12 | UDL-12 | 38% | 10% | 19650 | 19650 | 100% | Good | Good |
| Example 1-13 | UDL-13 | 8% | 20% | 18003 | 18002 | 100% | Good | Good |
| Example 1-14 | UDL-14 | 3% | 25% | 23920 | 23920 | 100% | Good | Good |

**[Table 9]**

| | Composition for forming metal oxide film | (A) Content | (B) Content | Film thickness "a" (A) | Film thickness "b" (A) | b/a × 100 | Coatability "a" | Coatability "b" |
|---|---|---|---|---|---|---|---|---|
| | | % | % | Å | Å | % | Cracking | Cracking |
| Comparative Example 1-1 | Comparative UDL-1 | 6% | 15% | 10011 | 10010 | 100% | Good | Good |
| Comparative Example 1-2 | Comparative UDL-2 | 6% | 15% | 9350 | 9349 | 100% | Good | Good |
| Comparative Example 1-3 | Comparative UDL-3 | 6% | 15% | 9973 | 9974 | 100% | Poor | Poor |
| Comparative Example 1-4 | Comparative UDL-9 | 6% | 15% | 9984 | 9985 | 100% | Poor | Poor |
| Comparative Example 1-5 | Comparative UDL-5 | 6% | 15% | 9954 | 9953 | 100% | Poor | Poor |
| Comparative Example 1-6 | Comparative UDL-6 | 6% | 15% | 9974 | 9975 | 100% | Good | Good |
| Comparative Example 1-7 | Comparative UDL-7 | 6% | 15% | 9933 | 9933 | 100% | Poor | Poor |
| Comparative Example 1-8 | Comparative UDL-8 | 50% | 0% | 10081 | 10081 | 100% | Poor | Poor |
| Comparative Example 1-9 | Comparative UDL-9 | 0% | 20% | 10044 | 10044 | 100% | Good | Good |
| Comparative Example 1-10 | Comparative UDL-10 | 11% | 0% | 9966 | 9966 | 100% | Good | Good |
| Comparative Example 1-11 | Comparative UDL-11 | 38% | 10% | 19354 | 19355 | 100% | Poor | Poor |
| Comparative Example 1-12 | Comparative UDL-12 | 10% | 10% | 10101 | 10100 | 100% | Poor | Poor |
| Comparative Example 1-13 | Comparative UDL-13 | 8% | 20% | 18190 | 18191 | 100% | Poor | Poor |
| Comparative Example 1-14 | Comparative UDL-14 | 3% | 26% | 17450 | 17450 | 100% | Poor | Poor |
| Comparative Example 1-15 | Comparative UDL-15 | 9% | 20% | 18189 | 18188 | 100% | Good | Good |
| Comparative Example 1-16 | Comparative UDL-16 | 8% | 20% | 17993 | 17993 | 100% | Good | Good |
| Comparative Example 1-17 | Comparative UDL-17 | 8% | 20% | 18002 | 18000 | 100% | Good | Good |
| Comparative Example 1-18 | Comparative UDL-18 | 8% | 20% | 18108 | 18109 | 100% | Good | Good |

As shown in Tables 8 and 9, it is found that in any of Examples 1-1 to 1-14, which used the inventive compositions for forming a metal oxide film (UDL-1 to 14), a film having good film formability and almost no reduction in the film due to the solvent treatment, therefore good solvent resistance, can be obtained. Each of Example UDL-14, which had a content of the flowability accelerator being as high as 25%, and Example UDL-12, which had a content of the metal oxide film nanoparticle being as high as 38%, formed a metal oxide film with 2 pm in film thickness without cracking. That is, when the content of the inventive flowability accelerator (B) is 9% or more and preferably when the weight ratio between the metal oxide nanoparticle (A) and the flowability accelerator (B) is 80/20 to 10/90, a thick metal oxide film can be formed with excellent coatability. Meanwhile, in Comparative UDL-3 and 4 and UDL-11 to 14, which used R-3 and R-4 having the flowability accelerator with a cardo structure, and Comparative UDL-5, which used the high-carbon polymer R-5, cracking was observed.

In Comparative UDL-7 in which the metal oxide nanoparticle of UDL-1 was changed to the polymer A-2 having the polymetaloxane main chain skeleton, which was a hydrolytically condensed product of the metal alkoxide, cracking was also observed. It is presumed that the metal compound having a polymer structure such as A-2 has low heat resistance and large thermal contraction during the baking, resulting in cracking. Meanwhile, also in Comparative UDL-8, which used the metal oxide nanoparticle A-1 alone, cracking was observed. From these results, it can be mentioned that adding the flowability accelerator is needed for forming a thick metal oxide film having excellent coatability, this flowability accelerator being a resin having the inventive structural unit represented by the general formula (1) and essentially not containing a compound/polymer having a cardo structure nor a high-carbon polymer.

### [Evaluation of Storage Stability (Examples 2-1 to 2-14 and Comparative Examples 2-1 to 2-9)]

Of the metal oxide films of UDL-1 to 14 in Examples, Comparative UDL-1 and 2, Comparative UDL-6, Comparative UDL-9 and 10, and Comparative UDL-15 to 18, which had good coatability in the evaluation of cracking resistance, a number of defects with 100 nm in size was checked by using SP2 (defect inspection device), manufactured by KLA-TENCOR. In addition, in-liquid particles of the above compositions for forming a metal oxide film were measured by using KS-41 (in-liquid particle counter), manufactured by Kyushu RION corporation. A number of particles with 0.15 um or larger contained in 1 mL of the composition was counted five times, and an average value thereof was used as the measured value. After the composition was stored under an environment at 10°C for 6 months, the number of defects and the number of in-liquid particles were checked in the same manner as above.

Table 10 shows the results.

**[Table 10]**

| | Composition for forming metal oxide film | Evaluation of coating defect (initial) | LPC (initial) | Evaluation of coating defect (after 6 months) | LPC (after 6 months) |
|---|---|---|---|---|---|
| | | number/wf | number/ml | number/wf | number/ml |
| Example 2-1 | UDL-1 | 16 | 4.2 | 18 | 4.3 |
| Example 2-2 | UDL-2 | 13 | 4.1 | 16 | 4.4 |
| Example 2-3 | UDL-3 | 13 | 3.9 | 13 | 4.5 |
| Example 2-4 | UDL-4 | 10 | 4.5 | 14 | 4.4 |
| Example 2-5 | UDL-5 | 14 | 4.3 | 15 | 4.3 |
| Example 2-6 | UDL-6 | 16 | 4.4 | 14 | 4.3 |
| Example 2-7 | UDL-7 | 19 | 4.6 | 17 | 4.4 |
| Example 2-8 | UDL-8 | 17 | 3.8 | 18 | 4.2 |
| Example 2-9 | UDL-9 | 12 | 4.0 | 16 | 4.3 |
| Example 2-10 | UDL-10 | 18 | 4.2 | 20 | 4.1 |
| Example 2-11 | UDL-17 | 16 | 4.2 | 19 | 4.2 |
| Example 2-12 | UDL-12 | 17 | 4.5 | 16 | 4.3 |
| Example 2-13 | UDL-13 | 15 | 4.1 | 17 | 4.6 |
| Example 2-14 | UDL-14 | 18 | 4.0 | 15 | 4.2 |
| Comparative Example 2-1 | Comparative UDL-1 | 20 | 3.9 | 17 | 4.1 |
| Comparative Example 2-2 | Comparative UDL-2 | 19 | 4.2 | 18 | 4.3 |
| Comparative Example 2-3 | Comparative UDL-6 | 14 | 4.5 | 16 | 4.3 |
| Comparative Example 2-4 | Comparative UDL-9 | 11 | 3.6 | 16 | 3.8 |
| Comparative Example 2-5 | Comparative UDL-10 | 21 | 4.6 | 49 | 8.9 |
| Comparative Example 2-6 | Comparative UDL-15 | 17 | 4.3 | 72 | 12.3 |
| Comparative Example 2-7 | Comparative UDL-16 | 16 | 4.2 | 63 | 10.9 |
| Comparative Example 2-8 | Comparative UDL-17 | 19 | 4.6 | 58 | 10.6 |
| Comparative Example 2-9 | Comparative UDL-18 | 25 | 4.7 | 79 | 11.4 |

As shown in Table 10, Examples 2-1 to 2-14, which used the inventive compositions for forming a metal oxide film (UDL-1 to 14), had small numbers of the in-liquid particles and defects after coating after the 6-month storage, and found to have excellent storage stability. Meanwhile, Comparative Example 2-6, which used Comparative UDL-15 removing the dispersion stabilizer (C) from UDL-13, and Comparative Examples 2-7 to 2-9, which used RC-1 to 3 as the dispersion stabilizer (C), found the increased numbers of particles and defects after coating after the 6-month storage. This is presumably because the metal oxide nanoparticle in the composition has poor dispersion stability, and the nanoparticles are aggregated during the long-term storage.

### [Evaluation of Etching Resistance (Examples 3-1 to 3-11 and Comparative Examples 3-1 to 3-5)]

Each of the compositions for forming a metal oxide film of UDL-1 to 11 in Examples, Comparative UDL-1 and 2, Comparative UDL-6, and Comparative UDL-9 and 10, which had good coatability in the evaluation of cracking resistance, was applied onto a silicon substrate. The composition was baked in the atmosphere at 350°C for 60 seconds to form a coating film with 1000 nm, and the film thickness "a" was measured. Subsequently, etching was performed by using an etching apparatus "Telius", manufactured by Tokyo Electron Ltd., with a CF₄ gas and an O₂ gas under the following conditions for each 1 minute, and the film thickness "b" was measured.

A film thickness etched with the CF₄ gas within the 1 minute (film thickness "b" - film thickness "a") was calculated as etching resistance against the CF₄ gas. A case of the difference between the film thicknesses "b" and "a" being less than 60 nm was evaluated as "A" (excellent), a case of that being 60 nm or more and less than 70 nm was evaluated as "B" (good), and a case of that being 70 nm or more was evaluated as "C" (poor).

A film thickness etched with the O₂ gas within the 1 minute (film thickness "d" - film thickness "c") was calculated as etching resistance against the O₂ gas. A case of the difference between the film thicknesses "c" and "d" being less than 75 nm was evaluated as "A" (excellent), a case of that being 75 nm or more and less than 85 nm was evaluated as "B" (good), and a case of that being 85 nm or more was evaluated as "C" (poor).

Table 11 shows the results.

Dry etching condition with CF₄ gas
Chamber pressure: 100 mT
RF power (upper part): 500 W
RF power (lower part): 400 W
CF₄ gas flow rate: 300 sccm
Time: 60 sec
Chamber pressure: 15 mT
RF power (upper part): 300 W
RF power (lower part): 50 W
O₂ gas flow rate: 30 sccm
N₂ gas flow rate: 270 sccm
Time: 60 sec

**[Table 11]**

| | Composition for forming metal oxide film | (A) content | (B) content | Etching | resistance |
|---|---|---|---|---|---|
| | | % | % | CF | O₂ |
| Example 3-1 | UDL-1 | 6% | 15% | A | A |
| Example 3-2 | UDL-2 | 6% | 15% | A | A |
| Example 3-3 | UDL-3 | 6% | 15% | A | A |
| Example 3-4 | UDL-4 | 6% | 15% | A | A |
| Example 3-5 | UDL-5 | 6% | 15% | A | A |
| Example 3-6 | UDL-6 | 6% | 15% | A | A |
| Example 3-7 | UDL-7 | 6% | 15% | A | A |
| Example 3-8 | UDL-8 | 6% | 15% | A | A |
| Example 3-9 | UDL-9 | 6% | 15% | A | A |
| Example 3-10 | UDL-10 | 6% | 15% | A | A |
| Example 3-11 | UDL-11 | 10% | 10% | A | A |
| Comparative Example 3-1 | Comparative UDL-1 | 6% | 15% | A | A |
| Comparative Example 3-2 | Comparative UDL-2 | 6% | 15% | C | C |
| Comparative Example 3-3 | Comparative UDL-6 | 6% | 15% | C | C |
| Comparative Example 3-4 | Comparative UDL-9 | 0% | 20% | C | C |
| Comparative Example 3-5 | Comparative UDL-10 | 11% | 0% | C | C |

As shown in Table 11, with comparing the compositions having a content of the metal oxide nanoparticle (A) of 6% and a content of the flowability accelerator (B) of 15%, it was found that Examples 3-1 to 3-10, which used the inventive composition for forming a metal oxide film, have excellent etching resistance against the CF₄ gas and O₂ gas compared with Comparative Examples 3-2 and 3-3. Therefore, since exhibiting excellent etching resistance against both of the CF₄ gas and O₂ gas, the inventive composition is suggested to be useful as a mask for etching a Si-based substrate to be processed with a CF₄-based gas and useful for a reversing process of removing an organic resist underlayer film pattern with an O₂-based gas and reversing the pattern to a metal oxide film.

The composition containing no metal oxide nanoparticle and composed of only the flowability accelerator, such as Comparative Example 3-4, cannot form a film having excellent dry-etching resistance. Meanwhile, even the composition containing the metal oxide nanoparticle varies the dry etching resistance depending on the selected flowability accelerator. Comparative Example 3-2, which used the acrylic resin for the flowability accelerator, deteriorated the dry etching resistance. It is presumed that although the flowability accelerator R-6, which used in Comparative Example 3-3, is a compound having a cardo structure having excellent dry etching resistance, the compound has a flexible acrylate group as the crosslinking group, therefore, a dense cured film cannot be formed and the dry etching resistance is deteriorated. In Comparative Example 3-5, the composition using pentaerythritol tiracrylate, which is commonly used as a binder for UV-curing, instead of the flowability accelerator was unsuitable for forming a film having excellent dry-etching resistance, similar to Comparative Example 3-2 and Comparative Example 3-3.

That is, it can be mentioned that using the resin having the structural unit represented by the general formula (1) as the flowability accelerator is important to achieve the composition that can form a thick film excellent in the dry etching resistance and the cracking resistance.

### [Evaluation of Filling Property (Examples 4-1 to 4-14 and Comparative Examples 4-1 to 4-18)]

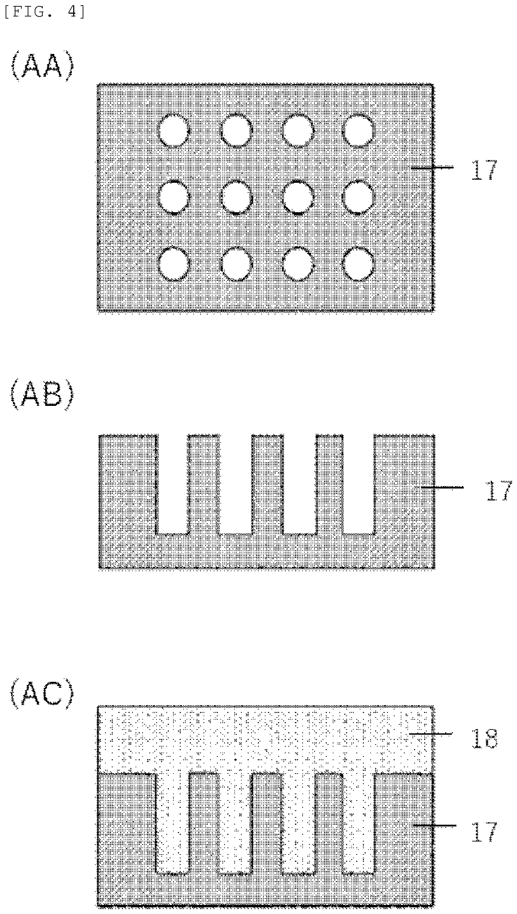

Each of the above composition for forming a metal oxide film (UDL-1 to 14 and Comparative UDL-1 to 18) were applied onto a SiO₂ wafer substrate having a dense hole pattern (hole diameter: 0.16 um, hole depth: 2.0 um, distance between centers of adjacent two holes: 0.40 um). The composition was heated at 350°C for 60 seconds by using a hot plate to form a metal oxide film. The composition was similarly heated in the atmosphere at 350°C for 60 seconds, and baked at 450°C for 60 seconds under a nitrogen flow managed with an oxygen concentration of 0.2% or less to form a metal oxide film. The used substrate was a base substrate 17 (SiO₂ wafer substrate) having the dense hole pattern illustrated in FIG. 4(AA) (overhead view) and FIG. 4(AB) (sectional view). A sectional shape of each of the obtained wafer substrate was observed by using an electron microscope (S-4700), manufactured by Hitachi, Ltd., to check whether there is no void (space) inside the metal oxide film filling the hole inside. Tables 12 and 13 show the results. When a composition for forming a metal oxide film having poor filling property is used, voids are generated inside the metal oxide film filling the hole inside in this evaluation. When a composition for forming a metal oxide film having good filling property is used, a metal oxide film 18 fills the hole inside without void and peeling in this evaluation, as illustrated in FIG. 4(AC).

**[Table 12]**

| | Composition for forming metal oxide film | (A) content | (B) content | Filling | |
|---|---|---|---|---|---|
| | | % | % | 350°C | 450°C |
| Example 4-1 | UDL-1 | 6% | 15% | Absent | Absent |
| Example 4-2 | UDL-2 | 6% | 15% | Absent | Absent |
| Example 4-3 | UDL-3 | 6% | 15% | Absent | Absent |
| Example 4-4 | UDL-4 | 6% | 15% | Absent | Absent |
| Example 4-5 | UDL-5 | 6% | 15% | Absent | Absent |
| Example 4-6 | UDL-6 | 6% | 15% | Absent | Absent |
| Example 4-7 | UDL-7 | 6% | 15% | Absent | Absent |
| Example 4-8 | UDL-8 | 6% | 15% | Absent | Absent |
| Example 4-9 | UDL-9 | 6% | 15% | Absent | Absent |
| Example 4-10 | UDL-10 | 6% | 15% | Absent | Absent |
| Example 4-11 | UDL-11 | 10% | 10% | Absent | Absent |
| Example 4-12 | UDL-12 | 38% | 10% | Absent | Absent |
| Example 4-13 | UDL-13 | 8% | 20% | Absent | Absent |
| Example 4-14 | UDL-14 | 3% | 25% | Absent | Absent |

**[Table 13]**

| | Composition for forming metal oxide film | (A) content | (B) content | Filling | |
|---|---|---|---|---|---|
| | | % | % | 350°C | 450°C |
| Comparative Example 4-1 | Comparative UDL-1 | 6% | 15% | Peeled | Peeled |
| Comparative Example 4-2 | Comparative UDL-2 | 6% | 15% | Void | Void |
| Comparative Example 4-3 | Comparative UDL-3 | 6% | 15% | Void | Void |
| Comparative Example 4-4 | Comparative UDL-4 | 6% | 15% | Peeled | Peeled |
| Comparative Example 4-5 | Comparative UDL-5 | 6% | 15% | Void | Void |
| Comparative Example 4-6 | Comparative UDL-6 | 6% | 15% | Peeled | Peeled |
| Comparative Example 4-7 | Comparative UDL-7 | 6% | 15% | Void | Void |
| Comparative Example 4-8 | Comparative UDL-8 | 50% | 0% | Void | Void |
| Comparative Example 4-9 | Comparative UDL-9 | 0% | 20% | Absent | Absent |
| Comparative Example 4-10 | Comparative UDL-10 | 11% | 0% | Void | Void |
| Comparative Example 4-11 | Comparative UDL-11 | 38% | 10% | Void | Void |
| Comparative Example 4-12 | Comparative UDL-12 | 10% | 10% | Void | Void |
| Comparative Example 4-13 | Comparative UDL-13 | 8% | 20% | Void | Void |
| Comparative Example 4-14 | Comparative UDL-14 | 3% | 26% | Void | Void |
| Comparative Example 4-15 | Comparative UDL-15 | 9% | 20% | Micro void | Micro void |
| Comparative Example 4-16 | Comparative UDL-16 | 8% | 20% | Micro void | Micro void |
| Comparative Example 4-17 | Comparative UDL-17 | 8% | 20% | Micro void | Micro void |
| Comparative Example 4-18 | Comparative UDL-18 | 8% | 20% | Micro void | Micro void |

As shown in Tables 12 and 13, Examples 4-1 to 4-14, which used the inventive compositions for forming a metal oxide film (UDL-1 to 14), can fill the dense hole pattern having a high aspect ratio without void. The inventive composition is confirmed to have good filling property. Meanwhile, Comparative Example 4-8, which used Comparative UDL-8 of the metal oxide nanoparticle alone, had insufficient flowability, and thereby found considerable voids.

In Comparative Example 4-15, which used no dispersion stabilizer, a small amount of micro voids were observed. Also, in Comparative Examples 4-16 to 4-18, which used the dispersion stabilizer having a weight reduction rate of more than 30% on a temperature change from 30°C to 190°C, micro voids were observed presumably due to insufficient effect of assisting the thermal flowability effect of the flowability accelerator. That is, it can be mentioned that not only the flowability accelerator but also the dispersion stabilizer having an effect of further improving the thermal flowability of the resins for the thermal flowability accelerator is preferably added to achieve the composition for forming a metal oxide film having excellent filling property for a high aspect-ratio pattern. The dispersion stabilizer used in the present invention has not only the function of improving the dispersion stability of the metal oxide nanoparticle in the composition but also the function of improving the thermal flowability of the composition.

Such as Examples 4-7 and 4-8, by appropriately regulating the modifying rate of the hydroxy group of the flowability accelerator, such as B-7 and B-8, both of the good filling property and good adhesiveness to a substrate can be highly achieved. In Example 4-10, the resin R-1, which has a propargyloxo group, and the resin B-1, which has a hydroxy group, are combined for regulating the modifying rate to obtain the effect similar to the effect of Example 4-7. Meanwhile, in Comparative Example 4-1, Comparative Example 4-4, and Comparative Example 4-6, no void was observed inside the holes but deterioration in adhesiveness to the substrate was observed due to an insufficient amount of the hydroxy groups of the flowability accelerator. It can be mentioned that a certain amount of the hydroxy groups is preferably contained to exhibit the adhesiveness to the substrate.

In Comparative UDL-7 in which the metal oxide nanoparticle of UDL-1 was changed to the polymer A-2 being a hydrolytically condensed product of the metal alkoxide and having a polymetaloxane main chain skeleton, it is presumed that A-2 has poor heat resistance and large thermal contraction during the baking, leading to failure to fill the substrate bottom and observed considerable voids. In Comparative Example 4-2, it is considered that R-2 used for the flowability accelerator has insufficient heat resistance, therefore a void was generated during the baking at 350°C. Also, in Comparative Example 4-10, insufficient heat resistance of pentaerythritol triacrylate used instead of the flowability accelerator, therefore a void was generated. Meanwhile, Comparative Example 4-3 and Comparative Example 4-5 used R-3 and R-5, which have excellent heat resistance, for the flowability accelerator. However, it is presumed that these materials have poor flowability, therefore a void was generated on filling the high aspect-ratio pattern. In Comparative Example 4-13, the content of the flowability accelerator was increased from 15% to 20% compared with Comparative Example 4-3 to form a thick film, but the void was not improved. Also, in Comparative Example 4-14, which used the flowability accelerator and the metal oxide nanoparticle at a weight ratio of 90/10 to increase the rate of the flowability accelerator, a void was observed. In Comparative Examples 4-11 and 4-12, which used Comparative UDL-1 and 12 using R-3, a void was also observed.

That is, it can be mentioned that the presence of the flowability accelerator is essential to form a metal oxide having excellent filling property that can favorably fill a high aspect-ratio pattern, but a high carbon polymer such as the polymers R-3 and R-5 having a rigid cardo structure is unsuitable due to its poor flowability, and using the inventive resin having the structural unit represented by the general formula (1) is important.

### [Patterning Process (Examples 5-1 to 5-11 and Comparative Examples 5-1 to 5-5)]

Each of the compositions for forming a metal oxide film of UDL-1 to 11 in Examples, Comparative UDL-1 and 2, Comparative UDL-6, and Comparative UDL-9 and 10, which had good coatability in the evaluation of cracking resistance, was applied onto a silicon wafer substrate on which a 1000-nm SiO₂ film having a trench pattern (trench width: 10 um, trench depth: 0.50 µm) was formed. The composition was baked in the atmosphere at 350°C for 60 seconds to form a metal-containing film with 1000 nm in film thickness. A silicon atom-containing resist middle layer material (SOG-1) was applied thereon, and baked at 220°C for 60 seconds to form a resist middle layer film with 40 nm in film thickness. A single layer resist for ArF of a resist upper layer film material was applied thereon, and baked at 105°C for 60 seconds to form a photoresist film with 100 nm in film thickness.

The silicon atom-containing resist middle layer material (SOG-1) was prepared as follows. A silicon-containing middle layer film polymer for ArF (SiP1) and a crosslinking catalyst (CAT1) were dissolved in an organic solvent containing 0.1 mass% of FC-4430 (manufactured by Sumitomo 3M Limited.) at a ratio shown in Table 14, and the composition was filtered with a filter made of a fluororesin having a pore diameter of 0.1 um to prepare the silicon atom-containing resist middle layer film material (SOG-1).

**[Table 14]**

| | Polymer | Thermally crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The structural formulae of the used silicon-containing middle layer film polymer for ArF (SiP1) and crosslinking catalyst (CAT1) are shown below.

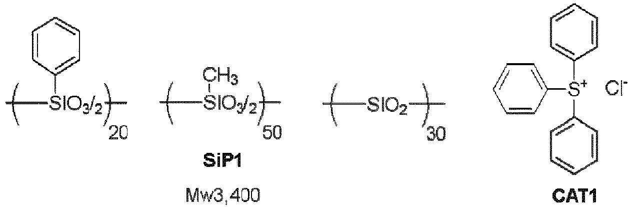

The resist upper layer film material (single layer resist for ArF) was prepared as follows. A polymer (RP1), an acid generator (PAG1), and a base compound (Amine1) were dissolved in a solvent containing 0.1 mass% of a surfactant FC-4430 (manufactured by Sumitomo 3M Limited.) at a ratio shown in Table 15, and the solution was filtered with a filter made of a fluororesin with 0.1 um.

**[Table 15]**

| | Polymer (parts by mass) | Acid generator (parts by mass) | Base compound (parts by mass) | Solvent (parts by mass) |
|---|---|---|---|---|
| Single layer resist for ArF | RP1 (100) | PAG1 (6.6) | Amine1 (0.8) | PGMEA (2500) |

The polymer (RP1), acid generator (PAG1), and base compound (Amine1) used for the resist upper layer film material (single layer resist for ArF) are shown below.

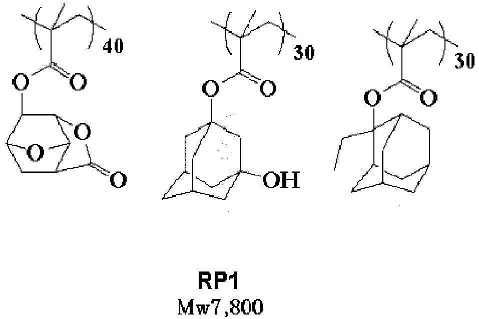

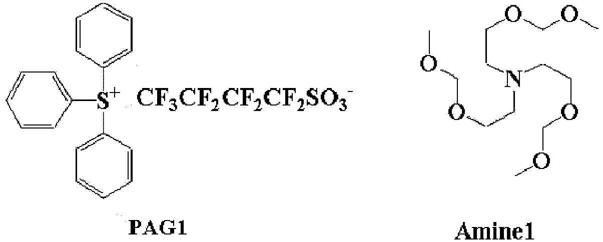

Then, the film was exposed by using an ArF immersion exposure apparatus (manufactured by NIKON CORPORATION; NSR-S610C, NA 1.30, σ 0.92/0.74, 35° cross pole, 6% halftone phase-shifting mask), baked at 100°C for 60 seconds (PEB), and developed with a 2.38 mass% aqueous solution of tetramethylammonium hydroxide (TMAH) for 30 seconds to obtain a positive-type line-and-space pattern (resist pattern) of 1:1 with 100 nm.

Then, while using the resist pattern as a mask, the silicon atom-containing resist middle layer film material (SOG-1) were processed by dry etching using an etching apparatus CE-300I, manufactured by ULVAC, Inc., to form a hard mask pattern. While using the obtained SOG-1 pattern as a mask, the metal oxide film was etched to form a metal oxide film pattern. While using the obtained metal oxide film pattern as a mask, the SiO₂ film was processed by etching. The etching conditions are shown as follows.
The condition of transferring the resist pattern to the silicon atom-containing resist middle layer material (SOG-1)
   Dry etching condition with CF₄ gas
   Pressure: 1 Pa
   Antenna RF power: 100 W
   Bias RF power: 15 W
   CF₄ gas flow rate: 15 sccm
   Time: 60 sec
The condition of transferring the silicon atom-containing resist middle layer material (SOG-1) pattern to the metal oxide film
   Dry etching condition with Cl₂ gas
   Pressure: 1 Pa
   Antenna RF power: 320 W
   Bias RF power: 30 W
   Cl₂ gas flow rate: 25 sccm
   Time: 1200 sec
The condition of transferring the metal oxide film pattern to the SiO₂ film
Dry etching condition with CF₄ gas
   Pressure: 1 Pa
   Antenna RF power: 100 W
   Bias RF power: 15 W
   CF₄ gas flow rate: 15 sccm
   Time: 450 sec

Table 16 shows results of the observation of a cross section of the pattern with an electron microscope (S-4700), manufactured by Hitachi, Ltd.

**[Table 16]**

| | Composition for forming metal oxide film | (A) content | (B) content | After substrate-transferring etching |
|---|---|---|---|---|
| | | % | % | Pattern shape |
| Example 5-1 | UDL-1 | 6% | 15% | Vertical |
| Example 5-2 | UDL-2 | 6% | 15% | Vertical |
| Example 5-3 | UDL-3 | 6% | 15% | Vertical |
| Example 5-4 | UDL-4 | 6% | 15% | Vertical |
| Example 5-5 | UDL-5 | 6% | 15% | Vertical |
| Example 5-6 | UDL-6 | 6% | 15% | Vertical |
| Example 5-7 | UDL-7 | 6% | 15% | Vertical |
| Example 5-8 | UDL-8 | 6% | 15% | Vertical |
| Example 5-9 | UDL-9 | 6% | 15% | Vertical |
| Example 5-10 | UDL-10 | 6% | 15% | Vertical |
| Example 5-11 | UDL-11 | 10% | 10% | Vertical |
| Comparative Example 5-1 | Comparative UDL-1 | 6% | 15% | Pattern collapsed |
| Comparative Example 5-2 | Comparative UDL-2 | 6% | 15% | Pattern twisted |
| Comparative Example 5-3 | Comparative UDL-6 | 6% | 15% | Pattern twisted |
| Comparative Example 5-4 | Comparative UDL-9 | 0% | 20% | Pattern twisted |
| Comparative Example 5-5 | Comparative UDL-10 | 11% | 0% | Pattern twisted |

As shown in Table 16, in any of Examples 5-1 to 5-11, which used the inventive compositions for forming a metal oxide film (UDL-1 to 11), the resist upper layer film pattern was finally transferred favorably to the substrate, and the formation of the line-and-space pattern with 1 um in depth was possible. That is, it has been confirmed that the inventive composition for forming a metal oxide film is suitably used for the fine processing with the multilayer resist method.

Meanwhile, in Comparative Example 5-1, which used Comparative UDL-1 confirmed to have insufficient adhesiveness to the substrate in the evaluation of filling property, the pattern was collapsed during the pattern processing, and failed to finally obtain a good pattern. In Comparative Examples 5-2 to 5-5, which used Comparative UDL-2, 6, 9, and 10 confirmed to have insufficient performance in the evaluation of the dry etching resistance, the pattern shape was twisted during the pattern processing and failed to finally obtain a good pattern.

### [Method of Reversing SOC Pattern (Examples of 6-1 to 6-11 and Comparative Examples 6-1 to 6-6)]

On a silicon wafer substrate on which a 2000-nm SiO₂ film was formed, a coating-type organic underlayer material (SOC-1) was applied as a resist underlayer film, and baked at 350°C for 60 seconds to form a resist underlayer film with 1500 nm in film thickness. A silicon atom-containing resist middle layer material (SOG-1) was applied thereon, and baked at 220°C for 60 seconds to form a resist middle layer film with 45 nm in film thickness. A single layer resist for ArF of a resist upper layer film material was applied thereon, and baked at 105°C for 60 seconds to form a photoresist film with 100 nm in film thickness. A protective film material for immersion (TC-1) was applied on the photoresist film, and baked at 90°C for 60 seconds to form a protective film with 50 nm in film thickness.

Used for the resist upper layer film material (single layer resist for ArF) was the same material as in the above patterning process (Example 5).

The coating-type organic underlayer film material (SOC-1) was prepared as follows. A resist underlayer film polymer (SOP1) was dissolved in an organic solvent containing 0.5 mass% of FC-4430 (manufactured by Sumitomo 3M Limited.) at a ratio shown in Table 17, and the solution was filtered with a filter made of a fluororesin having a pore diameter of 0.2 um to prepare the coating-type organic underlayer material (SOC-1).

**[Table 17]**

| | Polymer | Organic solvent |
|---|---|---|
| | (parts by mass) | (parts by mass) |
| SOC-1 | SOP1 (25) | Propylene glycol monoethyl ether (75) |

Table 18 shows a structural formula of the used polymer for a resist underlayer film (SOP 1).

**[Table 18]**

| Compound or polymer | Mw | Mw/Mn |
|---|---|---|
| 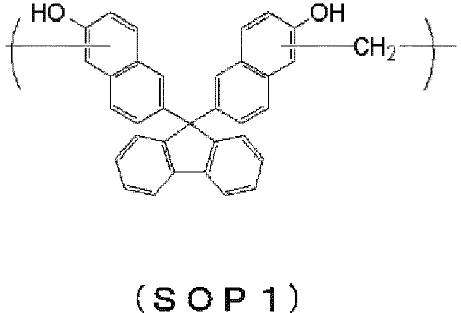 | 3700 | 2.82 |

The silicon atom-containing resist middle layer material (SOG-1) was prepared as follows. A silicon-containing middle layer film polymer for ArF (SiP1) and a crosslinking catalyst (CAT1) were dissolved in an organic solvent containing 0.1 mass% of FC-4430 (manufactured by Sumitomo 3M Limited.) at a ratio shown in Table 19, and the solution was filtered with a filter made of a fluororesin having a pore diameter of 0.1 um to prepare the silicon atom-containing resist middle layer material (SOG-1).

**[Table 19]**

| | Polymer | Thermally crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The structural formulae of the used silicon-containing middle layer film polymer for ArF (SiP1) and crosslinking catalyst (CAT1) are shown below.

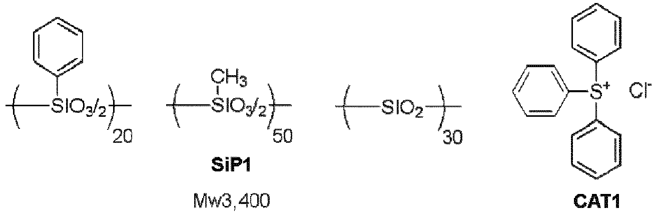

Then, the film was exposed by using an ArF immersion exposure apparatus (manufactured by NIKON CORPORATION; NSR-S610C, NA 1.30, σ 0.92/0.74, 35° cross pole, 6% halftone phase-shifting mask), baked at 100°C for 60 seconds (PEB), and developed with a 2.38 mass% aqueous solution of tetramethylammonium hydroxide (TMAH) for 30 seconds to obtain a positive-type line-and-space pattern (resist pattern) of 1:1 with 100 nm.

Subsequently, the silicon atom-containing resist middle layer material (SOG-1) was processed by dry etching while using the resist pattern as a mask using an etching apparatus "Telius", manufactured by Tokyo Electron Ltd, to form a hard mask pattern. While using the obtained hard mask pattern as a mask, the resist underlayer film (SOC-1) was etched to form a SOC-1 film pattern. The etching conditions are shown as follows.
The condition of transferring the resist pattern to the silicon atom-containing resist middle layer material (SOG-1)
   Chamber pressure: 50 mT
   RF power (upper part): 500 W
   RF power (lower part): 300 W
   CF₄ gas flow rate: 150 sccm
   CHF₃ gas flow rate: 50 sccm
   Time: 20 sec
The condition of transferring the silicon atom-containing resist middle layer material (SOG-1) pattern to the resist underlayer film (SOC-1)
   Chamber pressure: 10 mT
   RF power (upper part): 1,000 W
   RF power (lower part): 300 W
   CO₂ gas flow rate: 150 sccm
   CO gas flow rate: 50 sccm
   N₂ gas flow rate: 50 sccm
   H₂ gas flow rate: 150 sccm
   Time: 600 sec

Subsequently, on the obtained SOC-1 film pattern, each of the above compositions for forming a metal oxide film (UDL-1 to 11 and Comparative UDL-1, 2, 6, 9, and 10) was applied, and backed in the atmosphere at 350°C for 60 seconds to form a metal oxide film with 1000 nm in film thickness. Thereafter, the metal oxide film covering the SOC-1 film pattern was etched to uncover an upper surface of the SOC-1 film pattern. The SOG-1 film remained on the SOC-1 film pattern surface having the uncovered upper surface was removed by etching. Then, the uncovered SOC-1 was removed by etching for reversing the pattern to the metal oxide film. While using the obtained metal oxide film pattern as a mask, the SiO₂ film was processed by etching. As Comparative Example, the SiO₂ film was etched while using the SOC-1 film pattern as a mask without the composition for forming a metal oxide film (Comparative Example 6-6). The etching conditions are shown as follows.

Etching back of the metal oxide film (uncovering the SOC-1 film pattern)
   Pressure: 1 Pa
   Antenna RF power: 320 W
   Bias RF power: 30 W
   Cl₂ gas flow rate: 25 sccm
   Time: 300 sec
Removal of the silicon atom-containing resist middle layer material (SOG-1) from the SOC-1 film pattern
   Pressure: 1 Pa
   Antenna RF power: 100 W
   Bias RF power: 15 W
   CF₄ gas flow rate: 15 sccm
   Time: 60 sec
Removal of the SOC-1 film pattern
   Pressure: 1 Pa
   Antenna RF power: 300 W
   Bias RF power: 0 W
   O₂ gas flow rate: 25 sccm
   Time: 500 sec
The condition of transferring the metal oxide film pattern to the SiO₂ film
   Pressure: 1 Pa
   Antenna RF power: 100 W
   Bias RF power: 15 W
   CF₄ gas flow rate: 15 sccm
   Time: 900 sec
   Comparative Example 6-6: The condition of transferring the SOC-1 film pattern to the SiO₂ film
   Pressure: 1 Pa
   Antenna RF power: 100 W
   Bias RF power: 15 W
   CF₄ gas flow rate: 15 sccm
   Time: 900 sec

Table 20 shows results of the observation of a cross section of the pattern with an electron microscope (S-4700), manufactured by Hitachi, Ltd.

**[Table 20]**

| | Composition for forming metal oxide film | (A) content | (B) content | After substrate-transferring etching |
|---|---|---|---|---|
| | | % | % | Pattern shape |
| Example 6-1 | UDL-1 | 6% | 15% | Vertical |
| Example 6-2 | UDL-2 | 6% | 15% | Vertical |
| Example 6-3 | UDL-3 | 6% | 15% | Vertical |
| Example 6-4 | UDL-4 | 6% | 15% | Vertical |
| Example 6-5 | UDL-5 | 6% | 15% | Vertical |
| Example 6-6 | UDL-6 | 6% | 15% | Vertical |
| Example 6-7 | UDL-7 | 6% | 15% | Vertical |
| Example 6-8 | UDL-8 | 6% | 15% | Vertical |
| Example 6-9 | UDL-9 | 6% | 15% | Vertical |
| Example 6-10 | UDL-10 | 6% | 15% | Vertical |
| Example 6-11 | UDL-11 | 10% | 10% | Vertical |
| Comparative Example 6-1 | Comparative UDL-1 | 6% | 15% | Pattern collapsed |
| Comparative Example 6-2 | Comparative UDL-2 | 6% | 15% | No pattern |
| Comparative Example 6-3 | Comparative UDL-6 | 6% | 15% | No pattern |
| Comparative Example 6-4 | Comparative UDL-9 | 0% | 20% | No pattern |
| Comparative Example 6-5 | Comparative UDL-10 | 11% | 0% | No pattern |
| Comparative Example 6-6 | None | - | - | Pattern twisted |

As shown in Table 20, any of Examples 6-1 to 6-11, which used the inventive compositions for forming a metal oxide film (UDL-1 to 11), precisely reversed the SOC-1 film pattern, and the reversed pattern was finally transferred favorably to the substrate without pattern collapse. From these results, it has been confirmed that the inventive composition for forming a metal oxide film is suitably used for fine processing using the tone-reversing etching method in the multilayer resist process method. Meanwhile, in Comparative Example 6-6, which transferred the SOC-1 film pattern directly to the SiO₂ film, the SOC-1 film had insufficient etching resistance, and thereby the twisted pattern shape was observed. Comparative Example 6-1, which was confirmed to have insufficient adhesiveness to the substrate in the evaluation of filling property, the pattern was collapsed during the pattern processing, and failed to finally obtain a good reversed pattern. In Comparative Examples 6-2 to 6-5, which were confirmed to have insufficient performance in the evaluation of the dry etching resistance, the pattern formation was failed presumably due to the insufficient etching selectivity rate to the SOC-1 film.

From the above results, it has been revealed that the inventive composition for forming a metal oxide film has excellent storage stability and can form a thick film having excellent cracking resistance, and is extremely useful as the resist underlayer film material used for the multilayer resist method and as the reversing agent used for the tone-reversing etching method because having both of high filling property and dry etching resistance. It has been also revealed that the inventive patterning process using this composition can form a fine pattern with high precision even on a substrate having a stepped body to be processed.

## Claims

1. A composition for forming a metal oxide film, comprising:
(A) a metal oxide nanoparticle;
(B) a flowability accelerator containing a resin having a structural unit represented by the following general formula (1);
(C) a dispersion stabilizer having two or more benzene rings or having one benzene ring and a structure represented by the following general formula (C-1), and the dispersion stabilizer being composed of an aromatic group-containing compound having a molecular weight represented by a molecular formula of 500 or less; and
(D) an organic solvent,
wherein the flowability accelerator (B) has a content of 9 mass% or more in an entirety of the composition, a ratio Mw/Mn of a weight-average molecular weight Mw and a number-average molecular weight Mn of the flowability accelerator (B) in terms of polystyrene by a gel permeation chromatography method is 2.50 ≤ Mw/Mn ≤ 9.00, and the flowability accelerator (B) contains no compound nor polymer having a cardo structure, 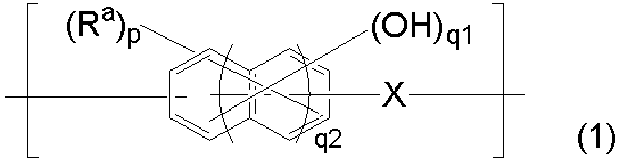
wherein R^{a} represents a saturated monovalent organic group having 1 to 30 carbon atoms or an unsaturated monovalent organic group having 2 to 30 carbon atoms; X represents a divalent organic group having 1 to 30 carbon atoms; "p" represents an integer of 0 to 5; "q₁" represents an integer of 1 to 6; "p+q₁" represents an integer of 1 or more and 6 or less; and "q₂" represents 0 or 1, 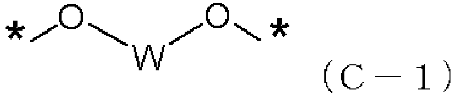
wherein "*" represents a bonding position; and W represents an organic group having 1 to 4 carbon atoms.

2. The composition for forming a metal oxide film according to claim 1, wherein the flowability accelerator (B) contains the resin having a structural unit represented by the following general formula (2) in addition to the resin having the structural unit represented by the general formula (1); or the flowability accelerator (B) is a resin having both of the structural unit represented by the general formula (1) and the structural unit represented by the following general formula (2), 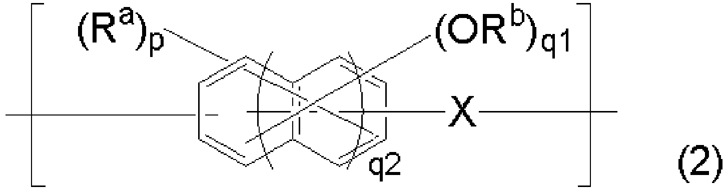 wherein R^{a} represents a saturated monovalent organic group having 1 to 30 carbon atoms or an unsaturated monovalent organic group having 2 to 30 carbon atoms; R^{b} represents a saturated hydrocarbon group having 1 to 30 carbon atoms or an unsaturated hydrocarbon group having 2 to 10 carbon atoms; X represents a divalent organic group having 1 to 30 carbon atoms; "p" represents an integer of 0 to 5; "q₁" represents an integer of 1 to 6; "p+q₁" represents an integer of 1 or more and 6 or less; and "q₂" represents 0 or 1.

3. The composition for forming a metal oxide film according to claim 2, wherein
in the general formula (2), R^{b} represents any one of an alkyl group having 1 to 30 carbon atoms or a structure represented by the following general formula (3), and a content of the general formula (2) satisfies relationships of a + b = 1 and 0.2 ≤ b ≤ 0.8, where "a" represents a proportion of the general formula (1) and "b" represents a proportion of the general formula (2), 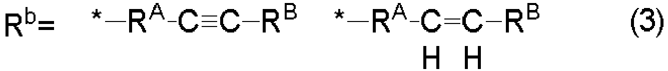
wherein "*" represents a bonding position to the oxygen atom; R^{A} represents a divalent organic group having 1 to 10 carbon atoms and optionally having a substituent; and R^{B} represents a hydrogen atom or a monovalent organic group having 1 to 10 carbon atoms and optionally having a substituent.

4. The composition for forming a metal oxide film according to any one of claims 1 to 3, wherein the dispersion stabilizer (C) has a weight reduction rate of less than 30% on a temperature change from 30°C to 190°C, and has a weight reduction rate of 98% or more on a temperature change from 30°C to 350°C.

5. The composition for forming a metal oxide film according to any one of claims 1 to 4, wherein the dispersion stabilizer (C) contains one or more compounds selected from the following general formulae (I) to (III), 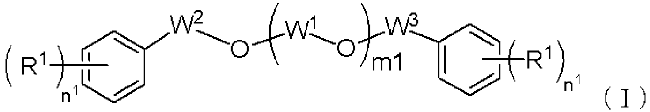
wherein R¹ each independently represents a hydrogen atom, a hydroxy group, or an organic group having 1 to 10 carbon atoms and optionally having a substituent; W¹ represents a phenylene group or a divalent group represented by the following general formula (I-1); each of W² and W³ represents a single bond or any one divalent group represented by the following general formula (I-2); "m¹" represent an integer of 1 to 10; and "n¹" represents an integer of 0 to 5, 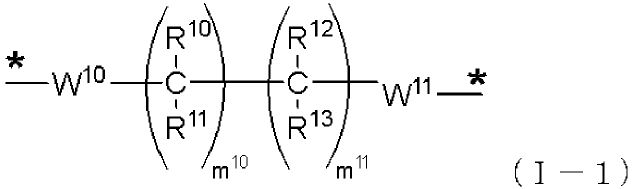
wherein "*" represents a bonding position; each of R¹⁰, R¹¹, R¹², and R¹³ represents a hydrogen atom, a hydroxy group, or an organic group having 1 to 10 carbon atoms; W¹⁰ and W¹¹ each independently represent a single bond or a carbonyl group; each of "m¹⁰" and "m¹¹" represents an integer of 0 to 10; and m¹⁰ ₊ m¹¹ >_ 1, 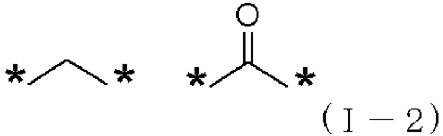
wherein "*" represents a bonding position, 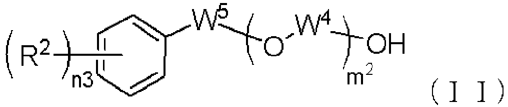
wherein R² each independently represents a hydrogen atom or an organic group having 1 to 10 carbon atoms and optionally having a substituent; W⁴ represents any one divalent group represented by the following general formula (II-1); W⁵ represents a single bond or a divalent group represented by the following general formula (II-2); "m²" represents an integer of 2 to 10; and "n³" represents an integer of 0 to 5, 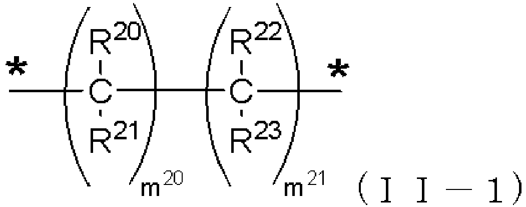
wherein "*" represents a bonding position; each of R²⁰, R²¹, R²², and R²³ represents a hydrogen atom, a hydroxy group, or an organic group having 1 to 10 carbon atoms; each of "m²⁰" and "m²¹" represent an integer of 0 to 10; and m²⁰ + m²¹ ≥ 1, 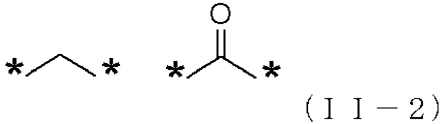
wherein "*" represents a bonding position, 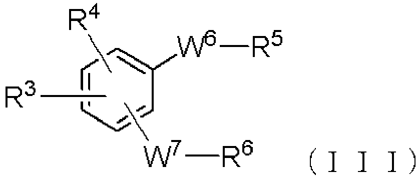
wherein each of R³ and R⁴ represents a hydrogen atom, a hydroxy group, or an organic group having 1 to 10 carbon atoms and optionally having a substituent, and R³ and R⁴ are optionally bonded to each other to form a cyclic structure; each of R⁵ and R⁶ represents an organic group having 1 to 10 carbon atoms, and R⁵ represents a group having any one of an aromatic ring or a divalent group represented by the following general formula (III-1); and each of W⁶ and W⁷ represents a single bond or any one divalent group represented by the following general formula (III-2), and at least one of W⁶ and W⁷ represents the divalent group represented by the following general formula (III-2), 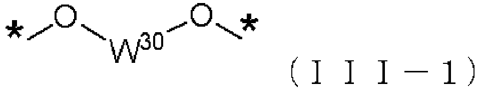
wherein "*" represents a bonding position; and W³⁰ represents an organic group having 1 to 4 carbon atoms, 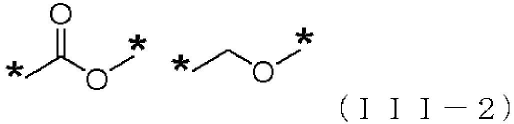
wherein "*" represents a bonding position.

6. The composition for forming a metal oxide film according to any one of claims 1 to 5, wherein the metal oxide nanoparticle (A) is one or more kinds of an oxide nanoparticle of a metal selected from the group consisting of zirconium, hafnium, aluminum, tungsten, titanium, copper, tin, cerium, indium, zinc, yttrium, lanthanum, chromium, cobalt, platinum, iron, antimony, and germanium.

7. The composition for forming a metal oxide film according to claim 6, wherein the metal oxide nanoparticle (A) is one or more of metal oxide nanoparticles selected from the group consisting of a zirconium oxide nanoparticle, a hafnium oxide nanoparticle, a tungsten oxide nanoparticle, a titanium oxide nanoparticle, and a tin oxide nanoparticle.

8. The composition for forming a metal oxide film according to any one of claims 1 to 7, wherein the metal oxide nanoparticle (A) has an average primary particle diameter of 100 nm or less.

9. The composition for forming a metal oxide film according to any one of claims 1 to 8, wherein a weight ratio between the metal oxide nanoparticle (A) and the flowability accelerator (B) is 80/20 to 10/90.

10. The composition for forming a metal oxide film according to any one of claims 1 to 9, further comprising one or more of a crosslinker, a surfactant, and an acid generator.

11. A patterning process for forming a pattern on a substrate to be processed, comprising steps of:
(I-1) applying the composition for forming a metal oxide film according to any one of claims 1 to 10 onto a substrate to be processed, and then heat-treating the composition to form a metal oxide film;
(I-2) forming a resist upper layer film on the metal oxide film by using a photoresist material;
(I-3) subjecting the resist upper layer film to pattern exposure, and then to development with a developer to form a pattern in the resist upper layer film;
(I-4) transferring the pattern to the metal oxide film by dry etching while using the resist upper layer film having the formed pattern as a mask; and
(I-5) processing the substrate to be processed while using the metal oxide film having the formed pattern as a mask to form the pattern on the substrate to be processed, or
a patterning process for forming a pattern on a substrate to be processed, comprising steps of:
(II-1) applying the composition for forming a metal oxide film according to any one of claims 1 to 10 onto a substrate to be processed, and then heat-treating the composition to form a metal oxide film;
(II-2) forming a silicon-containing resist middle layer film on the metal oxide film by using a silicon-containing resist middle layer film material;
(II-3) forming a resist upper layer film on the silicon-containing resist middle layer film by using a photoresist material;
(II-4) subjecting the resist upper layer film to pattern exposure, and then to development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal oxide film by dry etching while using the silicon-containing resist middle layer film having the transferred pattern as a mask; and
(II-7) processing the substrate to be processed while using the metal oxide film having the formed pattern as a mask to form the pattern on the substrate to be processed, or
a patterning process for forming a pattern on a substrate to be processed, comprising steps of:
(III-1) applying the composition for forming a metal oxide film according to any one of claims 1 to 10 onto a substrate to be processed, and then heat-treating the composition to form a metal oxide film;
(III-2) forming an inorganic hard mask middle layer film selected from a silicon oxide film, a silicon nitride film, and a silicon oxynitride film on the metal oxide film;
(III-3) forming an organic thin film on the inorganic hard mask middle layer film;
(III-4) forming a resist upper layer film on the organic thin film by using a photoresist material;
(III-5) subjecting the resist upper layer film to pattern exposure, and then to development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal oxide film by dry etching while using the inorganic hard mask middle layer film having the transferred pattern as a mask; and
(III-8) processing the substrate to be processed while using the metal oxide film having the formed pattern as a mask to form the pattern on the substrate to be processed, or
a patterning process for forming a pattern on a substrate to be processed, comprising steps of:
(IV-1) forming a resist underlayer film on a substrate to be processed;
(IV-2) forming: a resist middle layer film; or a combination of an inorganic hard mask middle layer film and an organic thin film on the resist underlayer film, the inorganic hard mask middle layer film being selected from a silicon oxide film, a silicon nitride film, and a silicon oxynitride film;
(IV-3) forming a resist upper layer film on the resist middle layer film or on the combination of the inorganic hard mask middle layer film and the organic thin film by using a photoresist material;
(IV-4) subjecting the resist upper layer film to pattern exposure, and then to development with a developer to form a pattern in the resist upper layer film;
(IV-5) transferring the pattern to the resist middle layer film or to the organic thin film and the inorganic hard mask middle layer film by dry etching while using the resist upper layer film having the formed pattern as a mask;
(IV-6) transferring the pattern to the resist underlayer film by dry etching while using the resist middle layer film or the inorganic hard mask middle layer film having the transferred pattern as a mask;
(IV-7) applying the composition for forming a metal oxide film according to any one of claims 1 to 10 onto the resist underlayer film having the formed pattern, heat-treating the composition to cover the metal oxide film and fill a gap of the resist underlayer film pattern with the metal oxide film;
(IV-8) etching back the metal oxide film covering the resist underlayer film having the formed pattern by a chemical stripper or dry etching, the metal oxide film so as to have an uncovered upper surface of the resist underlayer film having the formed pattern;
(IV-9) removing the resist middle layer film or the inorganic hard mask middle layer film remained on the upper surface of the resist underlayer film by dry etching;
(IV-10) removing the resist underlayer film having the uncovered surface and the formed pattern by dry etching to form a reversed pattern to the original pattern on the metal oxide film; and
(IV-11) processing the substrate to be processed while using the metal oxide film having the formed reversed pattern as a mask to form a tone-reversed pattern on the substrate to be processed, or
a patterning process using a composition for forming a metal oxide film as a sacrificial film, comprising steps of:
(V-1) applying the composition for forming a metal oxide film according to any one of claims 1 to 10 onto a substrate to be processed having a structure or a step, then heat-treating the composition to fill a metal oxide film;
(V-2) removing the metal oxide film outside the structure or the step on the substrate to be processed by a CMP method to remove the metal oxide from a surface of the substrate to be processed;
(V-3) alternately stacking an insulative film and a conductive film on the substrate to be processed filled with the metal oxide film;
(V-4) forming an organic resist underlayer film on a stacked film of the insulative film and the conductive film formed on the substrate to be processed filled with the metal oxide film;
(V-5) forming a resist middle layer film, or an inorganic hard mask middle layer film, or a combination of the inorganic hard mask middle layer film and an organic thin film on the organic resist underlayer film, the inorganic hard mask middle layer film being selected from a silicon oxide film, a silicon nitride film, and a silicon oxynitride film;
(V-6) forming a resist upper layer film on the resist middle layer film, or on the inorganic hard mask middle layer film, or on the combination of the inorganic hard mask middle layer film and the organic thin film by using a photoresist material;
(V-7) subjecting the resist upper layer film to pattern exposure, and then development with a developer to form a pattern in the resist upper layer film;
(V-8) transferring the pattern to the resist middle layer film, or to the inorganic hard mask middle layer film, or to the organic thin film and the inorganic hard mask middle layer film by dry etching while using the resist upper layer film having the formed pattern as a mask;
(V-9) transferring the pattern to the resist underlayer film by dry etching while using the resist middle layer film or the inorganic hard mask middle layer film having the transferred pattern as a mask;
(V-10) transferring the pattern to the stacked film of the insulative film and the conductive film by dry etching while using the resist underlayer film having the transferred pattern as a mask; and
(V-11) removing the metal oxide film filled on the substrate to be processed while using the stacked film of the insulative film and the conductive film having the transferred pattern as a mask.

12. The patterning process according to claim 11, wherein a substrate having a structure or step having an aspect ratio of 5 or more is used as the substrate to be processed.

13. A method for forming a metal oxide film functioning as a planarizing film used in a semiconductor apparatus manufacturing process, the method comprising:
applying the composition for forming a metal oxide film according to any one of claims 1 to 10 onto a substrate to be processed; and
heat-treating the substrate within a range of a temperature of 100°C or higher and 600°C or lower for 10 to 600 seconds to form a cured film, or
a method for forming a metal oxide film functioning as a planarizing film used in a semiconductor apparatus manufacturing process, the method comprising:
applying the composition for forming a metal oxide film according to any one of claims 1 to 10 onto a substrate to be processed; and
heat-treating the substrate in an atmosphere with an oxygen concentration of 1 vol% or more and 21 vol% or less to form a cured film, or
a method for forming a metal oxide film functioning as a planarizing film used in a semiconductor apparatus manufacturing process, the method comprising:
applying the composition for forming a metal oxide film according to any one of claims 1 to 10 on a substrate to be processed; and
heat-treating the substrate in an atmosphere with an oxygen concentration of less than 1 vol% to form a cured film.

## Patentansprüche

1. Zusammensetzung zur Bildung eines Metalloxidfilms, umfassend:
(A) ein Metalloxid-Nanopartikel;
(B) einen Fließfähigkeitsbeschleuniger, der ein Harz mit einer Struktureinheit der folgenden allgemeinen Formel (1) enthält;
(C) einen Dispersionsstabilisator mit zwei oder mehr Benzolringen oder mit einem Benzolring und einer Struktur, die durch die folgende allgemeine Formel (C-1) dargestellt wird, und wobei der Dispersionsstabilisator aus einer aromatische Gruppen enthaltenden Verbindung mit einem Molekulargewicht, das durch eine Molekularformel von 500 oder weniger dargestellt wird, besteht; und
(D) ein organisches Lösungsmittel,
wobei der Fließfähigkeitsbeschleuniger (B) einen Gehalt von 9 Massen-% oder mehr in der Gesamtheit der Zusammensetzung aufweist, ein Verhältnis Mw/Mn eines gewichtsmittleren Molekulargewichts Mw und eines zahlenmittleren Molekulargewichts Mn des Fließfähigkeitsbeschleunigers (B) in Bezug auf Polystyrol, durch ein Gelpermeationschromatographieverfahren, 2,50≤ Mw/Mn ≤ 9,00 beträgt und der Fließfähigkeits-Beschleuniger (B) keine Verbindung und kein Polymer mit einer Cardo-Struktur enthält, 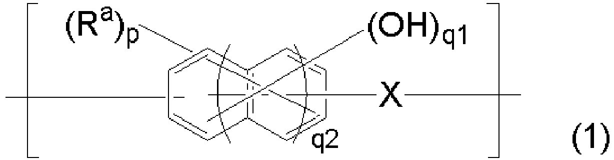
worin R^{a} eine gesättigte monovalente organische Gruppe mit 1 bis 30 Kohlenstoffatomen oder eine ungesättigte monovalente organische Gruppe mit 2 bis 30 Kohlenstoffatomen darstellt; X eine divalente organische Gruppe mit 1 bis 30 Kohlenstoffatomen darstellt; "p" eine ganze Zahl von 0 bis 5 darstellt; "q₁" eine ganze Zahl von 1 bis 6 darstellt; "p+q₁" eine ganze Zahl von 1 oder mehr und 6 oder weniger darstellt; und "q₂" 0 oder 1 darstellt, 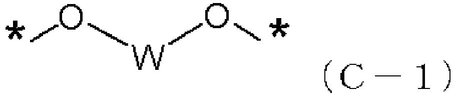
wobei "*" eine Bindungsposition darstellt; und W eine organische Gruppe mit 1 bis 4 Kohlenstoffatomen darstellt.

2. Zusammensetzung zur Bildung eines Metalloxidfilms nach Anspruch 1, wobei der Fließfähigkeitsbeschleuniger (B) das Harz mit einer Struktureinheit, die durch die folgende allgemeine Formel (2) dargestellt wird, zusätzlich zu dem Harz mit der Struktureinheit, die durch die allgemeine Formel (1) dargestellt wird, enthält; oder der Fließfähigkeitsbeschleuniger (B) ein Harz ist, das sowohl die durch die allgemeine Formel (1) dargestellte Struktureinheit als auch die durch die folgende allgemeine Formel (2) dargestellte Struktureinheit aufweist, 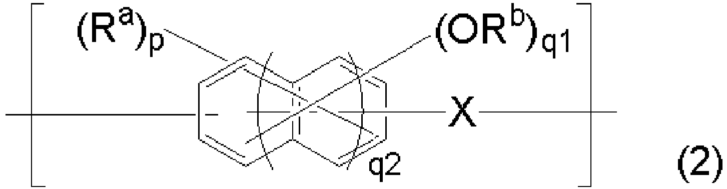 worin R^{a} eine gesättigte monovalente organische Gruppe mit 1 bis 30 Kohlenstoffatomen oder eine ungesättigte monovalente organische Gruppe mit 2 bis 30 Kohlenstoffatomen darstellt; R^{b} eine gesättigte Kohlenwasserstoffgruppe mit 1 bis 30 Kohlenstoffatomen oder eine ungesättigte Kohlenwasserstoffgruppe mit 2 bis 10 Kohlenstoffatomen darstellt; X eine zweiwertige organische Gruppe mit 1 bis 30 Kohlenstoffatomen darstellt; "p" eine ganze Zahl von 0 bis 5 darstellt; "q₁" eine ganze Zahl von 1 bis 6 darstellt; "p+q₁" eine ganze Zahl von 1 oder mehr und 6 oder weniger darstellt; und "q₂" 0 oder 1 darstellt.

3. Zusammensetzung zur Bildung eines Metalloxidfilms nach Anspruch 2, wobei
in der allgemeinen Formel (2) R^{b} eine beliebige Alkylgruppe mit 1 bis 30 Kohlenstoffatomen oder eine durch die folgende allgemeine Formel (3) dargestellte Struktur darstellt, und ein Gehalt der allgemeinen Formel (2) die Beziehungen a + b = 1 und 0,2 ≤ b ≤ 0,8 erfüllt, wobei "a" einen Anteil der allgemeinen Formel (1) und "b" einen Anteil der allgemeinen Formel (2) darstellt, 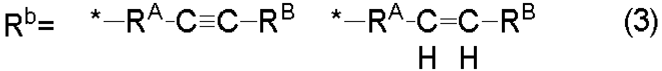
worin "*" eine Bindungsposition zum Sauerstoffatom darstellt; R^{A} eine zweiwertige organische Gruppe mit 1 bis 10 Kohlenstoffatomen und gegebenenfalls einem Substituenten darstellt; und R^{B} ein Wasserstoffatom oder eine einwertige organische Gruppe mit 1 bis 10 Kohlenstoffatomen und gegebenenfalls einem Substituenten darstellt.

4. Zusammensetzung zur Bildung eines Metalloxidfilms nach einem der Ansprüche 1 bis 3, wobei der Dispersionsstabilisator (C) eine Gewichtsreduktionsrate von weniger als 30 % bei einer Temperaturänderung von 30°C bis 190°C und eine Gewichtsreduktionsrate von 98 % oder mehr bei einer Temperaturänderung von 30°C bis 350°C aufweist.

5. Zusammensetzung zur Bildung eines Metalloxidfilms nach einem der Ansprüche 1 bis 4, wobei der Dispersionsstabilisator (C) eine oder mehrere Verbindungen enthält, die aus den folgenden allgemeinen Formeln (I) bis (III) ausgewählt sind, 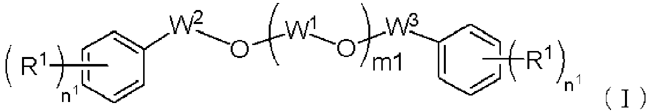
worin R¹ jeweils unabhängig ein Wasserstoffatom, eine Hydroxygruppe oder eine organische Gruppe mit 1 bis 10 Kohlenstoffatomen und gegebenenfalls einem Substituenten darstellt; W¹ eine Phenylengruppe oder eine zweiwertige Gruppe der folgenden allgemeinen Formel (I-1) darstellt; W² und W³ jeweils eine Einfachbindung oder eine beliebige zweiwertige Gruppe der folgenden allgemeinen Formel (I-2) darstellen; "m¹ " eine ganze Zahl von 1 bis 10 darstellt; und "n¹ " eine ganze Zahl von 0 bis 5 darstellt, 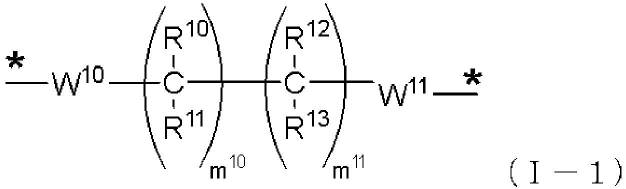
worin "*" eine Bindungsposition darstellt; jedes von R¹⁰ , R¹¹ , R¹² und R¹³ ein Wasserstoffatom, eine Hydroxygruppe oder eine organische Gruppe mit 1 bis 10 Kohlenstoffatomen darstellt; W¹⁰ und W¹¹ jeweils unabhängig eine Einfachbindung oder eine Carbonylgruppe darstellen; jedes von "m¹⁰" und "m¹¹" eine ganze Zahl von 0 bis 10 darstellt; und m¹⁰ ₊ m¹¹ ≥ 1, 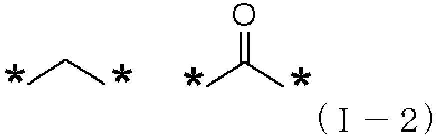
wobei "*" für eine Bindungsstelle steht, 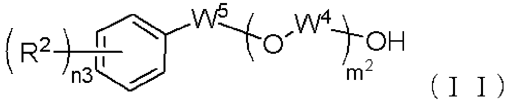
worin R² jeweils unabhängig ein Wasserstoffatom oder eine organische Gruppe mit 1 bis 10 Kohlenstoffatomen und gegebenenfalls einem Substituenten darstellt; W⁴ eine beliebige zweiwertige Gruppe der folgenden allgemeinen Formel (II-1) darstellt; W⁵ eine Einfachbindung oder eine zweiwertige Gruppe der folgenden allgemeinen Formel (II-2) darstellt; "m²" eine ganze Zahl von 2 bis 10 darstellt; und "n³" eine ganze Zahl von 0 bis 5 darstellt, 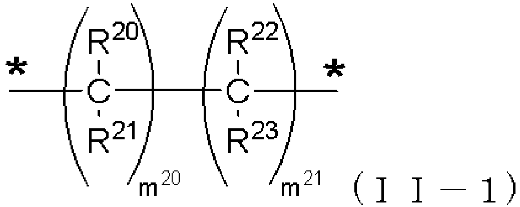
worin "*" eine Bindungsposition darstellt; jedes von R²⁰ , R²¹ , R²² und R²³ ein Wasserstoffatom, eine Hydroxygruppe oder eine organische Gruppe mit 1 bis 10 Kohlenstoffatomen darstellt; jedes von "m²⁰" und "m²¹" eine ganze Zahl von 0 bis 10 darstellt; und m²⁰ + m²¹ ≥ 1, 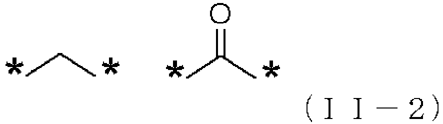
wobei "*" für eine Bindungsstelle steht, 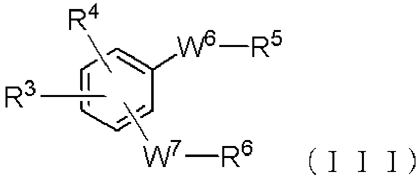
worin jeder der Reste R³ und R⁴ ein Wasserstoffatom, eine Hydroxygruppe oder eine organische Gruppe mit 1 bis 10 Kohlenstoffatomen und gegebenenfalls einem Substituenten darstellt, und R³ und R⁴ gegebenenfalls aneinander gebunden sind, um eine cyclische Struktur zu bilden; jeder der Reste R⁵ und R⁶ eine organische Gruppe mit 1 bis 10 Kohlenstoffatomen darstellt, und R⁵ eine Gruppe mit einem aromatischen Ring oder einer zweiwertigen Gruppe der folgenden allgemeinen Formel (III-1) darstellt; und jedes von W⁶ und W⁷ eine Einfachbindung oder eine beliebige zweiwertige Gruppe der folgenden allgemeinen Formel (III-2) darstellt, und mindestens eines von W⁶ und W⁷ die zweiwertige Gruppe der folgenden allgemeinen Formel (III-2) darstellt, 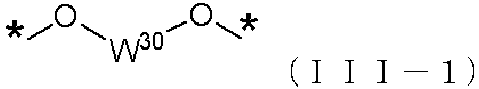
wobei "*" eine Bindungsposition darstellt; und W³⁰ eine organische Gruppe mit 1 bis 4 Kohlenstoffatomen darstellt, 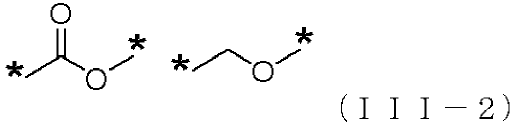
wobei "*" für eine Bindungsstelle steht.

6. Zusammensetzung zur Bildung eines Metalloxidfilms nach einem der Ansprüche 1 bis 5, wobei das Metalloxid-Nanopartikel (A) eine oder mehrere Arten eines Oxid-Nanopartikels eines Metalls ist, das aus der Gruppe ausgewählt ist, die aus Zirkonium, Hafnium, Aluminium, Wolfram, Titan, Kupfer, Zinn, Cer, Indium, Zink, Yttrium, Lanthan, Chrom, Kobalt, Platin, Eisen, Antimon und Germanium besteht.

7. Zusammensetzung zur Bildung eines Metalloxidfilms nach Anspruch 6, wobei das Metalloxid-Nanopartikel (A) ein oder mehrere Metalloxid-Nanopartikel ist, die aus der Gruppe ausgewählt sind, die aus einem Zirkoniumoxid-Nanopartikel, einem Hafniumoxid-Nanopartikel, einem Wolframoxid-Nanopartikel, einem Titanoxid-Nanopartikel und einem Zinnoxid-Nanopartikel besteht.

8. Zusammensetzung zur Bildung eines Metalloxidfilms nach einem der Ansprüche 1 bis 7, wobei das Metalloxid-Nanopartikel (A) einen durchschnittlichen Primärteilchendurchmesser von 100 nm oder weniger aufweist.

9. Zusammensetzung zur Bildung eines Metalloxidfilms nach einem der Ansprüche 1 bis 8, wobei das Gewichtsverhältnis zwischen den Metalloxid-Nanopartikeln (A) und dem Fließfähigkeitsbeschleuniger (B) 80/20 bis 10/90 beträgt.

10. Zusammensetzung zur Bildung eines Metalloxidfilms nach einem der Ansprüche 1 bis 9, die ferner einen oder mehrere Vernetzer, ein Tensid und einen Säurebildner enthält.

11. Strukturierungsverfahren zur Bildung eines Musters auf einem zu bearbeitenden Substrat, der die folgenden Schritte umfasst:
(I-1) Aufbringen der Zusammensetzung zur Bildung eines Metalloxidfilms nach einem der Ansprüche 1 bis 10 auf ein zu bearbeitendes Substrat und anschließende Wärmebehandlung der Zusammensetzung zur Bildung eines Metalloxidfilms;
(I-2) Bildung einer oberen Resistschicht auf dem Metalloxidfilm unter Verwendung eines Photoresistmaterials;
(I-3) Belichtung der oberen Resistschicht mit einem Muster und anschließende Entwicklung mit einem Entwickler zur Bildung eines Musters in der oberen Resistschicht;
(I-4) Übertragen des Musters auf den Metalloxidfilm durch Trockenätzen unter Verwendung des oberen Resistschichtfilms mit dem gebildeten Muster als Maske; und
(I-5) Bearbeiten des zu bearbeitenden Substrats unter Verwendung des Metalloxidfilms mit dem gebildeten Muster als Maske, um das Muster auf dem zu bearbeitenden Substrat zu bilden, oder
ein Strukturierungsverfahren zur Bildung eines Musters auf einem zu bearbeitenden Substrat, der die folgenden Schritte umfasst:
(II-1) Aufbringen der Zusammensetzung zur Bildung eines Metalloxidfilms nach einem der Ansprüche 1 bis 10 auf ein zu bearbeitendes Substrat und anschließende Wärmebehandlung der Zusammensetzung zur Bildung eines Metalloxidfilms;
(II-2) Ausbilden eines siliziumhaltigen Resist-Mittelschichtfilms auf dem Metalloxidfilm unter Verwendung eines siliziumhaltigen Resist-Mittelschichtfilmmaterials;
(II-3) Bilden einer oberen Resistschicht auf der siliziumhaltigen mittleren Resistschicht unter Verwendung eines Photoresistmaterials;
(II-4) Belichtung des oberen Resistschichtfilms mit einem Muster und anschließende Entwicklung mit einem Entwickler, um ein Muster im oberen Resistschichtfilm zu erzeugen;
(II-5) Übertragen des Musters auf die siliziumhaltige mittlere Lackschicht durch Trockenätzen unter Verwendung der oberen Lackschicht mit dem gebildeten Muster als Maske;
(II-6) Übertragen des Musters auf den Metalloxidfilm durch Trockenätzen unter Verwendung des siliziumhaltigen Resist-Mittelschichtfilms mit dem übertragenen Muster als Maske; und
(II-7) Bearbeiten des zu bearbeitenden Substrats unter Verwendung des Metalloxidfilms mit dem gebildeten Muster als Maske, um das Muster auf dem zu bearbeitenden Substrat zu bilden, oder
ein Strukturierungsverfahren zur Bildung eines Musters auf einem zu bearbeitenden Substrat, der die folgenden Schritte umfasst:
(III-1) Aufbringen der Zusammensetzung zur Bildung eines Metalloxidfilms nach einem der Ansprüche 1 bis 10 auf ein zu bearbeitendes Substrat und anschließende Wärmebehandlung der Zusammensetzung zur Bildung eines Metalloxidfilms;
(III-2) Bilden eines anorganischen Hartmasken-Mittelschichtfilms, ausgewählt aus einem Siliziumoxidfilm, einem Siliziumnitridfilm und einem Siliziumoxynitridfilm auf dem Metalloxidfilm ;
(III-3), die einen organischen Dünnfilm auf dem anorganischen Hartmasken-Mittelschichtfilm bildet;
(III-4) Bildung einer oberen Resistschicht auf dem organischen Dünnfilm unter Verwendung eines Photoresistmaterials;
(III-5) Belichtung der oberen Resistschicht mit einem Muster und anschließende Entwicklung mit einem Entwickler zur Bildung eines Musters in der oberen Resistschicht;
(III-6) Übertragen des Musters auf den organischen Dünnfilm und den anorganischen Hartmasken-Mittelschichtfilm durch Trockenätzen unter Verwendung des oberen Resistfilms mit dem gebildeten Muster als Maske;
(III-7) Übertragen des Musters auf den Metalloxidfilm durch Trockenätzen unter Verwendung des anorganischen Hartmasken-Mittelschichtfilms mit dem übertragenen Muster als Maske; und
(III-8) Bearbeiten des zu bearbeitenden Substrats unter Verwendung des Metalloxidfilms mit dem gebildeten Muster als Maske, um das Muster auf dem zu bearbeitenden Substrat zu bilden, oder
ein Strukturierungsverfahren zur Bildung eines Musters auf einem zu bearbeitenden Substrat, der die folgenden Schritte umfasst:
(IV-1) Bildung eines Resist-Unterschichtfilms auf einem zu verarbeitenden Substrat;
(IV-2) Bilden: eines Resist-Mittelschichtfilms; oder einer Kombination eines anorganischen Hartmasken-Mittelschichtfilms und eines organischen Dünnfilms auf dem Resist-Unterschichtfilm, wobei der anorganische Hartmasken-Mittelschichtfilm ausgewählt ist aus einem Siliziumoxidfilm, einem Siliziumnitridfilm und einem Siliziumoxynitridfilm;
(IV-3) Bilden einer oberen Resistschicht auf der mittleren Resistschicht oder auf der Kombination aus der mittleren anorganischen Hartmaskenschicht und der organischen Dünnschicht unter Verwendung eines Photoresistmaterials;
(IV-4) Belichtung der oberen Resistschicht mit einem Muster und anschließende Entwicklung mit einem Entwickler, um ein Muster in der oberen Resistschicht zu erzeugen;
(IV-5) Übertragen des Musters auf die mittlere Res istschicht oder auf die organische Dünnschicht und die mittlere anorganische Hartmaskenschicht durch Trockenätzen unter Verwendung der oberen Resistschicht mit dem gebildeten Muster als Maske;
(IV-6) Übertragen des Musters auf die Resistunterschicht durch Trockenätzen unter Verwendung der Resistmittelschicht oder der anorganischen Hartmaskenmittelschicht mit dem übertragenen Muster als Maske;
(IV-7) Aufbringen der Zusammensetzung zur Bildung eines Metalloxidfilms gemäß einem der Ansprüche 1 bis 10 auf den Resist-Unterschichtfilm mit dem gebildeten Muster, Wärmebehandlung der Zusammensetzung, um den Metalloxidfilm zu bedecken und eine Lücke des Resist-Unterschichtfilmmusters mit dem Metalloxidfilm zu füllen;
(IV-8) Zurückätzen des Metalloxidfilms, der den Resistunterschichtfilm mit dem gebildeten Muster bedeckt, durch einen chemischen Stripper oder Trockenätzen des Metalloxidfilms, so dass eine unbedeckte obere Oberfläche des Resistunterschichtfilms mit dem gebildeten Muster entsteht;
(IV-9) Entfernen der mittleren Resistschicht oder der anorganischen Hartmasken-Mittelschicht, die auf der oberen Oberfläche der unteren Resistschicht verblieben ist, durch Trockenätzen;
(IV-10) Entfernen des Resist-Unterschichtfilms mit der unbedeckten Oberfläche und dem gebildeten Muster durch Trockenätzen, um ein zum ursprünglichen Muster umgekehrtes Muster auf dem Metalloxidfilm zu bilden; und
(IV-11) Bearbeiten des zu bearbeitenden Substrats unter Verwendung des Metalloxidfilms mit dem gebildeten umgekehrten Muster als Maske, um ein tonumgekehrtes Muster auf dem zu bearbeitenden Substrat zu bilden, oder
ein Strukturierungsverfahren unter Verwendung einer Zusammensetzung zur Bildung eines Metalloxidfilms als Opferfilm, das folgende Schritte umfasst:
(V-1) Aufbringen der Zusammensetzung zur Bildung eines Metalloxidfilms nach einem der Ansprüche 1 bis 10 auf ein zu bearbeitendes Substrat mit einer Struktur oder einer Stufe und anschließende Wärmebehandlung der Zusammensetzung, um einen Metalloxidfilm zu bilden;
(V-2) Entfernen der Metalloxidschicht außerhalb der Struktur oder der Stufe auf dem zu bearbeitenden Substrat durch ein CMP-Verfahren, um das Metalloxid von einer Oberfläche des zu bearbeitenden Substrats zu entfernen;
(V-3) abwechselndes Aufbringen einer isolierenden Schicht und einer leitenden Schicht auf das zu bearbeitende Substrat, das mit der Metalloxidschicht gefüllt ist;
(V-4) Ausbilden eines organischen Resist-Unterschichtfilms auf einem gestapelten Film aus dem isolierenden Film und dem leitenden Film, der auf dem mit dem Metalloxidfilm gefüllten zu bearbeitenden Substrat ausgebildet ist;
(V-5) Bilden eines Resist-Mittelschichtfilms oder eines anorganischen Hartmasken-Mittelschichtfilms oder einer Kombination des anorganischen Hartmasken-Mittelschichtfilms und eines organischen Dünnfilms auf dem organischen Resist-Unterschichtfilm, wobei der anorganische Hartmasken-Mittelschichtfilm aus einem Siliziumoxidfilm, einem Siliziumnitridfilm und einem Siliziumoxynitridfilm ausgewählt ist;
(V-6) Bilden einer oberen Resistschicht auf der mittleren Resistschicht oder auf der mittleren anorganischen Hartmaskenschicht oder auf der Kombination aus der mittleren anorganischen Hartmaskenschicht und der organischen Dünnschicht unter Verwendung eines Photoresistmaterials;
(V-7) Belichtung der oberen Resistschicht mit einem Muster und anschließende Entwicklung mit einem Entwickler zur Bildung eines Musters in der oberen Resistschicht;
(V-8) Übertragen des Musters auf den Resist-Mittelschichtfilm oder auf den anorganischen Hartmasken-Mittelschichtfilm oder auf den organischen Dünnfilm und den anorganischen Hartmasken-Mittelschichtfilm durch Trockenätzen unter Verwendung des oberen Resistschichtfilms mit dem gebildeten Muster als Maske;
(V-9) Übertragen des Musters auf die Resistunterschicht durch Trockenätzen unter Verwendung der Resistmittelschicht oder der anorganischen Hartmaskenmittelschicht mit dem übertragenen Muster als Maske;
(V-10) Übertragen des Musters auf den gestapelten Film aus dem isolierenden Film und dem leitenden Film durch Trockenätzen unter Verwendung des Resist-Unterschichtfilms mit dem übertragenen Muster als Maske; und
(V-11) Entfernen des Metalloxidfilms, der auf das zu bearbeitende Substrat gefüllt ist, unter Verwendung des gestapelten Films aus dem isolierenden Film und dem leitenden Film mit dem übertragenen Muster als Maske.

12. Strukturierungsverfahren nach Anspruch 11, wobei ein Substrat mit einer Struktur oder Stufe mit einem Seitenverhältnis von 5 oder mehr als das zu bearbeitende Substrat verwendet wird.

13. Verfahren zur Herstellung eines Metalloxidfilms, der als Planarisierungsfilm in einem Halbleitervorrichtungsherstellungsprozess verwendet wird, wobei das Verfahren umfasst:
Aufbringen der Zusammensetzung zur Bildung eines Metalloxidfilms nach einem der Ansprüche 1 bis 10 auf ein zu bearbeitendes Substrat; und
Wärmebehandlung des Substrats in einem Temperaturbereich von 100°C oder höher und 600°C oder niedriger für 10 bis 600 Sekunden, um einen gehärteten Film zu bilden, oder
Verfahren zur Herstellung eines Metalloxidfilms, der als Planarisierungsfilm in einem Halbleitervorrichtungsherstellungsprozess verwendet wird, wobei das Verfahren umfasst:
Aufbringen der Zusammensetzung zur Bildung eines Metalloxidfilms nach einem der Ansprüche 1 bis 10 auf ein zu bearbeitendes Substrat; und
Wärmebehandlung des Substrats in einer Atmosphäre mit einer Sauerstoffkonzentration von 1 Vol% oder mehr und 21 Vol% oder weniger, um einen gehärteten Film zu bilden, oder
Verfahren zur Herstellung eines Metalloxidfilms, der als Planarisierungsfilm in einem Halbleitervorrichtungsherstellungsprozess verwendet wird, wobei das Verfahren umfasst:
Aufbringen der Zusammensetzung zur Bildung eines Metalloxidfilms nach einem der Ansprüche 1 bis 10 auf ein zu bearbeitendes Substrat; und
Wärmebehandlung des Substrats in einer Atmosphäre mit einer Sauerstoffkonzentration von weniger als 1 Vol.-% zur Bildung eines gehärteten Films.

## Revendications

1. Composition pour former un film d'oxyde métallique, comprenant :
(A) une nanoparticule d'oxyde métallique ;
(B) un accélérateur de fluidité contenant une résine ayant un motif structural représenté par la formule générale (1) suivante ;
(C) un stabilisant de dispersion ayant deux cycles benzéniques ou plus ou ayant un cycle benzénique et une structure représentée par la formule générale (C-1) suivante, et le stabilisant de dispersion étant composé d'un composé contenant un groupe aromatique ayant un poids moléculaire représenté par une formule moléculaire de 500 ou moins ; et
(D) un solvant organique,
dans laquelle l'accélérateur de fluidité (B) a une teneur de 9 % en masse ou plus dans la totalité de la composition, un rapport Mw/Mn d'une masse moléculaire moyenne en masse Mw et d'une masse moléculaire moyenne en nombre Mn de l'accélérateur de fluidité (B) en termes de polystyrène par une méthode de chromatographie par perméation de gel est de 2,50 ≤ Mw/Mn ≤ 9,00, et l'accélérateur de fluidité (B) ne contient aucun composé ni polymère ayant une structure cardo, 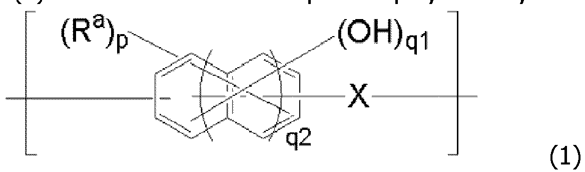
dans laquelle R^{a} représente un groupe organique monovalent saturé ayant de 1 à 30 atomes de carbone ou un groupe organique monovalent insaturé ayant de 2 à 30 atomes de carbone ; X représente un groupe organique divalent ayant de 1 à 30 atomes de carbone ; « p » représente un nombre entier de 0 à 5 ; « q₁ » représente un nombre entier de 1 à 6 ; « p+q₁ » représente un nombre entier de 1 ou plus et de 6 ou moins ; et « q₂ » représente 0 ou 1, 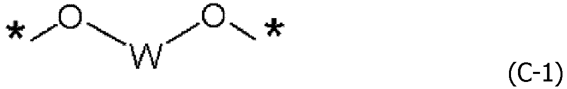
dans laquelle « * » représente une position de liaison ; et W représente un groupe organique ayant de 1 à 4 atomes de carbone.

2. Composition pour former un film d'oxyde métallique selon la revendication 1, dans laquelle l'accélérateur de fluidité (B) contient la résine ayant un motif structural représenté par la formule générale (2) suivante en plus de la résine ayant le motif structural représenté par le formule générale (1) ; ou l'accélérateur de fluidité (B) est une résine ayant à la fois le motif structural représenté par la formule générale (1) et le motif structural représenté par la formule générale (2) suivante, 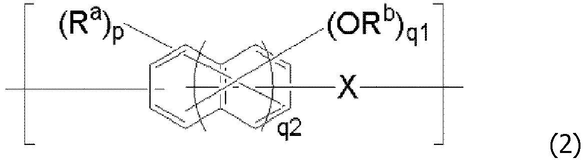 dans laquelle R^{a} représente un groupe organique monovalent saturé ayant de 1 à 30 atomes de carbone ou un groupe organique monovalent insaturé ayant de 2 à 30 atomes de carbone ; R^{b} représente un groupe hydrocarboné saturé ayant de 1 à 30 atomes de carbone ou un groupe hydrocarboné insaturé ayant de 2 à 10 atomes de carbone ; X représente un groupe organique divalent ayant de 1 à 30 atomes de carbone ; « p » représente un nombre entier de 0 à 5 ; « q₁ » représente un nombre entier de 1 à 6 ; « p+q₁ » représente un nombre entier de 1 ou plus et de 6 ou moins ; et « q₂ » représente 0 ou 1.

3. Composition pour former un film d'oxyde métallique selon la revendication 2, dans laquelle
dans la formule générale (2), R^{b} représente l'un quelconque d'un groupe alkyle ayant de 1 à 30 atomes de carbone ou d'une structure représentée par la formule générale (3) suivante, et un contenu de la formule générale (2) satisfait les relations de a + b = 1 et 0,2 ≤ b ≤ 0,8, où « a » représente une proportion de la formule générale (1) et « b » représente une proportion de la formule générale (2), 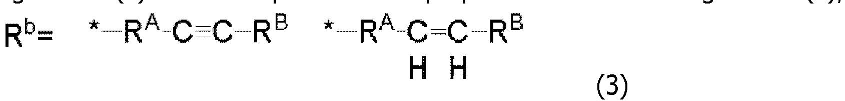
dans laquelle « * » représente une position de liaison à l'atome d'oxygène ; R^{A} représente un groupe organique divalent ayant de 1 à 10 atomes de carbone et ayant éventuellement un substituant ; et R^{B} représente un atome d'hydrogène ou un groupe organique monovalent ayant de 1 à 10 atomes de carbone et ayant éventuellement un substituant.

4. Composition pour former un film d'oxyde métallique selon l'une quelconque des revendications 1 à 3, dans laquelle le stabilisant de dispersion (C) a un taux de réduction de poids inférieur à 30 % lors d'un changement de température de 30 °C à 190 °C, et présente un taux de réduction de poids de 98 % ou plus lors d'un changement de température de 30 °C à 350 °C.

5. Composition pour former un film d'oxyde métallique selon l'une quelconque des revendications 1 à 4, dans laquelle le stabilisant de dispersion (C) contient un ou plusieurs composés choisis parmi les formules générales (I) à (III) suivantes, 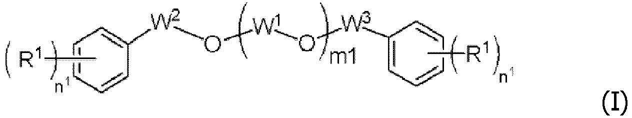
dans laquelle R¹ représente, chacun indépendamment, un atome d'hydrogène, un groupe hydroxy, ou un groupe organique ayant de 1 à 10 atomes de carbone et ayant éventuellement un substituant ; W¹ représente un groupe phénylène ou un groupe divalent représenté par la formule générale (I-1) suivante ; chacun de W² et W³ représente une liaison simple ou n'importe quel groupe divalent représenté par la formule générale (I-2) suivante ; « m¹ » représente un nombre entier de 1 à 10 ; et « n¹ » représente un nombre entier de 0 à 5, 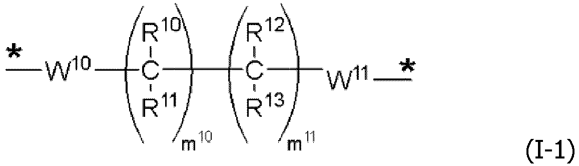
dans laquelle « * » représente une position de liaison ; chacun de R¹⁰, R¹¹, R¹² et R¹³ représente un atome d'hydrogène, un groupe hydroxy, ou un groupe organique ayant de 1 à 10 atomes de carbone ; W¹⁰ et W¹¹ représentent chacun indépendamment une liaison simple ou un groupe carbonyle ; chacun de « m¹⁰ » et « m¹¹ » représente un nombre entier de 0 à 10 ; et m¹⁰ + m¹¹ ≥ 1, 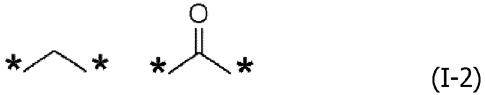
dans laquelle « * » représente une position de liaison, 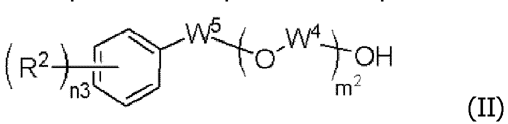
dans laquelle R² représente, chacun indépendamment, un atome d'hydrogène ou un groupe organique ayant de 1 à 10 atomes de carbone et ayant éventuellement un substituant ; W⁴ représente n'importe quel groupe divalent représenté par la formule générale (II-1) suivante ; W⁵ représente une liaison simple ou un groupe divalent représenté par la formule générale (II-2) suivante ; « m² » représente un nombre entier de 2 à 10 ; et « n³ » représente un nombre entier de 0 à 5, 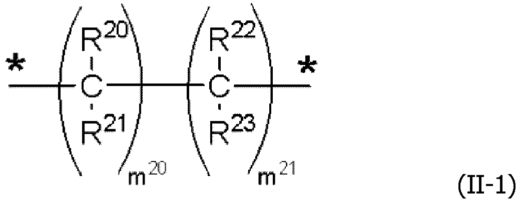
dans laquelle « * » représente une position de liaison ; chacun de R²⁰, R²¹, R²² et R²³ représente un atome d'hydrogène, un groupe hydroxy, ou un groupe organique ayant de 1 à 10 atomes de carbone ; chacun de « m²⁰ » et « m²¹ » représente un nombre entier de 0 à 10 ; et m²⁰ + m²¹ ≥ 1, 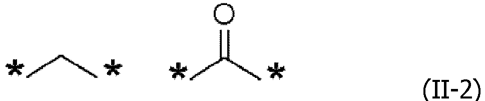
dans laquelle « * » représente une position de liaison, 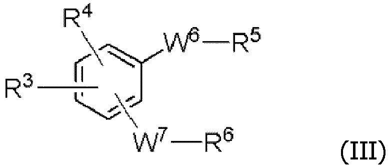
dans laquelle chacun de R³ et R⁴ représente un atome d'hydrogène, un groupe hydroxy, ou un groupe organique ayant de 1 à 10 atomes de carbone et ayant éventuellement un substituant, et R³ et R⁴ sont éventuellement liés l'un à l'autre pour former une structure cyclique ; chacun de R⁵ et R⁶ représente un groupe organique ayant de 1 à 10 atomes de carbone, et R⁵ représente un groupe ayant l'un quelconque d'un cycle aromatique ou d'un groupe divalent représenté par la formule générale (III-1) suivante ; et chacun de W⁶ et W⁷ représente une liaison simple ou n'importe quel groupe divalent représenté par la formule générale (III-2) suivante, et au moins l'un de W⁶ et W⁷ représente le groupe divalent représenté par la formule générale (III-2) suivante, 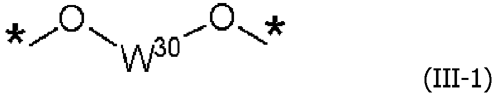
dans laquelle « * » représente une position de liaison ; et W³⁰ représente un groupe organique ayant de 1 à 4 atomes de carbone, 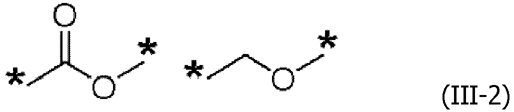
dans laquelle « * » représente une position de liaison.

6. Composition pour former un film d'oxyde métallique selon l'une quelconque des revendications 1 à 5, dans laquelle la nanoparticule d'oxyde métallique (A) est un ou plusieurs types d'une nanoparticule d'oxyde d'un métal choisi dans le groupe constitué par le zirconium, l'hafnium, l'aluminium, le tungstène, le titane, le cuivre, l'étain, le cérium, l'indium, le zinc, l'yttrium, le lanthane, le chrome, le cobalt, le platine, le fer, l'antimoine et le germanium.

7. Composition pour former un film d'oxyde métallique selon la revendication 6, dans laquelle la nanoparticule d'oxyde métallique (A) est une ou plusieurs nanoparticules d'oxyde métallique choisies dans le groupe constitué par une nanoparticule d'oxyde de zirconium, une nanoparticule d'oxyde d'hafnium, une nanoparticule d'oxyde de tungstène, une nanoparticule d'oxyde de titane et une nanoparticule d'oxyde d'étain.

8. Composition pour former un film d'oxyde métallique selon l'une quelconque des revendications 1 à 7, dans laquelle la nanoparticule d'oxyde métallique (A) a un diamètre moyen de particule primaire de 100 nm ou moins.

9. Composition pour former un film d'oxyde métallique selon l'une quelconque des revendications 1 à 8, dans laquelle un rapport pondéral entre la nanoparticule d'oxyde métallique (A) et l'accélérateur de fluidité (B) est de 80/20 à 10/90.

10. Composition pour former un film d'oxyde métallique selon l'une quelconque des revendications 1 à 9, comprenant en outre un ou plusieurs parmi un agent de réticulation, un tensioactif et un générateur d'acide.

11. Procédé de formation de motif pour former un motif sur un substrat à traiter, comprenant les étapes de :
(I-1) application de la composition pour former un film d'oxyde métallique selon l'une quelconque des revendications 1 à 10 sur un substrat à traiter, puis traitement thermique de la composition pour former un film d'oxyde métallique ;
(I-2) formation d'un film de couche supérieure de réserve sur le film d'oxyde métallique à l'aide d'un matériau de résine photosensible ;
(I-3) soumission du film de couche supérieure de réserve à une exposition à un motif, puis à un développement avec un révélateur pour former un motif dans le film de couche supérieure de réserve ;
(I-4) transfert du motif sur le film d'oxyde métallique par gravure à sec tout en utilisant le film de couche supérieure de réserve ayant le motif formé comme masque ; et
(I-5) traitement du substrat à traiter tout en utilisant le film d'oxyde métallique ayant le motif formé comme masque pour former le motif sur le substrat à traiter, ou
un procédé de formation de motif pour former un motif sur un substrat à traiter, comprenant les étapes de :
(II-1) application de la composition pour former un film d'oxyde métallique selon l'une quelconque des revendications 1 à 10 sur un substrat à traiter, puis traitement thermique de la composition pour former un film d'oxyde métallique ;
(II-2) formation d'un film de couche intermédiaire de réserve contenant du silicium sur le film d'oxyde métallique à l'aide d'un matériau de film de couche intermédiaire de réserve contenant du silicium ;
(II-3) formation d'un film de couche supérieure de réserve sur le film de couche intermédiaire de réserve contenant du silicium à l'aide d'un matériau de résine photosensible ;
(II-4) soumission du film de couche supérieure de réserve à une exposition à un motif, puis à un développement avec un révélateur pour former un motif dans le film de couche supérieure de réserve ;
(II-5) transfert du motif sur le film de couche intermédiaire de réserve contenant du silicium par gravure à sec tout en utilisant le film de couche supérieure de réserve ayant le motif formé comme masque ;
(II-6) transfert du motif sur le film d'oxyde métallique par gravure à sec tout en utilisant le film de couche intermédiaire de réserve contenant du silicium ayant le motif transféré comme masque ; et
(II-7) traitement du substrat à traiter tout en utilisant le film d'oxyde métallique ayant le motif formé comme masque pour former le motif sur le substrat à traiter, ou
un procédé de formation de motif pour former un motif sur un substrat à traiter, comprenant les étapes de :
(III-1) application de la composition pour former un film d'oxyde métallique selon l'une quelconque des revendications 1 à 10 sur un substrat à traiter, puis traitement thermique de la composition pour former un film d'oxyde métallique ;
(III-2) formation d'un film de couche intermédiaire de masque dur inorganique choisi parmi un film d'oxyde de silicium, un film de nitrure de silicium et un film d'oxynitrure de silicium sur le film d'oxyde métallique ;
(III-3) formation d'un film mince organique sur le film de couche intermédiaire de masque dur inorganique ;
(III-4) formation d'un film de couche supérieure de réserve sur le film mince organique à l'aide d'un matériau de résine photosensible ;
(III-5) soumission du film de couche supérieure de réserve à une exposition à un motif, puis à un développement avec un révélateur pour former un motif dans le film de couche supérieure de réserve ;
(III-6) transfert du motif sur le film mince organique et le film de couche intermédiaire de masque dur inorganique par gravure à sec tout en utilisant le film de couche supérieure de réserve ayant le motif formé comme masque ;
(III-7) transfert du motif sur le film d'oxyde métallique par gravure à sec tout en utilisant le film de couche intermédiaire de masque dur inorganique ayant le motif transféré comme masque ; et
(III-8) traitement du substrat à traiter tout en utilisant le film d'oxyde métallique ayant le motif formé comme masque pour former le motif sur le substrat à traiter, ou
un procédé de formation de motif pour former un motif sur un substrat à traiter, comprenant les étapes de :
(IV-1) formation d'un film de sous-couche de réserve sur un substrat à traiter ;
(IV-2) formation d'un film de couche intermédiaire de réserve ; ou d'une combinaison d'un film de couche intermédiaire de masque dur inorganique et d'un film mince organique sur le film de sous-couche de réserve, le film de couche intermédiaire de masque dur inorganique étant choisi parmi un film d'oxyde de silicium, un film de nitrure de silicium et un film d'oxynitrure de silicium ;
(IV-3) formation d'un film de couche supérieure de réserve sur le film de couche intermédiaire de réserve ou sur la combinaison du film de couche intermédiaire de masque dur inorganique et du film mince organique à l'aide d'un matériau de résine photosensible ;
(IV-4) soumission du film de couche supérieure de réserve à une exposition à un motif, puis à un développement avec un révélateur pour former un motif dans le film de couche supérieure de réserve ;
(IV-5) transfert du motif sur le film de couche intermédiaire de réserve ou sur le film mince organique et le film de couche intermédiaire de masque dur inorganique par gravure à sec tout en utilisant le film de couche supérieure de réserve ayant le motif formé comme masque ;
(IV-6) transfert du motif sur le film de sous-couche de réserve par gravure à sec tout en utilisant le film de couche intermédiaire de réserve ou le film de couche intermédiaire de masque dur inorganique ayant le motif transféré comme masque ;
(IV-7) application de la composition pour former un film d'oxyde métallique selon l'une quelconque des revendications 1 à 10 sur le film de sous-couche de réserve ayant le motif formé, traitement thermique de la composition pour couvrir le film d'oxyde métallique et combler un espace du motif de film de sous-couche de réserve avec le film d'oxyde métallique ;
(IV-8) gravure en retrait du film d'oxyde métallique couvrant le film de sous-couche de réserve ayant le motif formé par un décapant chimique ou une gravure à sec, le film d'oxyde métallique de manière à avoir une surface supérieure découverte du film de sous-couche de réserve ayant le motif formé ;
(IV-9) retrait du film de couche intermédiaire de réserve ou du film de couche intermédiaire de masque dur inorganique resté sur la surface supérieure du film de sous-couche de réserve par gravure à sec ;
(IV-10) retrait du film de sous-couche de réserve ayant la surface découverte et le motif formé par gravure à sec pour former un motif inversé par rapport au motif original sur le film d'oxyde métallique ; et
(IV-11) traitement du substrat à traiter tout en utilisant le film d'oxyde métallique ayant le motif inversé formé comme masque pour former un motif à tons inversés sur le substrat à traiter, ou
un procédé de formation de motif utilisant une composition pour former un film d'oxyde métallique en tant que film sacrificiel, comprenant les étapes de :
(V-1) application de la composition pour former un film d'oxyde métallique selon l'une quelconque des revendications 1 à 10 sur un substrat à traiter ayant une structure ou un gradin, puis traitement thermique de la composition pour combler un film d'oxyde métallique ;
(V-2) retrait du film d'oxyde métallique à l'extérieur de la structure ou du gradin sur le substrat à traiter par un procédé CMP pour éliminer l'oxyde métallique d'une surface du substrat à traiter ;
(V-3) empilements en alternance d'un film isolant et d'un film conducteur sur le substrat à traiter comblé avec le film d'oxyde métallique ;
(V-4) formation d'un film de sous-couche de réserve organique sur un film empilé du film isolant et du film conducteur formés sur le substrat à traiter comblé avec le film d'oxyde métallique ;
(V-5) formation d'un film de couche intermédiaire de réserve, ou d'un film de couche intermédiaire de masque dur inorganique, ou d'une combinaison du film de couche intermédiaire de masque dur inorganique et d'un film mince organique sur le film de sous-couche de réserve organique, le film de couche intermédiaire de masque dur inorganique étant choisi parmi un film d'oxyde de silicium, un film de nitrure de silicium et un film d'oxynitrure de silicium ;
(V-6) formation d'un film de couche supérieure de réserve sur le film de couche intermédiaire de réserve, ou sur le film de couche intermédiaire de masque dur inorganique, ou sur la combinaison du film de couche intermédiaire de masque dur inorganique et du film mince organique à l'aide d'un matériau de résine photosensible ;
(V-7) soumission du film de couche supérieure de réserve à une exposition à un motif, puis développement avec un révélateur pour former un motif dans le film de couche supérieure de réserve ;
(V-8) transfert du motif sur le film de couche intermédiaire de réserve, ou sur le film de couche intermédiaire de masque dur inorganique, ou sur le film mince organique et le film de couche intermédiaire de masque dur inorganique par gravure à sec tout en utilisant le film de couche supérieure de réserve ayant le motif formé comme masque ;
(V-9) transfert du motif sur le film de sous-couche de réserve par gravure à sec tout en utilisant le film de couche intermédiaire de réserve ou le film de couche intermédiaire de masque dur inorganique ayant le motif transféré comme masque ;
(V-10) transfert du motif sur le film empilé du film isolant et du film conducteur par gravure à sec tout en utilisant le film de sous-couche de réserve ayant le motif transféré comme masque ; et
(V-11) retrait du film d'oxyde métallique comblé sur le substrat à traiter tout en utilisant le film empilé du film isolant et du film conducteur ayant le motif transféré comme masque.

12. Procédé de formation de motif selon la revendication 11, dans lequel un substrat ayant une structure ou un gradin ayant un rapport de forme de 5 ou plus est utilisé comme substrat à traiter.

13. Méthode de formation d'un film d'oxyde métallique fonctionnant comme un film de planarisation utilisé dans un procédé de fabrication d'un appareil à semiconducteur, la méthode comprenant :
l'application de la composition pour former un film d'oxyde métallique selon l'une quelconque des revendications 1 à 10 sur un substrat à traiter ; et
le traitement thermique du substrat dans une plage d'une température de 100 °C ou plus et de 600 °C ou moins pendant 10 à 600 secondes pour former un film durci, ou
une méthode pour former un film d'oxyde métallique fonctionnant comme un film de planarisation utilisé dans un procédé de fabrication d'appareil à semiconducteur, la méthode comprenant :
l'application de la composition pour former un film d'oxyde métallique selon l'une quelconque des revendications 1 à 10 sur un substrat à traiter ; et
le traitement thermique du substrat dans une atmosphère avec une concentration en oxygène de 1 % en volume ou plus et de 21 % en volume ou moins pour former un film durci, ou
une méthode pour former un film d'oxyde métallique fonctionnant comme un film de planarisation utilisé dans un procédé de fabrication d'appareil à semiconducteur, la méthode comprenant :
l'application de la composition pour former un film d'oxyde métallique selon l'une quelconque des revendications 1 à 10 sur un substrat à traiter ; et
le traitement thermique du substrat dans une atmosphère avec une concentration en oxygène inférieure à 1 % en volume pour former un film durci.
